(19) Europäisches Patentamt
European Patent Office
Office européen des brevets

(11) **EP 4 668 071 A1**

(12) **EUROPEAN PATENT APPLICATION**

(43) Date of publication:
24.12.2025 Bulletin 2025/52

(21) Application number: 25184212.6

(22) Date of filing: 20.06.2025

(51) International Patent Classification (IPC):
*G06F 3/0354* (2013.01)

(52) Cooperative Patent Classification (CPC):
G06F 3/03545

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 21.06.2024 KR 20240080912
31.10.2024 KR 20240151961

(71) Applicant: Hideep Inc.
Seongnam-si, Gyeonggi-do 13493 (KR)

(72) Inventors:
• KIM, Kiung
13493 Gyeonggi-do (KR)
• BYUN, Mun Sub
13493 Gyeonggi-do (KR)
• PAEK, Chongkuk
13493 Gyeonggi-do (KR)
• JUNG, Kiruoung
13493 Gyeonggi-do (KR)

(74) Representative: HGF
HGF Europe LLP
Neumarkter Straße 18
81673 München (DE)

(54) **STYLUS PEN INCLUDING SEALING MEMBER**

(57) According to the present disclosure, a stylus pen includes: a housing; a core having one end disposed outside the housing and the rest portion disposed in the housing and moved along a longitudinal direction by external force applied to the one end; an inductor unit including a ferrite core disposed in the housing and having a through-hole through which the core passes and a coil wound around an outer surface of the ferrite core; a capacitor unit electrically connected to the inductor unit to form a resonance circuit; and a plurality of sealing members configured to block a plurality of moisture ingress paths that pass through a core opening of the housing.

【 FIG. 54A】

## Description

CROSS-REFERENCE TO RELATED APPLICATIONS

This US non-provisional patent application claims priority under 35 USC §119 of Korean Patent Application No. 10-2024-0080912, filed on June 21, 2024 and No. 10-2024-0151961, filed on October 31, 2024, the entire contents of which are hereby incorporated by reference.

BACKGROUND

The present disclosure relates to a stylus pen, and more particularly, to a sealing member capable of blocking one or a plurality of moisture ingress paths in the stylus pen and a stylus pen including the same.

A stylus pen is a pen-shaped device capable of inputting data by lightly touching a screen while dragging or clicking on the screen. A user uses the stylus pen for a precise touch input.

The stylus pen may be classified into an active stylus pen and a passive stylus pen depending on whether the stylus pen includes a battery and an electronic component therein.

Although the active stylus pen has an advantage of having an excellent basic performance and providing additional functions (pen pressure, hovering, and buttons) in comparison with the passive stylus pen, the active stylus pen has a disadvantage in that most of users substantially do not use the active stylus pen except for some advanced users because the active stylus pen is expensive and uses a rechargeable battery as power.

Although the passive stylus pen has an advantage in that the passive stylus pen is inexpensive and does not require a battery in comparison with the active stylus pen, the passive stylus pen has a disadvantage in that the passive stylus pen is difficult to recognize a precise touch in comparison with the active stylus pen. In recent years, however, technologies of an electro magnetic resonance (EMR) method that is an inductive resonance method and a capacitive resonance method are proposed to realize a passive stylus pen capable of recognizing a precise touch.

Although the EMR method is excellent in writing and drawing quality that is a key function of the stylus pen, the EMR method has a disadvantage of having a great thickness and requiring more costs because a separate EMR sensor panel and a separate EMR driving IC are necessarily added in addition to a capacitance touch panel.

The capacitive resonance method uses a general capacitance touch sensor and a general touch controller IC to increase a performance of the IC and support a pen touch without additional costs.

In the EMR method or the capacitive resonance method, a resonance signal is required to have a great amplitude to more accurately distinguish a touch caused by the stylus pen. Thus, a driving signal transmitted to the stylus pen needs to have the almost same resonance frequency as that of the resonance circuit contained in the stylus pen. However, according to the conventional EMR method or capacitive resonance method, although the resonance frequency is the same as the frequency of the driving signal, signal transmission is difficult because of extremely great attenuation of the signal transmission. As a result, despite a lot of attempts of many touch controller IC vendors for a long time, no companies have succeeded in mass production because a sufficient output signal is not produced.

Thus, a feature of how to design structures of an internal resonance circuit and a pen is a key factor to manufacture an EMR or capacitive resonance stylus pen capable of producing a maximum output signal.

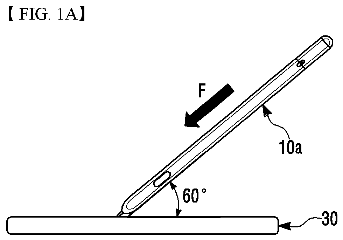

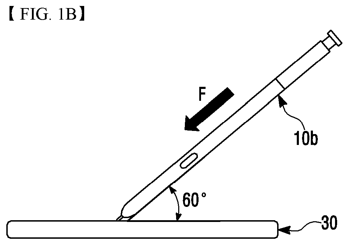

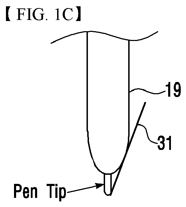

FIG. 1A to 1C are views for explaining one requirement of a conventional stylus pen.

An outer design of the conventional stylus pen, such as the stylus pens 10a and 10b in FIG. 1A to 1C, needs to satisfy a predetermined requirement in consideration of an environment of the user.

The one requirement is that the conventional stylus pens 10a and 10b may perform a drawing in a state of being inclined at a predetermined angle (e.g., 60°) with a predetermined contact surface 31.

In particular, the stylus pens 10a and 10b are required to perform a drawing even in a state of being inclined at a predetermined angle (e.g., 60°) as a pen tip is pressed such that, when the stylus pen contacts a surface of a display panel 300 and then a predetermined force F is applied, the pen tip is pressed, and a portion thereof is retracted into a housing 19.

As a result, when the conventional stylus pen 10a or 10b is inclined to the contact surface 31, an inclination of the predetermined angle (e.g., 60°) needs not to be disturbed by an outer component (e.g., housing 19) of the stylus pen 10a or 10b.

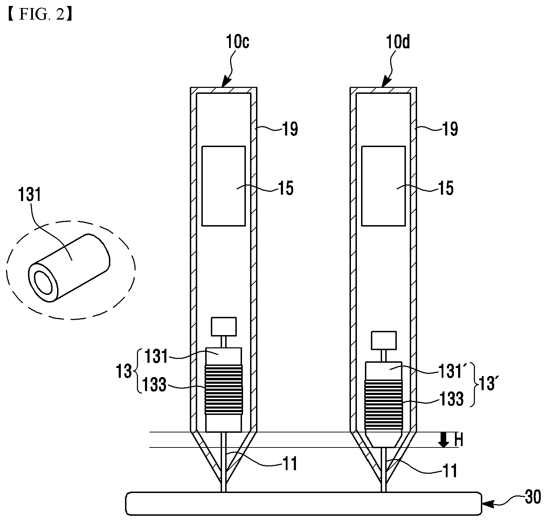

FIG. 2 is a schematic view illustrating an inner structure of the conventional stylus pen.

Each of conventional stylus pens 10c and 10d illustrated in FIG. 2 includes a pen tip 11, an inductor unit 13 or 13', a capacitor unit 15, and a housing 19. The conventional stylus pen further includes other additional components in addition to the above-described components.

The inductor unit 13 or 13' includes a ferrite core 131 or 131' and a coil 133. The pen tip 11 has a portion that is inserted into a through-hole of the ferrite core 131 or 131'.

The inductor unit 13 or 13' and the capacitor unit 15 are electrically connected to form an LC resonance unit. The LC resonance unit may be resonated by a driving signal provided by a transmitter disposed outside the stylus pen 10c and 10d and emit a predetermined signal (hereinafter, referred to as a pen signal).

The ferrite core 131' of the inductor unit 13' of the stylus pen 10d illustrated at a right side of FIG. 2 has a shape different from that of the ferrite core 131 of the inductor unit 13 of the stylus pen 10c illustrated at a left side. Specifically, the ferrite core 131' of the stylus pen 10d illustrated at the right side has a lower end that has a shape (hereinafter, referred to as a taper shape) having a width that gradually decreases in a downward direction. Through the taper shape, the ferrite core 131' may be disposed closer to a lower end (or pen tip) in the housing 19 by a predetermined distance H.

In the conventional stylus pens 10c and 10d in FIG. 2, a magnitude of the pen signal received by a receiver disposed outside the stylus pen 10c and 10d may be varied based on a position of the inductor unit 13 and 13' in the housing 19. The position of the inductor unit 13 and 13' may be determined to maximize the magnitude of the pen signal.

Since the ferrite core 131' of the stylus pen 10d illustrated at the right side is disposed closer to the pen tip than the ferrite core 131 of the stylus pen 10c illustrated at the left side, the magnitude of the pen signal received by the receiver is relatively great. However, there is a limitation in maximizing the magnitude of the pen signal received by the receiver by using only the taper shape of the ferrite core 131' of the stylus pen 10d illustrated at the right side.

Furthermore, while maximizing the magnitude of the pen signal received by the receiver, it is also required to stably accommodate the inductor unit 13 and 13' in the housing 19.

On the other hand, since the stylus pen is used in various environments due to characteristics thereof, the stylus pen has a high possibility of being damaged by external factors. In particular, moisture ingress may significantly affect a function of the stylus pen. Since the stylus pen includes precise electronic components therein, ingress of moisture such as water or humidity may cause corrosion of the components or an electrical short-circuit between the components, thereby degrading a performance of the stylus pen. The above-described limitation may shorten a lifespan of the stylus pen and cause inconvenience of the user.

Although some stylus pens currently available on the market have a waterproof function, the stylus pens have a limitation of using an incomplete or expensive special material to increase manufacturing costs. Thus, there is a need to develop a technology capable of effectively and economically preventing moisture ingress into the stylus pens.

SUMMARY

The present disclosure provides a sealing member capable of blocking a plurality of moisture ingress paths of a stylus pen and a stylus pen including the same.

The present disclosure also provides a sealing member capable of exhibiting an additional effect of blocking a moisture ingress path through a contact part and a stylus pen including the same.

The present disclosure also provides a buffer member capable of performing both a buffer function and a waterproof function, a stylus pen including the same, and a method for minimizing a size of the buffer member.

An embodiment of the present disclosure provides a stylus pen including: a housing; a core having one end disposed outside the housing and the rest portion disposed in the housing and moved along a longitudinal direction by external force applied to the one end; an inductor unit including a ferrite core disposed in the housing and having a through-hole through which the core passes and a coil wound around an outer surface of the ferrite core; a capacitor unit electrically connected to the inductor unit to form a resonance circuit; and a plurality of sealing members configured to block a plurality of moisture ingress paths that pass through a core opening of the housing.

In an embodiment, the plurality of moisture ingress paths may include: a first moisture ingress path in which moisture enters into the stylus pen through the core opening of the housing and a space between the housing and the inductor unit; and a second moisture ingress path in which moisture enters into the stylus pen through the core opening of the housing and a through-hole of the ferrite core.

In an embodiment, the plurality of sealing members include: a first sealing member configured to block the first moisture ingress path; and a second sealing member configured to block the second moisture ingress path.

In an embodiment, the first sealing member may surround at least a portion of the outer surface of the ferrite core and be in close contact with an inner wall of the housing.

In an embodiment, the stylus pen may further include a fixing bracket fixed in the housing and coupled to the one end of the ferrite core, in which the first sealing member may surround at least a portion of an outer surface of the fixing bracket and be in close contact with an inner wall of the housing.

In an embodiment, the stylus pen may further include a fixing bracket fixed in the housing and coupled to the one end of the ferrite core, in which the fixing bracket may include a partition wall that is in contact with the ferrite core, and the second sealing member is disposed on the partition wall to fill an outer portion of a through-hole of the partition wall, which passes through the partition wall, and be in close contact with the core at a portion at which the core passes the through-hole of the partition wall.

In an embodiment of the present disclosure, a stylus pen includes: a housing; a core having one end disposed outside the housing and the rest portion disposed in the housing and moved along a longitudinal direction by external force applied to the one end; an inductor unit including a ferrite core disposed in the housing and having a through-hole through which the core passes and a coil wound around an outer surface of the ferrite core; a capacitor unit electrically connected to the inductor unit to form a resonance circuit; and a sealing member configured to block a path in which moisture enters into the stylus pen through a core opening of the housing and a through-hole of the ferrite core.

In an embodiment, the stylus pen may further include a fixing bracket fixed in the housing and coupled to the one end of the ferrite core, in which the fixing bracket may include a partition wall that is in contact with the ferrite core, and the second sealing member may be disposed on the partition wall to fill an outer portion of a through-hole of the partition wall, which passes through the partition wall, and be in close contact with the core at a portion at which the core passes the through-hole of the partition wall.

In an embodiment, the sealing member may include a cylindrical contact part having a height in the longitudinal direction of the core and be in close contact with the core at the contact part.

In an embodiment, the contact part may maintain a close contact state with at least a portion of the core when the core is moved in the longitudinal direction.

In an embodiment of the present disclosure, a stylus pen includes: a housing; a core having one end disposed outside the housing and the rest portion disposed in the housing and moved along a longitudinal direction by external force applied to the one end; an inductor unit including a ferrite core disposed in the housing and having a through-hole through which the core passes and a coil wound around an outer surface of the ferrite core; a capacitor unit electrically connected to the inductor unit to form a resonance circuit; a buffer member disposed between an inner surface of the housing and the other end of the ferrite core to surround at least a portion of the other end of the ferrite core; and a sealing member configured to block a path in which moisture enters into the stylus pen through a core opening of the housing and a space between the housing and the inductor unit.

In an embodiment, the buffer member may be in close contact with the housing and the other end of the ferrite core.

In an embodiment, the other end of the ferrite core may include at least one curved portion having a tapered shape having a diameter or a width that gradually decreases in a direction toward an end thereof and having an outer surface that is curved inward.

In an embodiment, the buffer member may have a smaller thickness in comparison with a case in which the other end of the ferrite core does not include the curved portion.

In an embodiment, the sealing member may surround the outer surface of the ferrite core and be in close contact with an inner wall of the housing.

In an embodiment, the stylus pen may further include a fixing bracket fixed in the housing and coupled to the one end of the ferrite core, in which the sealing member may surround the fixing bracket and be in close contact with an inner wall of the housing.

In an embodiment of the present disclosure, a stylus pen includes: a housing; a core having one end disposed outside the housing and the rest portion disposed in the housing and moved along a longitudinal direction by external force applied to the one end; an inductor unit including a ferrite core disposed in the housing and having a through-hole through which the core passes and a coil wound around an outer surface of the ferrite core; a capacitor unit electrically connected to the inductor unit to form a resonance circuit; and a buffer member disposed between the housing and the other end of the ferrite core to surround at least a portion of the other end of the ferrite core and including a fourth sealing member at one end thereof, in which the sealing member has an outer portion that is in close contact with an inner wall of the housing.

In an embodiment, the fourth sealing member may be taped or coated on one surface of the buffer member.

In an embodiment, the fourth sealing member may have an inner portion that is in close contact with the core or the ferrite core.

In an embodiment, the fourth sealing member may have an inner portion that is spaced a predetermined distance from the core or the ferrite core.

In an embodiment, the stylus pen may further include a third sealing member that surrounds at least a portion of the outer surface of the ferrite core and is in close contact with the housing.

In an embodiment, the third sealing member may be in contact with the coil.

In an embodiment, the stylus pen may further include: a fixing bracket fixed in the housing and coupled to the one end of the ferrite core; and a first sealing member that surrounds at least a portion of an outer surface of the fixing bracket and is in close contact with the housing.

In an embodiment, the stylus pen may further include: a button part disposed on an outer surface of the housing; a button bracket fixed in the housing and coupled to the button part; and a packing member that is coupled to the button bracket and is in close contact with the button bracket.

In an embodiment, the stylus pen may further include: a substrate bracket fixed in the housing to surround the capacitor unit; a clicker button moved in the longitudinal direction by external force applied to one end thereof; a clicker housing having one end coupled to the housing to surround the clicker button in the housing; a clicker cover that connects the substrate bracket and the clicker housing in the housing; and a fifth sealing member that surrounds a predetermined groove defined in the clicker cover around a portion at which the clicker cover is coupled to the substrate bracket, in which the fifth sealing member is in close contact with the housing.

BRIEF DESCRIPTION OF THE FIGURES

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:

FIG. 1A to 1C are views for explaining one requirement of a conventional stylus pen;

FIG. 2 is a schematic view illustrating an inner structure of the conventional stylus pen;

FIG. 3 is a perspective view illustrating a stylus pen 100 according to an embodiment of the present disclosure;

FIG. 4 is a cross-sectional view illustrating the stylus pen 100 in FIG. 3;

FIG. 5 is a detailed cross-sectional view illustrating an inductor unit 120 in FIG. 4;

FIG. 6 is a view for explaining an inner configuration of the stylus pen in FIGS. 4 and 5 and an effect caused by the inner configuration according to an embodiment of the present disclosure;

FIG. 7 is a view for explaining in more detail the inner configuration of the stylus pen in FIGS. 4 and 5 and the effect caused by the inner configuration according to an embodiment of the present disclosure;

FIG. 8 is a view for explaining an amount of increase in magnitude of a pen signal according to a predetermined height S in FIG. 7;

FIG. 9 is a cross-sectional view illustrating a portion of the stylus pen 100 in FIG. 3;

FIG. 10A is a perspective view for explaining structures of an inner case 110 and a buffer member 115 illustrated in FIG. 9, and FIG. 10B is a perspective view illustrating only the inner case 110;

FIG. 11 is a perspective view illustrating a state in which the inner case 110 in FIG. 10A is removed;

FIGS. 12A and 12B are perspective views illustrating a first fixing member 130 in FIGS. 9 and 11 from various angles;

FIGS. 13A and 13B are perspective views illustrating a moving member 170 in FIGS. 9 and 11 from various angles;

FIGS. 14A and 14B are perspective views illustrating a second fixing member 190 in FIGS. 9 and 11 from various angles;

FIG. 15 is a perspective view illustrating some components in FIGS. 9 and 11 from one side;

FIGS. 16A and 16B are perspective views illustrating only some components in FIGS. 9 and 11;

FIG. 17 are views for explaining a motion of the stylus pen 100 in FIGS. 9 to 16;

FIG. 18A is a view illustrating a variation in LC value of a resonance circuit unit according to motions in FIG. 17;

FIG. 18B is a graph showing frequency characteristics in each of the motions of FIG. 17;

FIGS. 19A to 19C are views for explaining a limitation caused by an assembly deviation of a core 102 occurring when the stylus pen 100 in FIGS. 9 to 17 is assembled;

FIG. 20 is a graph showing a variation in resonance frequency according to pressure applied to the core 102 in each of FIGS. 19A to 19C;

FIGS. 21A to 21C are views for explaining a limitation caused by an assembly deviation of connection terminals 165a and 165b occurring when the stylus pen 100 in FIGS. 9 to 17 is assembled;

FIG. 22 is a cross-sectional view illustrating a portion of a stylus pen according to a modified embodiment of the stylus pen 100 in FIG. 3;

FIGS. 23A and 23B are views for explaining a first elastic member 180' in FIG. 22;

FIG. 24 is a view for explaining a motion of the stylus pen in FIGS. 22 and 23;

FIGS. 25A and 25B are views illustrating an example of an assembly deviation occurring in a core 102;

FIG. 26 is a graph showing a variation in resonance frequency according to pressure applied to the core 102 in each of FIGS. 25A and 25B;

FIG. 27 is a perspective view of a modified example of a ferrite core 121 in FIGS. 4 to 5;

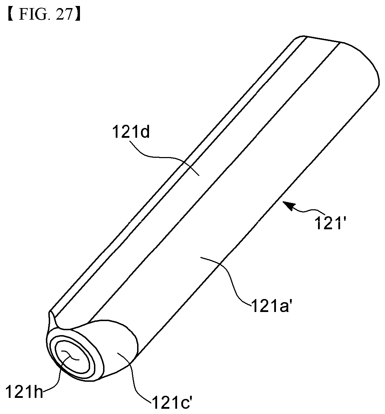

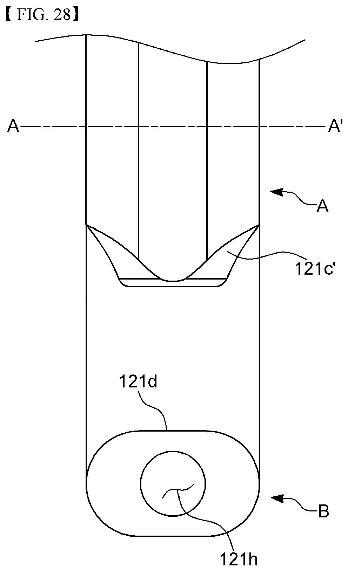

A in FIG. 28 is an enlarged front view illustrating a portion of a ferrite core 121' in FIG. 27, and B in FIG. 28 is a cross-sectional view taken along line A-A' of A in FIG. 28;

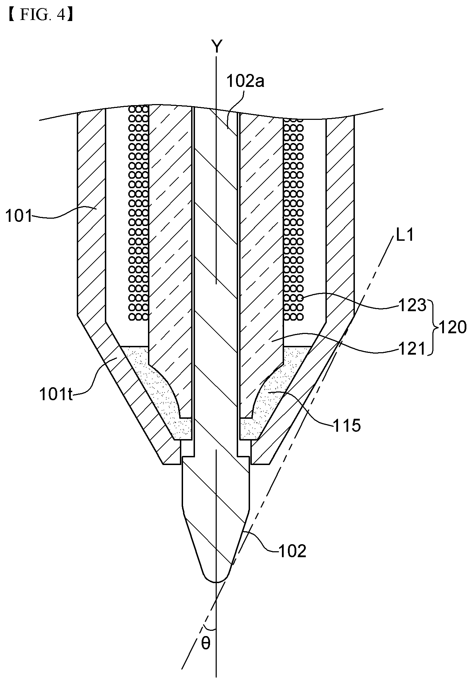

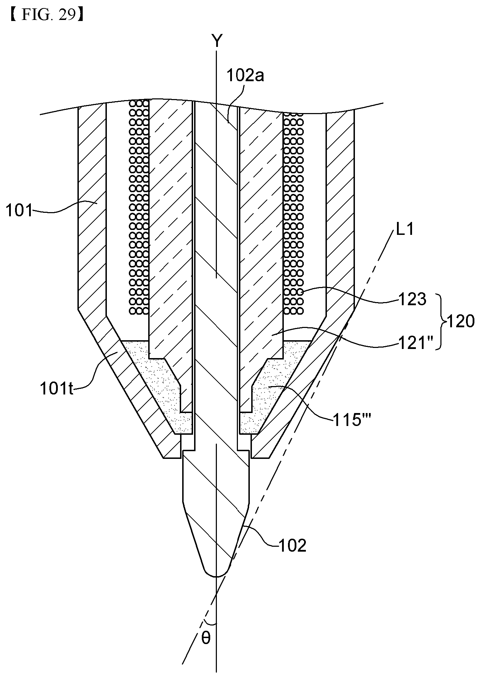

FIG. 29 is a cross-sectional view illustrating a stylus pen to which another modified example of the ferrite core 121 in FIG. 4 is applied;

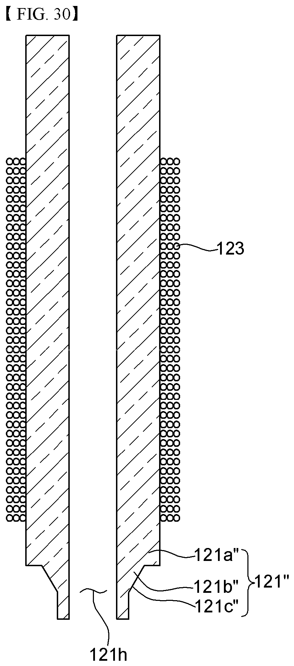

FIG. 30 is a cross-sectional view illustrating only a ferrite core 121" and a coil 123 in FIG. 29;

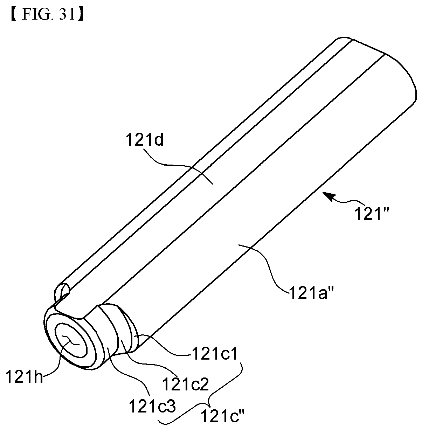

FIG. 31 is a perspective view illustrating the ferrite core 121" in FIGS. 29 to 30;

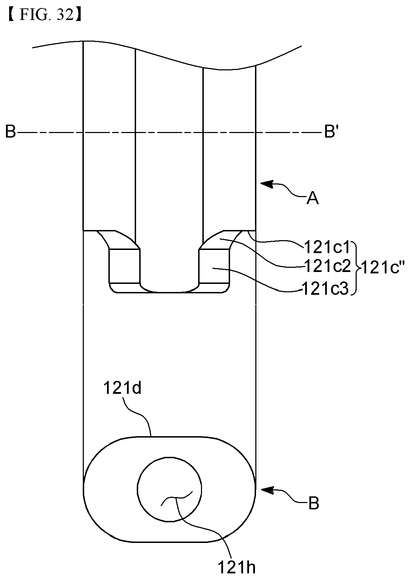

A in FIG. 32 is an enlarged front view illustrating a portion of the ferrite core 121" in FIG. 31, and B in FIG. 32 is a cross-sectional view taken along line B-B' of A in FIG. 32;

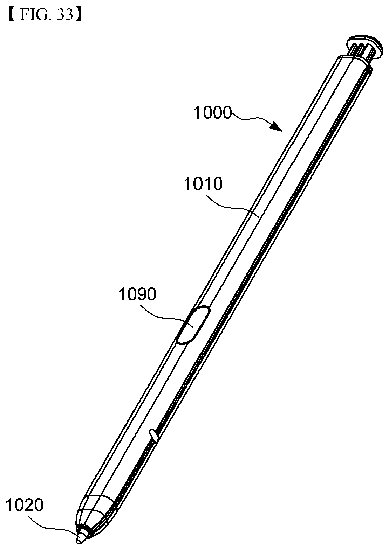

FIG. 33 is a perspective view illustrating a stylus pen 1000 according to another embodiment of the present disclosure;

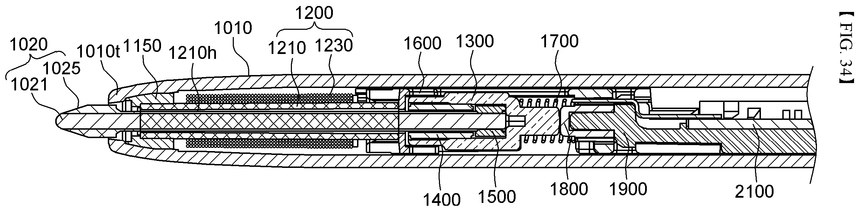

FIG. 34 is a cross-sectional view illustrating a portion of the stylus pen 1000 in FIG. 33;

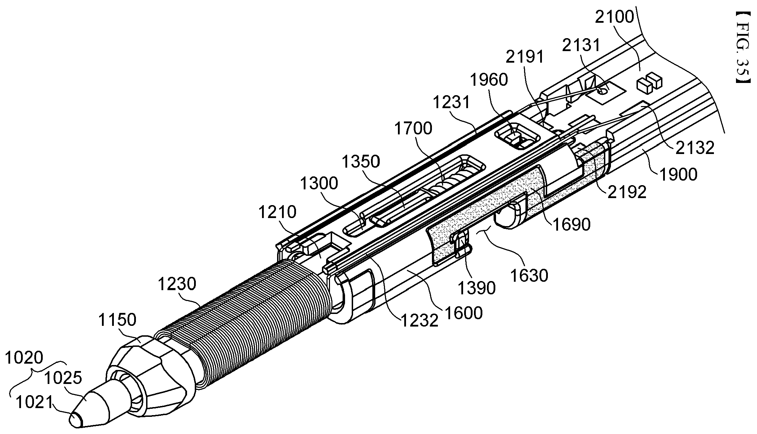

FIG. 35 is a perspective view illustrating a state in which a housing 1010 of the stylus pen 1000 in FIG. 33 is removed;

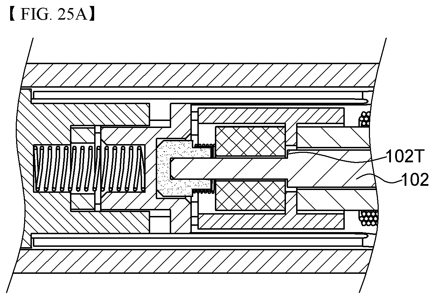

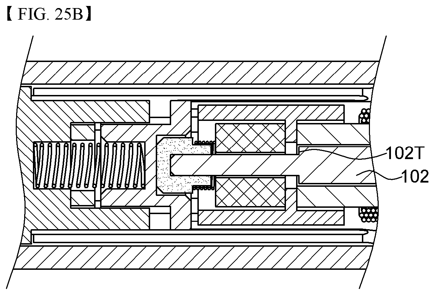

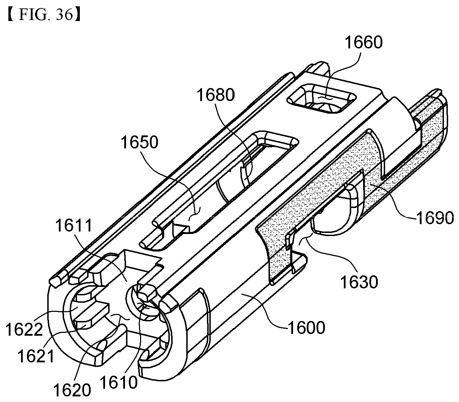

FIG. 36 is a perspective view illustrating only a fixing bracket 1600 in FIG. 25;

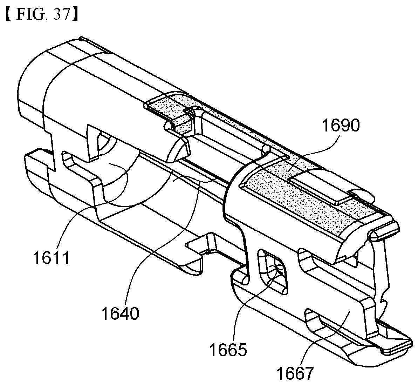

FIG. 37 is a perspective view illustrating the fixing bracket 1600 in FIG. 36 viewed from a different direction;

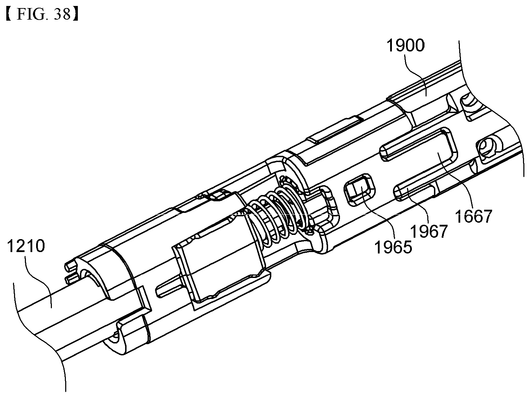

FIG. 38 is a perspective view illustrating a portion of FIG. 35 viewed from a different direction;

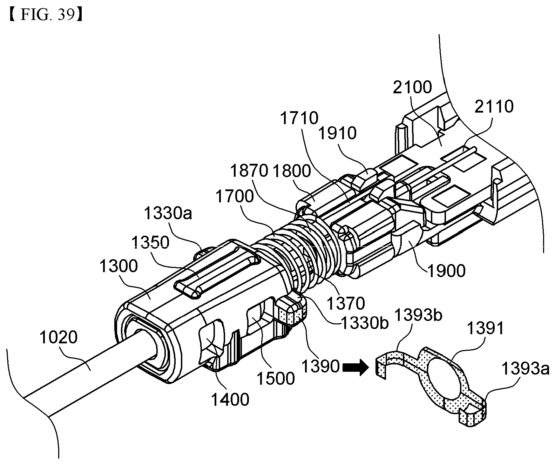

FIG. 39 is a perspective view illustrating a state in which an inductor unit 1200 and a fixing bracket 1600 in FIG. 35 are removed;

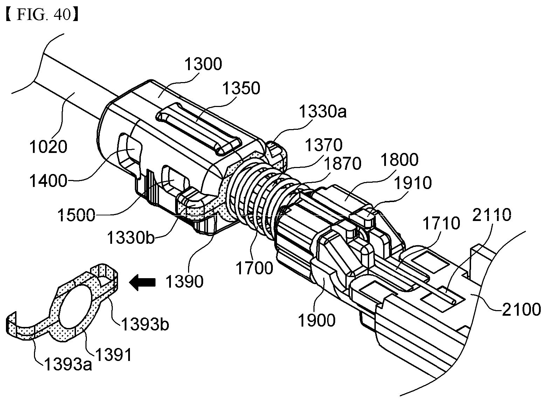

FIG. 40 is a perspective view illustrating FIG. 39 viewed from a different direction;

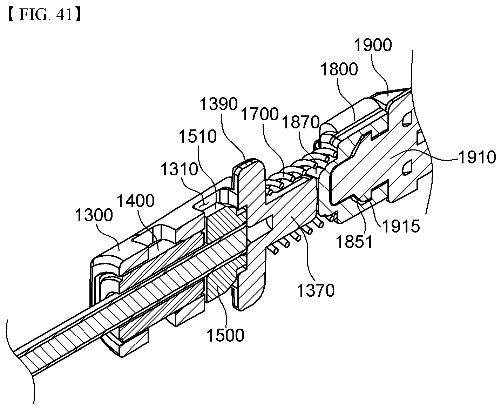

FIG. 41 is a cross-sectional view of FIG. 39;

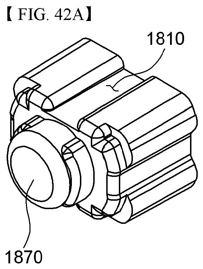

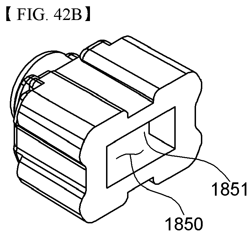

FIG. 42 is perspective views illustrating only elastic member 1800 in FIG. 39;

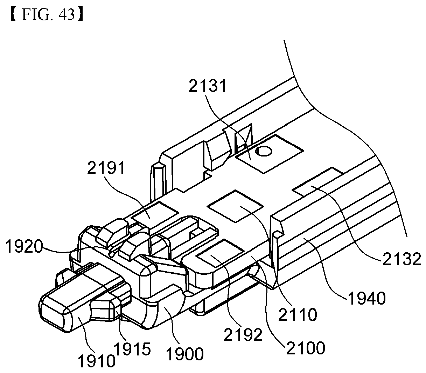

FIG. 43 is a perspective view illustrating a substrate bracket 1900 and a substrate 2100 in FIG. 39;

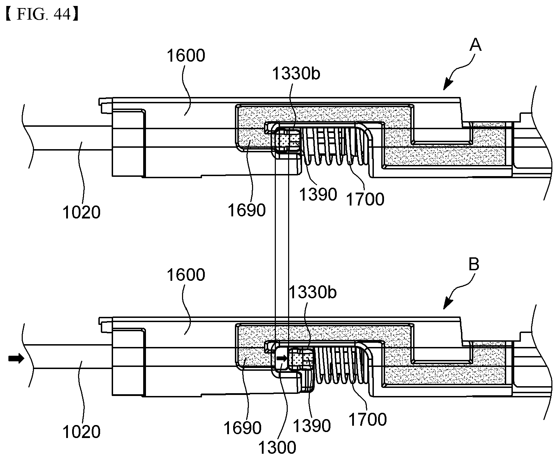

FIG. 44 is a view for explaining a movement of a moving bracket 1300 according to a movement of the core 1020 in FIGS. 35 to 43, and an electrical contact and disconnection between the fixing bracket 1600 and the moving bracket 1300;

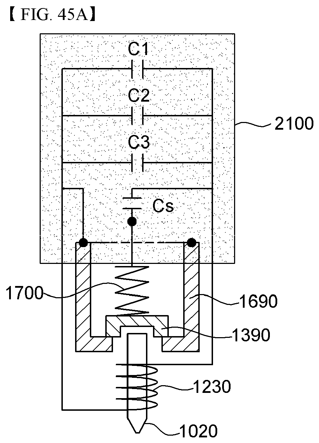

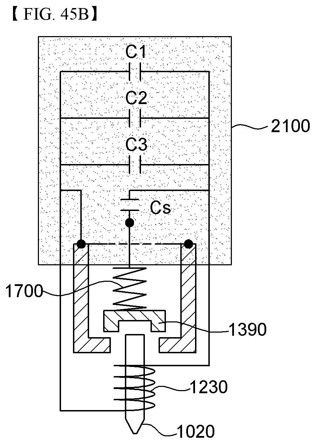

FIGS. 45A and 45B are schematic views illustrating A and B in FIG. 44, respectively;

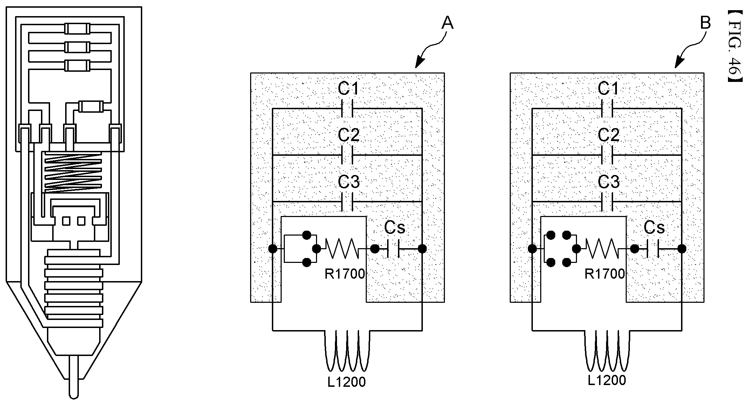

FIG. 46 is a schematic view illustrating a stylus pen according to another embodiment of the present disclosure and showing equivalent circuit diagrams of A and B in FIG. 44;

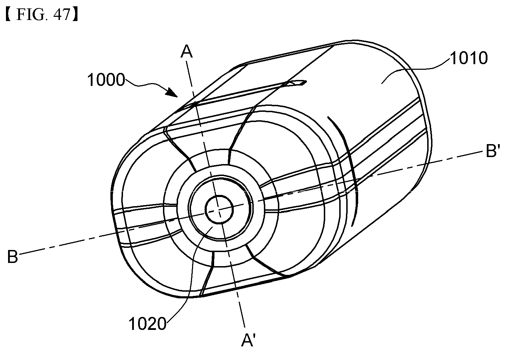

FIG. 47 is a perspective view illustrating a stylus pen 1000 in FIG. 33 according to another embodiment of the present disclosure viewed from the core 1020;

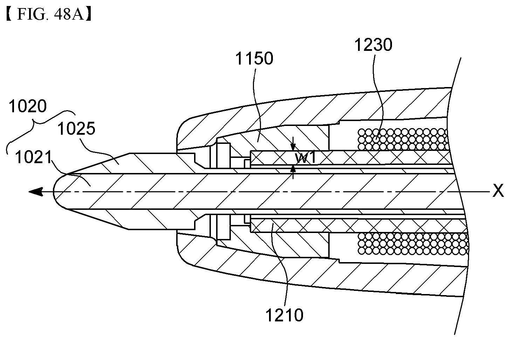

FIG. 48A is a partial cross-sectional view obtained by cutting the stylus pen 1000 along line A-A' in FIG. 47;

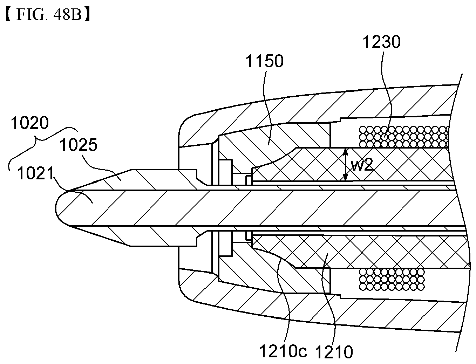

FIG. 48B is a partial cross-sectional view obtained by cutting the stylus pen 1000 along line B-B' in FIG. 47;

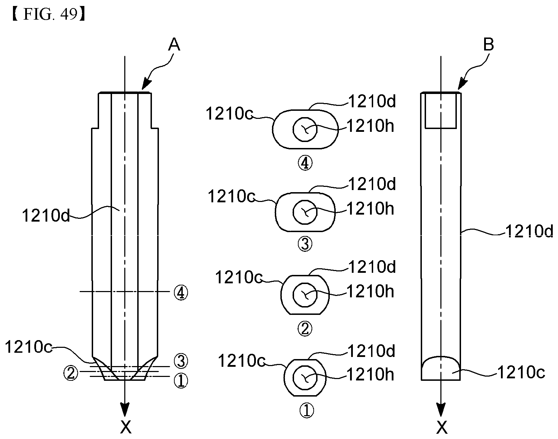

FIG. 49 is a view illustrating cross-sectional views and side views (A and B) of a ferrite core 1210 in FIGS. 47 and 48;

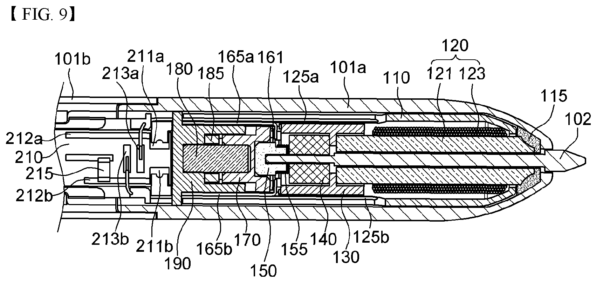

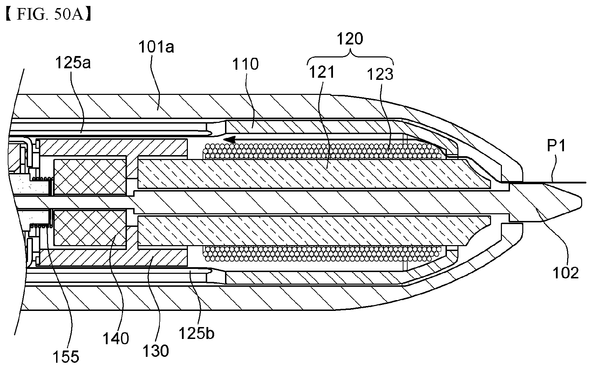

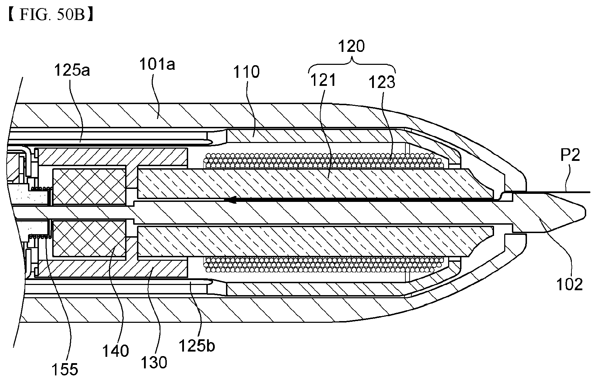

FIGS. 50A and 50B are views illustrating a first moisture ingress path and a second moisture ingress path in which moisture enters into the stylus pen in FIG. 9 through a core opening of the housing;

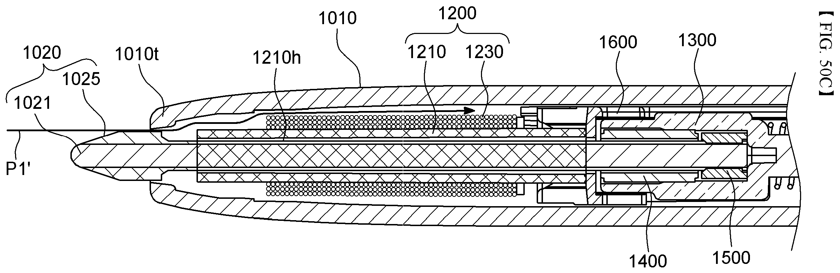

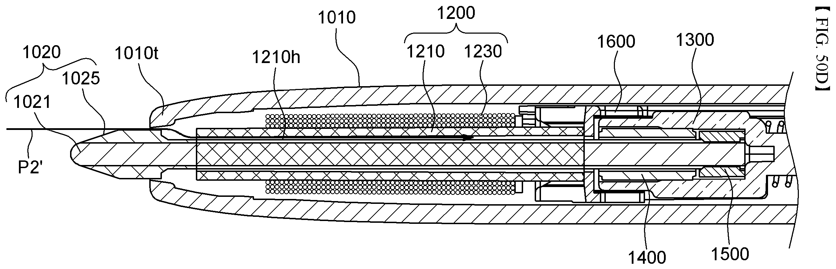

FIGS. 50C and 50D are views illustrating a first moisture ingress path and a second moisture ingress path in which moisture enters into the stylus pen in FIG. 34 through a core opening of the housing;

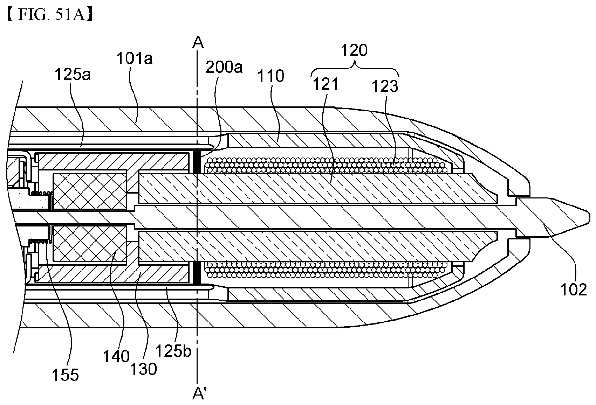

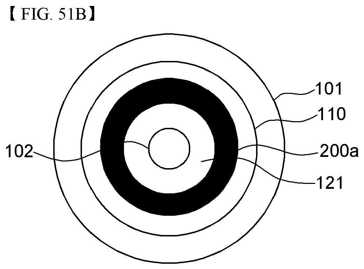

FIGS. 51A and 51B are views illustrating an embodiment of a sealing member for blocking the first moisture ingress path in the stylus pen in FIGS. 50A and 50B;

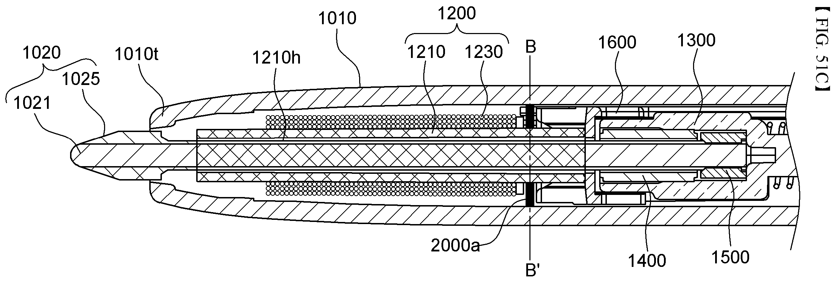

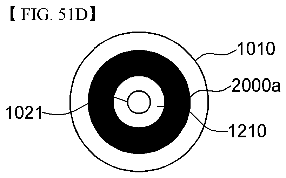

FIGS. 51C and 51D are views illustrating an embodiment of a sealing member for blocking the first moisture ingress path in the stylus pen in FIGS. 50C and 50D;

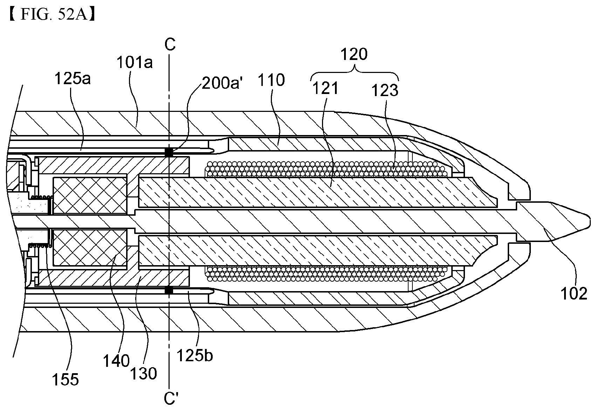

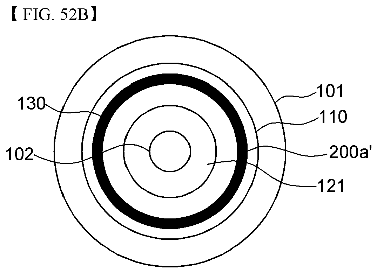

FIGS. 52A and 52B are views illustrating another embodiment of the sealing member for blocking the first moisture ingress path in the stylus pen in FIGS. 50A and 50B;

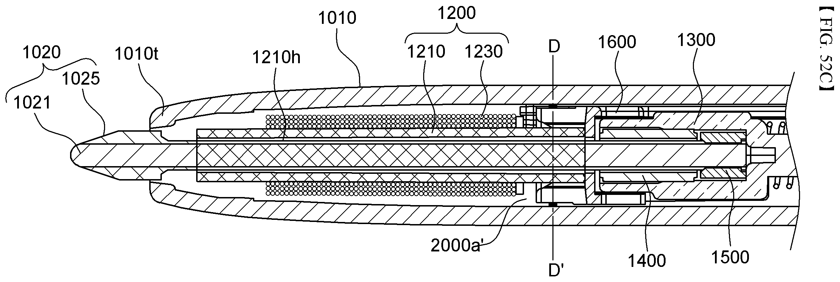

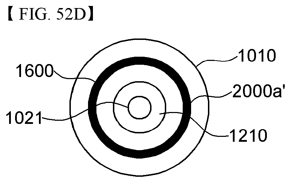

FIGS. 52C and 52D are views illustrating another embodiment of the sealing member for blocking the first moisture ingress path in the stylus pen in FIGS. 50C and 50D;

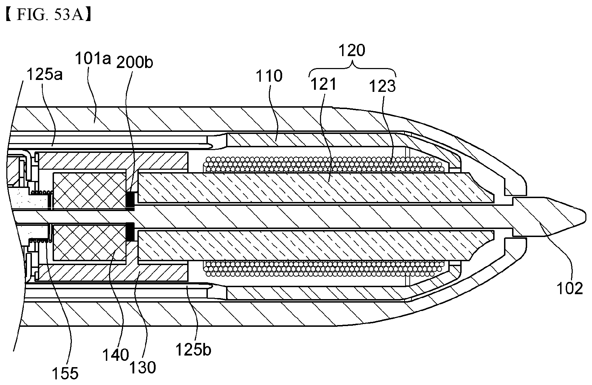

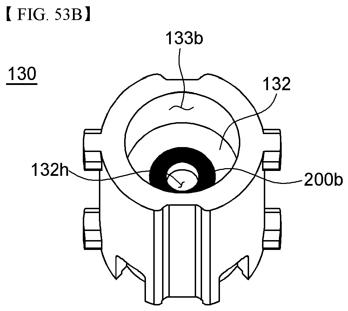

FIGS. 53A and 53B are views illustrating an embodiment of a sealing member for blocking the second moisture ingress path in the stylus pen in FIGS. 50A and 50B;

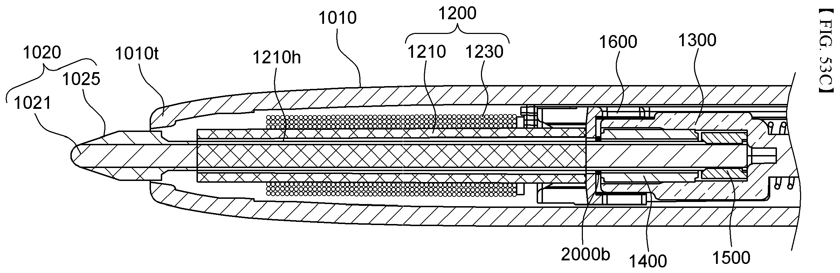

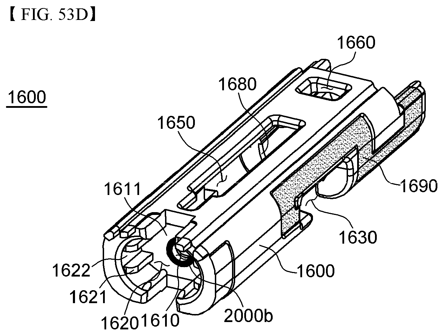

FIGS. 53C and 53D are views illustrating an embodiment of a sealing member for blocking the second moisture ingress path in the stylus pen illustrated in FIGS. 50C and 50D;

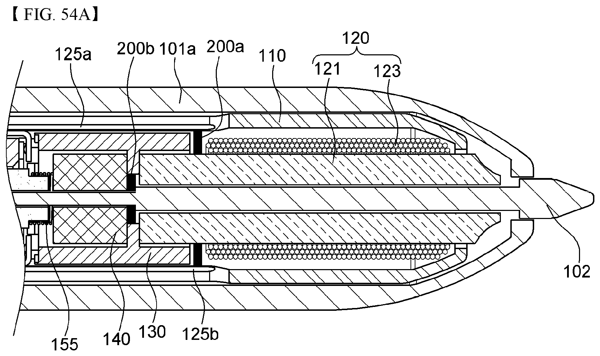

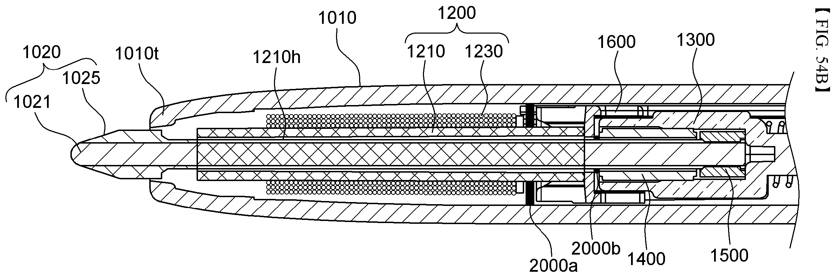

FIGS. 54A and 54B are views illustrating addition of a first sealing member and a second sealing member to each of the stylus pens in FIGS. 50A to 50D;

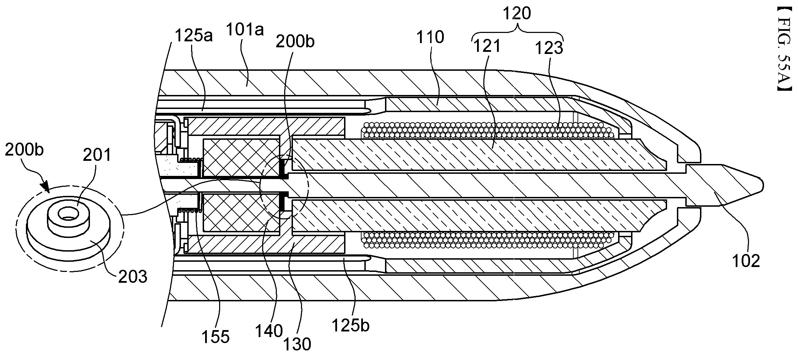

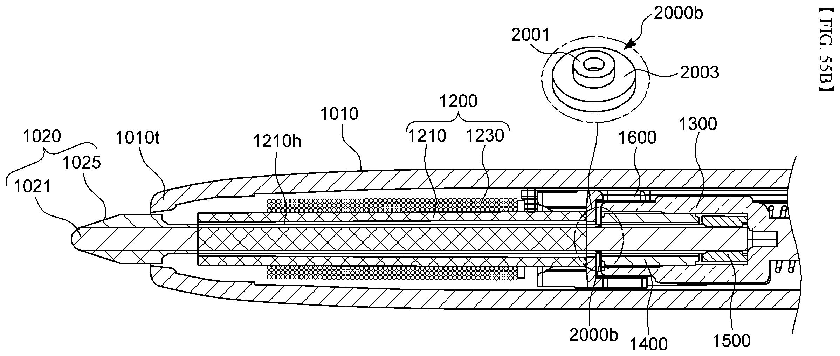

FIGS. 55A and 55B are views illustrating a modified example of the sealing member in FIGS. 53A to 53D;

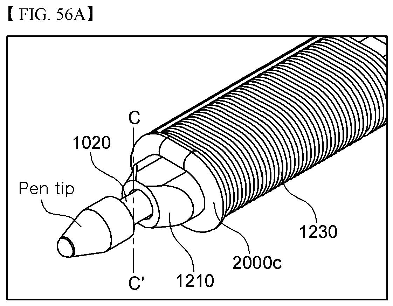

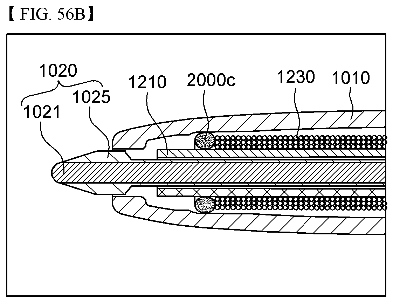

FIGS. 56A and 56B are views illustrating another embodiment of a sealing member for blocking the first moisture ingress path in the stylus pen in FIGS. 50C and 50D;

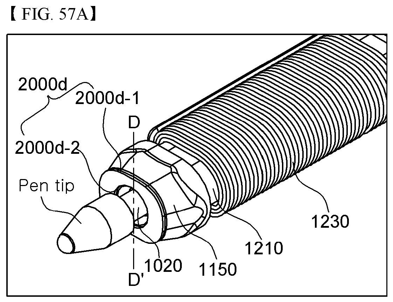

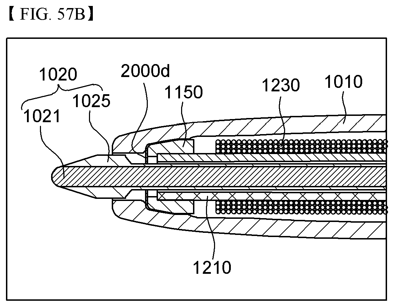

FIGS. 57A and 57B are views illustrating an embodiment of a buffer member for blocking the first moisture ingress path and the second moisture ingress path in the stylus pen in FIGS. 50C and 50D;

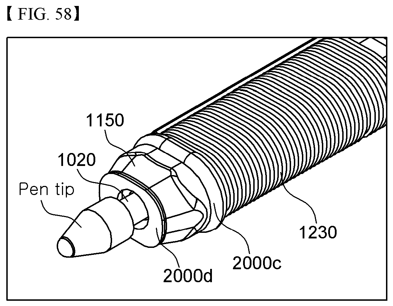

FIG. 58 is a view illustrating a stylus pen including the sealing member in FIG. 56 and the buffer member in FIG. 57;

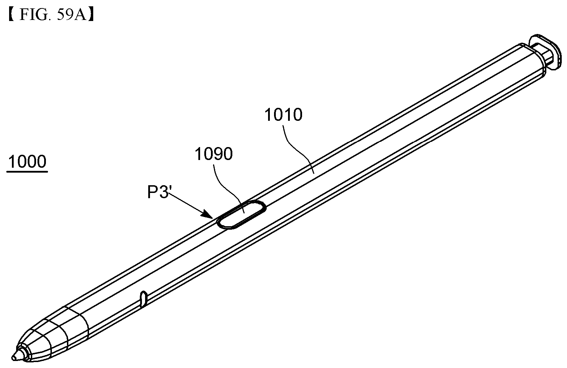

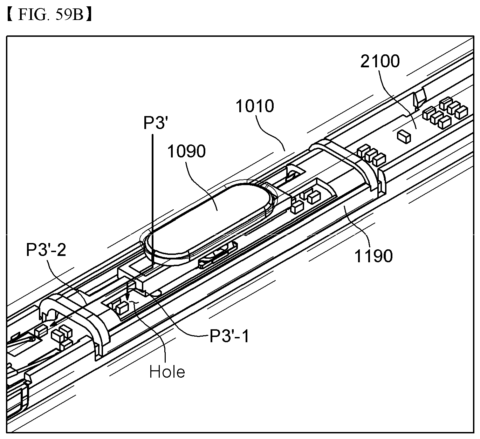

FIGS. 59A and 59B are views illustrating a third moisture ingress path through a button part in the stylus pen in FIG. 34;

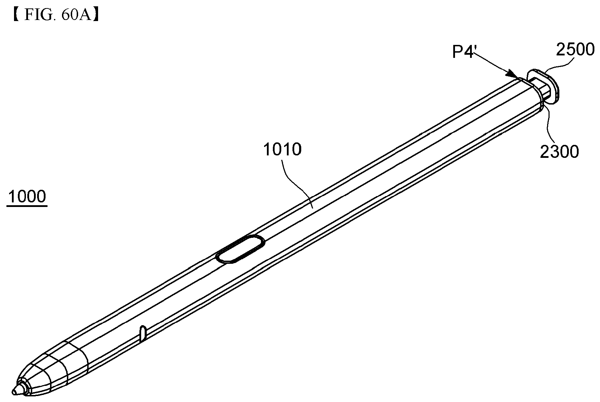

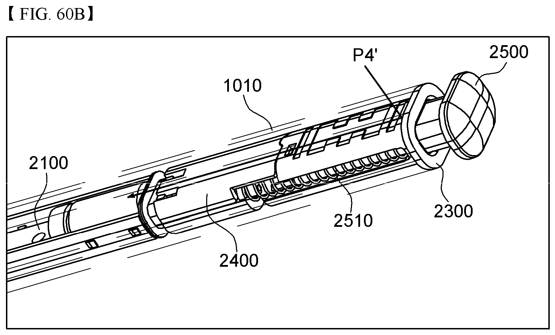

FIGS. 60A and 60B are views illustrating a fourth moisture ingress path in which moisture enters into the stylus pen in FIG. 34 through a coupling portion between a housing and a rear bracket;

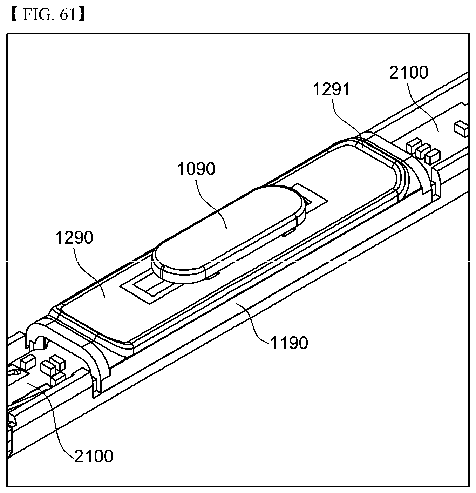

FIG. 61 is a view illustrating a packing member for blocking the third moisture ingress path in the stylus pen in FIGS. 59A and 59B;

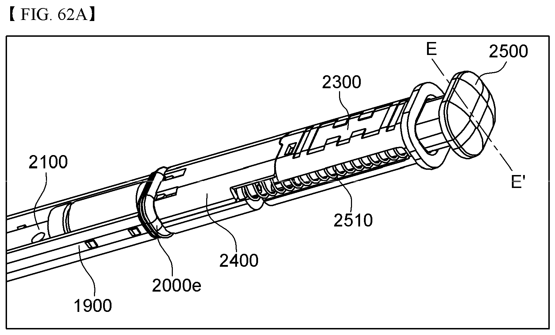

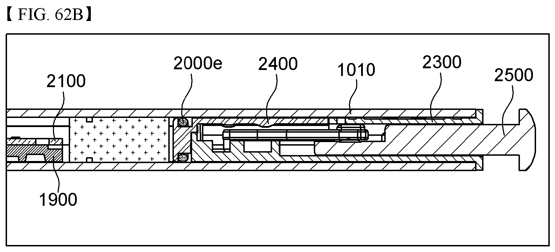

FIGS. 62A and 62B are views illustrating an embodiment of a sealing member for blocking the fourth moisture ingress path in the stylus pen in FIGS. 60A and 60B; and

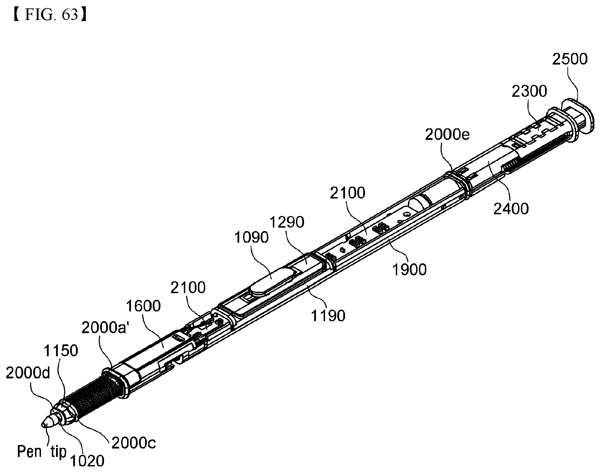

FIG. 63 is a view illustrating a plurality of waterproof units in the stylus pen in FIG. 34.

DETAILED DESCRIPTION

The present disclosure will now be described more fully with reference to the accompanying drawings, in which exemplary embodiments of the invention are shown. These embodiments are provided so that this disclosure will be thorough and complete, and will fully convey the concept of the invention to those skilled in the art. The invention may, however, be embodied in many different forms and should not be construed as being limited to the embodiments set forth herein. Therefore, it will be understood that the embodiments disclosed in this specification includes some variations without limitations to the shapes as illustrated in the figures. Also, the position or the arrangement of each component in the embodiment may be varied without departing form the spirit or scope of the invention. The preferred embodiments should be considered in descriptive sense only and not for purposes of limitation. Therefore, the scope of the invention is defined not by the detailed description of the invention but by the appended claims, and all differences within the scope will be construed as being included in the present disclosure. In the drawings, like reference numerals refer to like elements throughout.

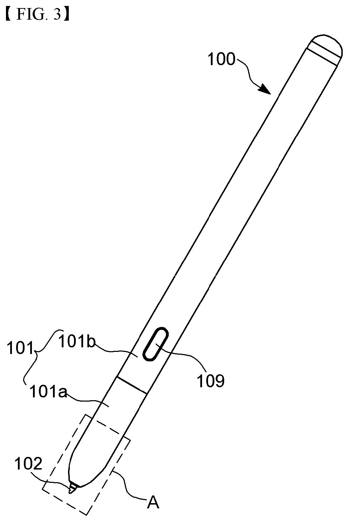

FIG. 3 is a perspective view illustrating a stylus pen 100 according to an embodiment of the present disclosure.

Referring to FIG. 3, a stylus pen according to an embodiment of the present disclosure includes a housing 101 and a core 102.

The housing 101 defines an appearance of the stylus pen 100. The housing 101 includes an inner predetermined space and has an elongated shape in one direction. The housing 101 may be formed such that two or more parts are coupled to each other or integrated into one piece.

The housing 101 may be made of a non-conductive synthetic resin material.

The housing 101 may include a first housing 101a and a second housing 101b. The first housing 101a and the second housing 101b may be coupled to each other to form the appearance of the stylus pen 100. Various components are embedded in the first housing 101a and the second housing 101b.

A button part 109 may be disposed on the housing 101. The button part 109 may be disposed at a middle portion of an outer surface of the second housing 101b. The button part 109 is designed to perform a specific motion of the stylus pen 100. For example, the button part 109 may be a mechanical or touch-type button used for a cancel operation.

The core 102 has one end, which is disposed outside the housing 101, and the rest portion except for the one end, which is disposed in the housing 101. Here, the one end of the core 102 may be referred to as a pen tip.

One portion of the one end of the core 102 may be moved into the housing 101 by external force applied from the outside. As the external force increases, a volume of the one portion of the one end of the core 102, which is moved into the housing 101, may increase. When the applied external force decreases, the one portion of the one end of the core 102 moves out of the housing 101 by a mechanical operation of components in the housing 101. When the external force is not applied, the one portion of the one end of the core 102 is returned to an original state.

Hereinafter, an inner structure of the housing 101 will be described with reference to FIGS. 4 to 5.

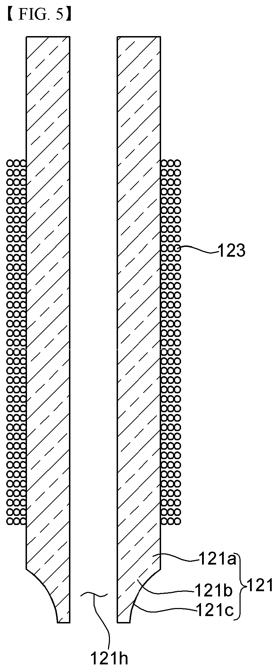

FIG. 4 is a cross-sectional view illustrating portion A of the stylus pen 100 in FIG. 3, and FIG. 5 is a detailed cross-sectional view illustrating an inductor unit 120 in FIG. 4.

Referring to FIGS. 4 and 5, the stylus pen 100 according to an embodiment of the present disclosure includes a buffer member 115, an inductor unit 120, and a capacitor unit (not shown), which are disposed in the housing 101.

The buffer member 115 is disposed in the housing 101 and disposed between one end of a ferrite core 121 and an inner surface of the housing 101. The buffer member 115 may be disposed in a tapered portion 101t of the housing 101. The tapered portion 101t of the housing 101, which is adjacent to the one end of the core 102 among both ends of the housing 101, has a shape having a width or diameter that gradually decreases in a direction toward an end of the one end of the housing 101.

The buffer member 115 has a cone shape or a polygonal pyramid shape and includes a through-hole through which one end of the ferrite core 121 and a body 102a of the core 102 pass. An inner surface of the through-hole may have a shape corresponding to an outer surface of the one end of the ferrite core 121 and an outer surface of the body 102a of the core 102. Here, the body 102a of the core 102 refers to a portion, which is disposed in the through-hole of the ferrite core 12, in the core 102 having an elongated shape in one direction.

The buffer member 115 may be made of an elastic material such as rubber to serve as a buffer between the ferrite core 121 and the housing 101. The buffer member 115 may protect the housing 101 and the ferrite core 121 and block an electrical or magnetic effect from the outside.

The buffer member 115 has a shape that surrounds one end or a lower end 121b of the ferrite core 121.

A virtual tangent line L1, which contacts, in common, the tapered portion 101t of the housing 101 and the portion (or pen tip) disposed outside the housing in the core 102, forms a predetermined angle $\theta$ with a central axis Y of the core 102. Here, the predetermined angle $\theta$ may be less than 30°. When the predetermined angle $\theta$ is less than 30°, a drawing may be performed even in a state in which the stylus pen according to an embodiment of the present disclosure is inclined at 60° based on a contact surface.

The inductor unit 120 may constitute an LC resonant unit with a capacitor unit (not shown). A resonance frequency may be set by a value of inductance L of the inductor unit 120 and a value of capacitance C of the capacitor unit (not shown). This resonance frequency may be varied according to variation in the value of the inductance L of the inductor unit 120 or the value of the capacitance C of the capacitor unit (not shown).

The inductor unit 120 includes a ferrite core 121 and a coil 123 wound around an outer surface of the ferrite core 121.

At least one layer of the coil 123 may be wound around the ferrite core 123.

The ferrite core 121 may have an overall cylindrical or polygonal container shape, and a through-hole 121h that passes through the inside of the ferrite core 121 may be formed along a longitudinal direction of the ferrite core 121.

The ferrite core 121 has the through-hole 121h through which the body 102a of the core 102 passes. The body 102a of the core 102 may perform a linear reciprocating movement along a longitudinal direction through the through-hole 121h.

One end of the ferrite core 121 may have a tapered shape having a diameter or width that gradually decreases in a direction toward an end thereof. Here, an outer surface of the one end having the tapered shape may include at least one curved portion 121c that is curved inward.

The ferrite core 121 may include an upper end 121a and a lower end 121b disposed below the upper end 121a. Here, the upper end 121a and the lower end 121b may be integrated with each other.

The upper end 121a has a cylindrical, elliptical, or polygonal container shape. Here, the cylindrical or polygonal container shape may have a constant diameter or width as illustrated in the drawing. Alternatively, the cylindrical, elliptical, or polygonal container shape may not have a constant diameter or width, and one portion may have a diameter or width different from that of another portion.

A portion of the through-hole 121h through which the body 102a of the core 102 passes is formed in the upper end 121a. The coil 123 is disposed on an outer surface of the upper end 121a.

The rest portion of the through-hole 121h through which the body 102a of the core 102 passes is formed in the lower end 121b.

The lower end 121b has a tapered shape having a width that gradually decreases in a direction from top to bottom. Here, at least a portion of an outer surface of the lower end 121b has a curved portion 121c that is curved into the lower end 121b. At least one curved portion 121c may be provided. A technical effect of the stylus pen including the ferrite core 121 having the above-described curved portion 121c according to an embodiment of the present disclosure will be described below with reference to the accompanying drawings.

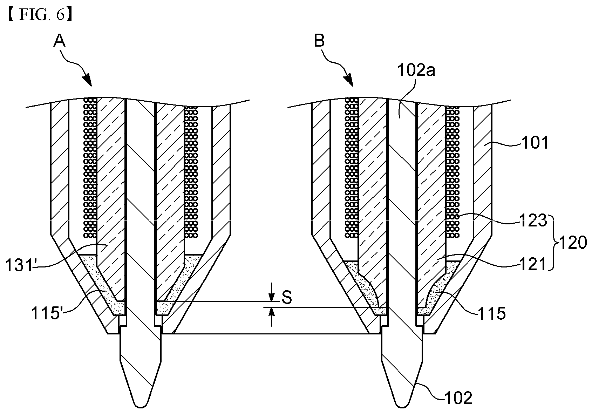

FIG. 6 is a view for explaining an inner configuration of the stylus pen in FIGS. 4 and 5 and an effect caused by the inner configuration according to an embodiment of the present disclosure. Specifically, B in FIG. 6 is a cross-sectional view illustrating the stylus pen according to an embodiment of the present disclosure in FIGS. 4 and 5, and A in FIG. 6 is a cross-sectional view illustrating a case in which the ferrite core 121 in B in FIG. 6 is replaced with the ferrite core 131' illustrated at a right side of FIG. 2.

Referring to FIG. 6, the stylus pen according to an embodiment of the present disclosure in B in FIG. 6 may include the ferrite core 121 that is disposed lower by a predetermined length S than the ferrite core 131' in A in FIG. 6.

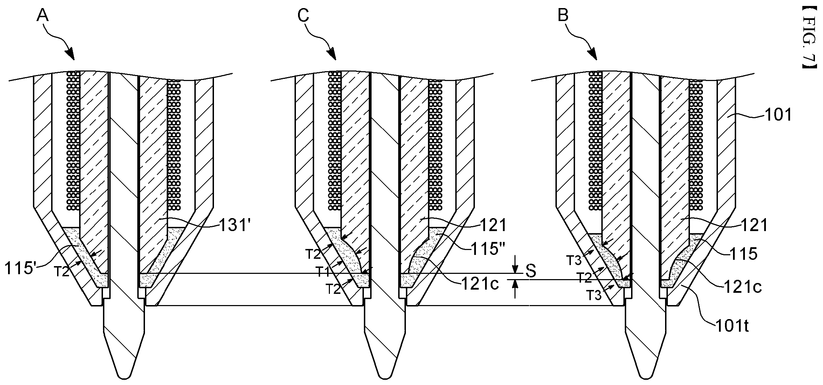

Accordingly, when the stylus pen according to an embodiment of the present disclosure is used, the inductor unit 120 including the ferrite core 121 may be disposed closer to a receiver (not shown) disposed below the core 102 of the stylus pen. Thus, there is an advantage in that a magnitude of a pen signal detected by the receiver increases. This is because a thickness (between inner and outer surfaces) of the buffer member 115 may be reduced by a shape of the ferrite core 121 of the stylus pen according to an embodiment of the present disclosure. Hereinafter, this will be described below with reference to FIG. 7.

FIG. 7 is a view for explaining in more detail an inner configuration of the stylus pen in FIGS. 4 and 5 and an effect caused by the inner configuration according to an embodiment of the present disclosure. Specifically, A in FIG. 7 is the same as A in FIG. 6, B in FIG. 7 is the same as B in FIG. 6, and C in FIG. 7 is a view illustrating a case in which the ferrite core 121 is disposed at the same position as the ferrite core 131' in A in FIG. 7.

Referring to A in FIG. 7, the buffer member 115' has a constant thickness T2 between inner and outer surfaces thereof. As the thickness T2 is gradually minimized, the ferrite core 131' may move as low as possible in the tapered portion 101t of the housing 101. However, the thickness T2 has a limitation due to a structure of the buffer member 115' or other manufacturing processes.

Here, when it is assumed that the thickness T2 is a minimum thickness of the buffer member 115' due to the structure of the buffer member 115' or other manufacturing processes, A in FIG. 7 shows a case in which the conventional ferrite core 131' is disposed at a lowest position in the housing 101.

Referring to C in FIG. 7, the ferrite core 121 is disposed at the same position as the ferrite core 131' in A in FIG. 7. Here, since the ferrite core 121 has the curved portion 121c, the buffer member 115" is different in configuration from the buffer member 115' in A in FIG. 7. Specifically, an inner surface of the buffer member 115" has a protruding curved surface in correspondence to the curved portion 121c of the ferrite core 121.

A thickness between an outer surface and the curved inner surface of the buffer member 115" is varied according to positions. Specifically, each of upper and lower ends of the inner surface of the buffer member 115" has the minimum thickness T2 from the outer surface, an intermediate portion of the inner surface of the buffer member 115" has a thickness between T2 and T1 (where, $T1 > T2$).

In C in FIG. 7, at least one portion (upper and lower ends) of the buffer member 115" satisfies the minimum thickness T2, and the intermediate portion of the buffer member 115" has the thickness T1 greater than the minimum thickness T2. As described above, since the thickness T1 of the intermediate portion of the buffer member 115" is greater than the minimum thickness T2, there is an advantage in that the buffer member 115" is easier to manufacture than the conventional buffer member 115' in A in FIG. 7.

Referring to B in FIG. 7, an inner surface of the buffer member 115 is formed into a curved surface by the curved portion 121c of the ferrite core 121. Each of upper and lower ends of the inner surface of the buffer member 115 has a thickness T3 (T3<T2) from the outer surface of the buffer member 115, and an intermediate portion of the inner surface of the buffer member 115 has a thickness between T3 and T2 from the outer surface of the buffer member 115.

In B in FIG. 7, although the upper and lower ends of the buffer member 115 do not satisfy the minimum thickness T2, since the intermediate portion of the buffer member 115 satisfies the minimum thickness T2, the buffer member 115 may be manufactured. Since the buffer member 115 manufactured as described above has the minimum thickness less than that of each of the buffer members 115' and 115" in A and C in FIG. 7, a volume of the buffer member 115 may be further reduced. Thus, the buffer member 115 may move further downward in the tapered portion 101t of the housing 101. Accordingly, the ferrite core 121 may be disposed lower by a predetermined height S than those in A and C in FIG. 7.

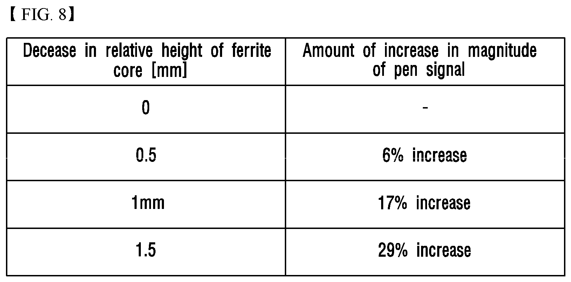

FIG. 8 is a view for explaining an amount of increase in magnitude of a pen signal according to the predetermined height S in A and C in FIG. 7.

Referring to a table in FIG. 8, it may be known that the magnitude of the pen signal increases as the predetermined height S increases.

As described above, the stylus pen 100 according to an embodiment of the present disclosure in FIGS. 4 to 7 may reduce the thickness of the buffer member 115 because the tapered portion of the ferrite core 121 of the inductor unit 120 has a shape different from that of the conventional ferrite core 131'. Thus, the ferrite core 121 may be disposed closer to an end of the stylus pen 102 in the housing 101. Thus, the receiver that receives the pen signal emitted from the stylus pen 100 according to an embodiment of the present disclosure may obtain a greater pen signal to improve sensing sensitivity of the stylus pen at a side of the receiver.

On the other hand, the receiver that is described above several times represents a module or device that receives the pen signal emitted from the stylus pen 100 according to an embodiment of the present disclosure. The receiver may be a general digitizer or a display panel. The display panel may have at least one loop pattern made of a conductive material. The loop pattern may be coupled to a touch sensor or coupled to the display panel separately from the touch sensor.

Hereinafter, specific internal structures of the stylus pen 100 according to an embodiment of the present disclosure, to which the ferrite core 121 and the buffer member 115 in FIGS. 4 to 7 are applied, will be described with reference to the drawings.

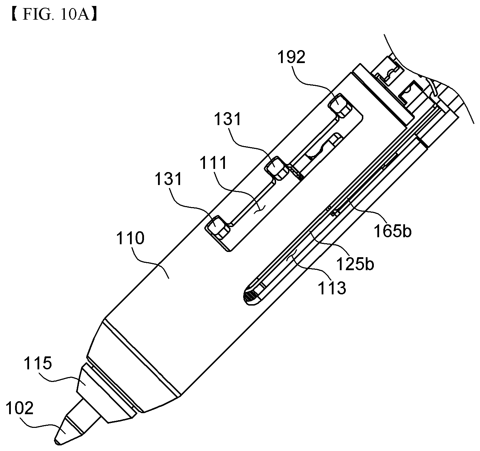

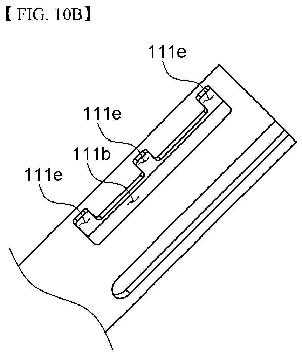

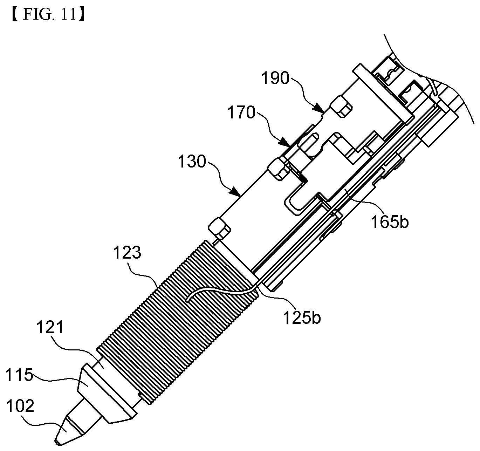

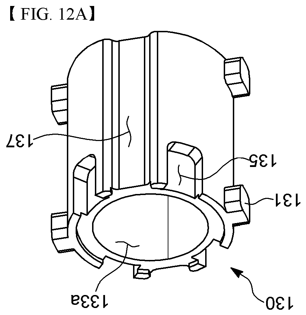

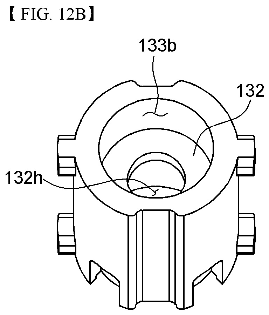

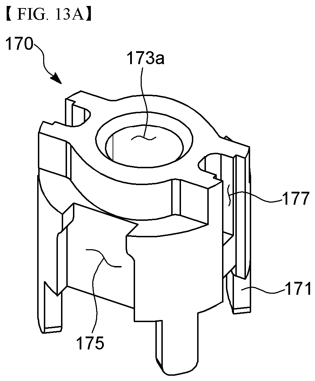

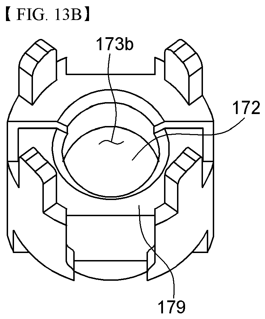

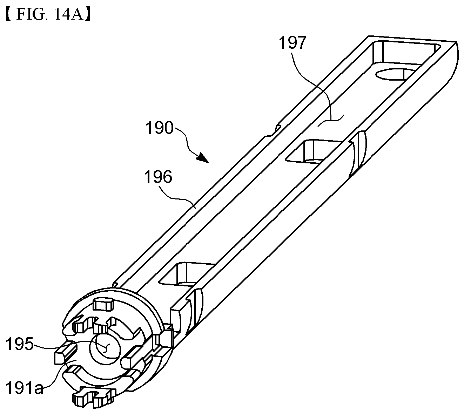

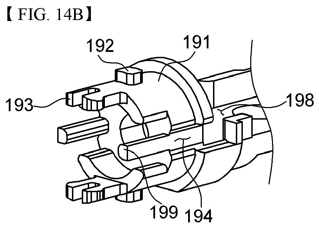

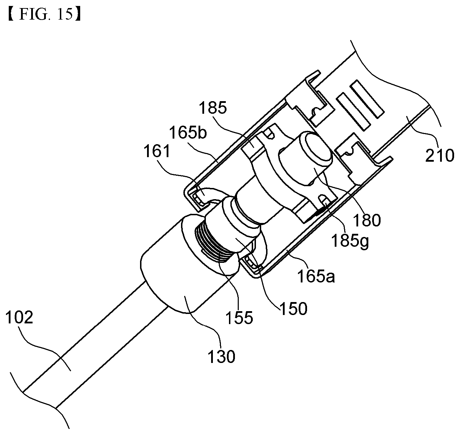

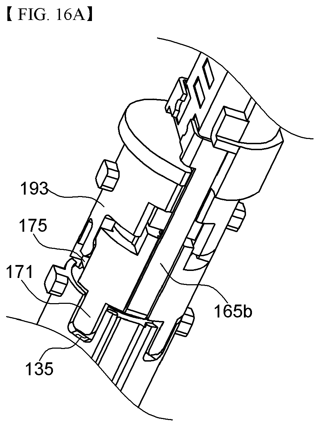

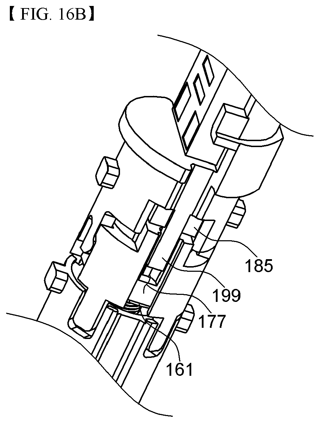

FIG. 9 is a cross-sectional view illustrating a portion of the stylus pen 100 according to an embodiment of the present disclosure in FIG. 3, FIG. 10A is a perspective view for explaining structures of an inner case 110 and the buffer member 115 in FIG. 9, FIG. 10B is a perspective view illustrating only the inner case 110. FIG. 11 is a perspective view illustrating a case in which the inner case 110 in FIG. 10A is removed, FIG. 12A and 12B are perspective views illustrating a first fixing member 130 in FIGS. 9 and 11 from various angles, FIGS. 13A and 13B are perspective views illustrating a moving member 170 in FIG. 9 and 11 from various angles, FIGS. 14A and 14B are perspective views illustrating a second fixing member 190 in FIGS. 9 and 11 from various angles, FIG. 15 is a perspective view illustrating some components in FIGS. 9 and 11 from one side, and FIGS. 16A and 16B are perspective views illustrating only some components in FIGS. 9 and 11.

Referring to FIG. 9, the stylus pen 100 includes at least two of an inner case 110, a buffer member 115, an inductor unit 120, a capacitor unit (not shown), a first fixing member 130, a magnetic body 140, a cover part 150, a ring terminal 161, connection terminals 165a and 165b, a moving member 170, a first elastic member 180, a second elastic member 185, an elastic body 155, a second fixing member 190, and a substrate 210.

The inner case 110 is made of a non-conductive material and is disposed in the housing 101. Specifically, the inner case 110 may be disposed in a first housing 101a of the housing 101. The inner case 110 may have a shape surrounding the inductor unit 120, the first fixing member 130, the ferrite chip 140, the cover part 150, the ring terminal 161, the connection terminals 165a and 165b, the moving member 170, the first elastic member 180, the second elastic member 185, the elastic body 155, and the second fixing member 190. The inner case 110 serves to protect various inner components from physical and/or electrical impacts.

Referring to FIG. 9 and FIGS. 10A and 10B, the inner case 110 may have a first opening 111 in which a first protrusion 131 of the first fixing member 130 and a first protrusion 192 of the second fixing member 190 are disposed. The first opening 111 may have a base groove 111b extending in a longitudinal direction of the stylus pen 100 and a plurality of extension grooves 111e connected to the base groove 111b and extending in a direction perpendicular to the longitudinal direction of the base groove 111b. The plurality of extension grooves 111e may be disposed at positions corresponding to a plurality of first protrusions 131 and 192. For example, the first opening 111 may have an "E"-shape.

The plurality of first protrusions 131 and 192 may be moved from the plurality of extension grooves 111e to the base groove 111b or from the base groove 111b to the plurality of extension grooves 111e by rotating the inner case 110 using the core 102 as a rotation axis in a counterclockwise or clockwise direction. Specifically, positions of the first fixing member 130 and the second fixing member 190 may be fixed in the inner case 110 by moving the plurality of first protrusions 131 and 192 from the base groove 111b to the plurality of extension grooves 111e. On the other hand, the moving member 170 may be moved in conjunction with a linear reciprocating movement of the core 102 caused by external force between the first fixing member 130 and the second fixing member 190 because the moving member 170 is not directly coupled to the inner case 110.

The inner case 110 may have a second opening 113 in which extension coils 125a and 125b are disposed and from which the connection terminals 165a and 165b are exposed. The second opening 113 may provide a space in which the extension coils 125a and 125b are disposed and protect the extension coils 125a and 125b from external impacts. Also, a mounting position of the connection terminals 165a and 165b may be easily checked through the second opening 113.

The buffer member 115 may be disposed between the inductor unit 120 and the housing 101 and between the core 102 and the inner case 110. The buffer member 115 has a through-hole through which the core 102 passes. The buffer member 115 may guide a position of the core 102, stably fix the inductor unit 120, and block the inductor unit 120 from external electrical or magnetic effects. Although the buffer member 115 may be provided separately from the inner case 110, the embodiment of the present disclosure is not limited thereto. For example, the buffer member 115 may be integrated with the inner case 110.

Referring to FIGS. 9 and 11, the buffer member 115, the inductor unit 120, the first fixing member 130, the moving member 170, and the second fixing member 190 may be arranged sequentially along a longitudinal direction (hereinafter, referred to as a "longitudinal direction") of the stylus pen 100 from one end of the core 102. That is, along the longitudinal direction, the inductor unit 120 may be disposed on the buffer member 115, the first fixing member 130 may be disposed on the inductor unit 120, the moving member 170 may be disposed on the first fixing member 130, and the second fixing member 190 may be disposed on the moving member 170.

The inductor unit 120 includes a ferrite core 121 and a coil 123 wound around the ferrite core 121. The ferrite core 121 has a through-hole through which the core 102 passes. The core 102 may perform a linear reciprocating movement along the longitudinal direction through the through-hole. At least one layer of the coil 123 may be wound around the ferrite core 121. The extension coils 125a and 125b may be connected to both ends of the coil 123, respectively. The extension coils 125a and 125b may each extend along the longitudinal direction and be connected to coil electrodes 213a and 213b disposed on the substrate 210, respectively.

The inductor unit 120 is fixedly installed in the housing 101. The inductor unit 120 may be fixed between the first fixing member 130 and the buffer member 115 in the longitudinal direction. The inductor unit 120 may be fixed by the inner case 110 in a direction (hereinafter, referred to as a "vertical direction") perpendicular to the longitudinal direction.

The inductor unit 120 may be fixed at one side of the first fixing member 130. Here, a portion of the inductor unit 120 may be disposed in a second cavity 133b of the first fixing member 130.

The inductor unit 120 may be electrically connected to a capacitor unit (not shown) mounted to the substrate 210 to constitute a resonance circuit unit. A resonance frequency may be set by a value of inductance L of the inductor unit 120 and a value of capacitance C of the capacitor unit (not shown). The resonance frequency may be varied because the value of inductance L of the inductor unit 120 is varied according to a movement of the magnetic body 140.

The capacitor unit (not shown) is disposed on the substrate 210. The capacitor unit (not shown) has a preset value of the capacitance C. The capacitor unit (not shown) may include two or more capacitors. The circuit may be constituted such that at least one of the two or more capacitors is always electrically connected to the inductor unit 120 as a basic capacitor.

The capacitor unit (not shown) includes a jumping capacitor 215. The circuit may be constituted such that the jumping capacitor 215 is mounted on the substrate 210 and electrically connected to the connection terminals 165a and 165b. For example, the jumping capacitor 215 may be electrically connected to connection pads 211a and 211b disposed on the substrate 210 through conductive patterns 212a and 212b. The jumping capacitor 215 may be electrically connected to or disconnected from the basic capacitor according to the movement of the core 102. Since the ring terminal 161 is in contact with the contact terminals 165a and 165b when external force is not applied to the core 102, the jumping capacitor 215 is connected to the base capacitor. On the other hand, when the moving member 170 that operates together with the core is moved toward the first elastic member 180 as external force is applied to the core 102, the ring terminal 161 is detached from the connection terminals 165a and 165b. Here, the jumping capacitor 215 may be electrically disconnected from the base capacitor.

Referring to FIGS. 9 and 11 and FIGS. 12A and 12B, the first fixing member 130 is disposed in the inner case 110. The first fixing member 130 has an overall cylindrical shape. The first fixing member 130 has a first cavity 133a and a second cavity 133b. The magnetic body 140 in FIG. 9 is disposed in the first cavity 133a, and one end of the ferrite core 121 of the inductor unit 120 in FIG. 9 is disposed in the second cavity 133b. A partition wall 132 is disposed between the first cavity 133a and the second cavity 133b, and the partition wall 132 has a through-hole 132h through which the core 102 passes.

The inductor unit 120 is disposed at one side of the first fixing member 130, and the second fixing member 190 is spaced at a predetermined distance from the other side of the first fixing member 130.

The plurality of first protrusions 131 that are described above may be disposed on an outer surface of the first fixing member 130.

A plurality of first grooves 135 in which a plurality of extension portions 171 are disposed, respectively, may be formed in the outer surface of the first fixing member 130. Also, a second groove 137 formed along the longitudinal direction to maintain a constant distance with the extension coils 125a and 125b illustrated in FIG. 11 may be formed in the outer surface of the first fixing member 130.

Referring to FIGS. 9 and 11 and FIGS. 13A and 13B, the moving member 170 is disposed between the first fixing member 130 and the second fixing member 190. The moving member 170 may perform a linear reciprocating movement between the first fixing member 130 and the second fixing member 190 in conjunction with a longitudinal movement of the core 102.

The moving member 170 is disposed in the inner case 110. The moving member 170 has an overall cylindrical shape. The moving member 170 includes a first cavity 173a and a second cavity 173b. A portion of the first elastic member 180 in FIG. 9 is disposed in the first cavity 173a, and a portion of the cover member 150 in FIG. 9 is disposed in the second cavity 173b. A partition wall 172 is disposed between the first cavity 173a and the second cavity 173b, and the partition wall 172 is disposed between the cover member 150 and the first elastic member 180.

The plurality of extension portions 171 disposed in the plurality of first grooves 135 are disposed on the outer surface of the moving member 170. The plurality of extension portions 171 may each have a shape extending along the longitudinal direction and be moved along the first grooves 135 of the first fixing member 130.

A plurality of second grooves 175 in which the second extension portions 193 of the second fixing member 190 in FIGS. 14A and 14B are disposed, respectively, may be formed on the outer surface of the moving member 170. As the moving member 170 performs the linear reciprocating movement along the longitudinal direction, the second grooves 175 are also moved accordingly. Thus, a position of the second extension portions 193 of the second fixing member 190 disposed in the second grooves 175 may be changed.

The second groove 175 of the moving member 170 may have a shape corresponding to the second extension portion 193 of the second fixing member 190. The second groove 175 may have a shape that prevents the second extension portion 193 of the second fixing member 190 from completely separated from the second groove 175 when the moving member 170 is moved away from the second fixing member 190. To this end, the second groove 175 may have a shape having a width that gradually decreases in a direction toward the second fixing member 190, and the second extension portion 193 of the second fixing member 190 may have a shape that protrudes in a width direction of the second groove 175.

A first groove 177 may be formed in the outer surface of the moving member 170. The first groove 177 may be elongated in the longitudinal direction, and the connection terminals 165a and 165b may be disposed in the first groove 177 as illustrated in FIG. 16B. The first groove 177 may fix and guide a position of the connection terminals 165a and 165b. Also, the first extension portion 192 of the second fixing member 190 may be disposed in the first groove 177 together with the connection terminals 165a and 165b.

Since the moving member 175 is disposed between the first fixing member 130 and the second fixing member 190, an extension portion 171 of the moving member 170 is disposed in the first groove 135 of the first fixing member 130, and first and second extension portions 193 and 199 of the second fixing member 190 are disposed in the first and second grooves 175 and 177 of the moving member 170, the moving member 175 may not be separated to the outside even during frequent movements.

The moving member 170 may include one surface 179 in which the first cavity 173a is defined, and the ring terminal 161 in FIGS. 9 and 15 may be disposed on the one surface 179. The one surface 179 may have a shape corresponding to that of the ring terminal 161. The ring terminal 161 disposed on the one surface 179 may be guided by an inner surfaces of at least one extension portion 171 disposed therearound.

Referring to FIGS. 9, 11, and FIGS.14A and 14B, the second fixing member 190 is fixed in the housing 101. At least a portion of the second fixing member 190 is fixed in the inner case 110.

The second fixing member 190 includes a cylindrical base portion 191. One surface 191a of the base portion 191 has a cavity 195 in which a portion of the first elastic member 180 in FIG. 9 is disposed. The second elastic member 185 in FIG. 9 is disposed on the one surface 191a of the base portion 191.

The second fixing member 190 includes a first extension portion 199 and a second extension portion 193, each of which extends from the one surface of the base portion 191 towards the moving member 170. A plurality of first extension portions 199 and a plurality of second extension portions 193 may be disposed on the one surface 191a of the base portion 191. Specifically, two first extension portions 199 may be disposed to face each other, and two second extension portions 193 may be disposed to face each other. The plurality of first and second extension portions 191 and 199 guide an outer surface of the second elastic member 185 in FIG. 9 from all directions. Thus, a position of the second elastic member 185 may be fixed by the plurality of first and second extension portions 191 and 199.

The first extension portion 199 may have an inner surface that guides an outer surface of the second elastic member 185 and an outer surface that supports a portion of the connection terminals 165a and 165b in FIGS. 9 and 11.

The second extension portion 193 has a predetermined shape so as not to be separated from the second groove 175 after being coupled to the second groove 175 of the moving member 170. For example, the second extension portion 193 may have a shape in which at least a portion protrudes to prevent separation from the second groove 175.

The second fixing member 190 may have a groove 194 defined in an outer surface of the base portion 191. A bottom surface of the groove 194 may be connected to the outer surface of the first extension portion 199 without a stepped portion. A portion of the connection terminals 165a and 165b in FIGS. 9 and 11 may be disposed in the groove 194.

The second fixing member 190 may include a seat portion 196 that extends along the longitudinal direction from the other surface (not shown) of the base portion 191. The seat portion 196 may have a cavity 197 in which the substrate 210 in FIGS. 9 and 11 is disposed.

The second fixing member 190 may have an opening 198 for connecting the connection terminals 165a and 165b in FIGS. 9 and 11 to the substrate 210 disposed in the cavity 197. The other ends of the connection terminals 165a and 165b may be disposed in the opening 198 and connected to the connection pads 211a and 211b of the substrate 210.

Referring to FIGS. 9, 11, and 15 and FIGS. 16A and 16B, the core 102 may extend a predetermined length in the longitudinal direction, and one end thereof may have a sharp shape. Here, the one end is exposed to the outside of the housing 101.

The core 102 includes a stepped portion 102T disposed on one portion of the intermediate portion between one end and the other end. One end and the other end of the intermediate portion may have different thicknesses based on the stepped portion 102T. Based on the stepped portion 102T, the one end of the intermediate portion may have a first thickness D1 greater than a second thickness D2 of the other end of the intermediate portion. The above-described stepped portion 102T allows the magnetic body 140 to be move together when the core 140 is moved along the longitudinal direction by external force. That is, when the core 102 is moved, the stepped portion 102T may push one surface of the magnetic body 140 to move the magnetic body 140 in the longitudinal direction. As the magnetic body 140 is moved along the longitudinal direction, a spaced distance between the inductor unit 120 and the magnetic body 140 is varied. The variation in distance varies a value of the inductance L of the inductor unit 120, and the variation in value of the inductance varies the resonance frequency of the stylus pen 100. A stylus pen sensing device that interacts with the stylus pen 100 may sense a variation in the resonance frequency to detect a pen pressure (pressure) applied to the core 102.

The magnetic body (140) is disposed in the first cavity 133a of the first fixing member 130 in FIGS. 12A and 12B and has a cylindrical shape. Also, the magnetic body 140 has a through-hole through which a portion of the core 102 passes. The through-hole may have a diameter equal to or greater than the second thickness D2 and less than the first thickness D1.

The magnetic body 140 may be a ferrite chip.

The magnetic body 140 may perform a linear reciprocating movement along the longitudinal direction in conjunction with the core 102. As the magnetic body 140 is moved in conjunction with the core 102, the value of the inductance L of the inductor unit 120 may be varied.

A cover part 161 is disposed at the other end of the core 102. The cover part 161 may have a shape covering the other end of the core 102. For example, the cover part 161 may have a cylindrical shape having different thicknesses at upper and lower portions.

The elastic member 155 may be disposed between the cover portion 161 and the magnetic body 140. The elastic member 155 may be a spring. The elastic member 155 may have one end that is inserted into a portion of the cover portion 161 and the other end and the other end that is in contact with the magnetic body 140.

The elastic member 155 may compensate a deviation of the magnetic body 140. For example, when a length (or height) of the magnetic body 140 is less by 0.1mm than a specification, the elastic member 155 allows the magnetic body 140 to be in close contact with the partition wall 132 of the first fixing member 130.

The ring terminal 161 is a hollow circle and electrically connects two connection terminals 165a and 165b. Here, the embodiment of the present disclosure is not limited to the shape of the ring terminal 161. For example, the ring terminal 161 may have a polygonal shape.

The ring terminal 161 is disposed on one surface of the moving member 170 and operates in conjunction with the moving member 170. That is, the ring terminal 161 is moved together with the linear reciprocating movement of the moving member 170 in the longitudinal direction.

Each of the connection terminals 165a and 165b includes one end that contacts or separates from the ring terminal 161 and the other end connected to the substrate 210. The one end may contact or separate from the ring terminal 161 by a movement of the ring terminal 161 that operates in conjunction with the moving member 170. The other end is directly connected to the connection pads 211a and 211b of the substrate 210 in FIG. 9 through soldering and the like.

The connection terminals 165a and 165b include a base portion disposed between the one end and the other end. This base portion may have a shape extending in the longitudinal direction. The base portion may be disposed in the first groove 177 of the moving member 170 in FIGS. 13A and 13B and in the groove 194 of the second fixing member 190 in FIGS. 14A and 14B. The base portion may be guided by the first extension portion 199 of the second fixing member 190.

The first elastic member 180 is disposed in the second fixing member 190. The first elastic member 180 may have a cylindrical shape that is elongated in the longitudinal direction. The first elastic member 180 may be made of a rubber material.

The first elastic member 180 may have one end disposed in the cavity 195 of the second fixing member 190 in FIGS. 14A and 14B and the other end disposed in the first cavity 173a of the moving member 170 in FIGS. 13A and 13B.

The second elastic member 185 is disposed in the second fixing member 190. The second elastic member 185 may have a flat cylindrical shape. The second elastic member 185 may be made of a rubber material. The second elastic member 185 may be made of a rubber material that is harder relative to that of the first elastic member 180. Thus, the second elastic member 185 may be made of a hard rubber material, and the first elastic member 180 may be made of a soft rubber material.

On the other hand, the second elastic member 185 may be a spring. The second elastic member 185 may be a spring configured to respond to relatively heavier force than the first elastic member 180.

The second elastic member 185 has a thickness in the longitudinal direction, which is less than that of the first elastic member 180, and a diameter in the vertical direction, which is greater than that of the first elastic member 180.

The second elastic member 185 is disposed to surround an intermediate portion of the first elastic member 180. Thus, the second elastic member 185 has a through-hole through which the first elastic member 180 passes.

As illustrated in FIG. 16B, the second elastic member 185 may have a groove 185g that is inserted into a portion of the first extension portion 199 of the second fixing member 190. Through this, the second elastic member 185 may be stably fixed to the second fixing member 190.

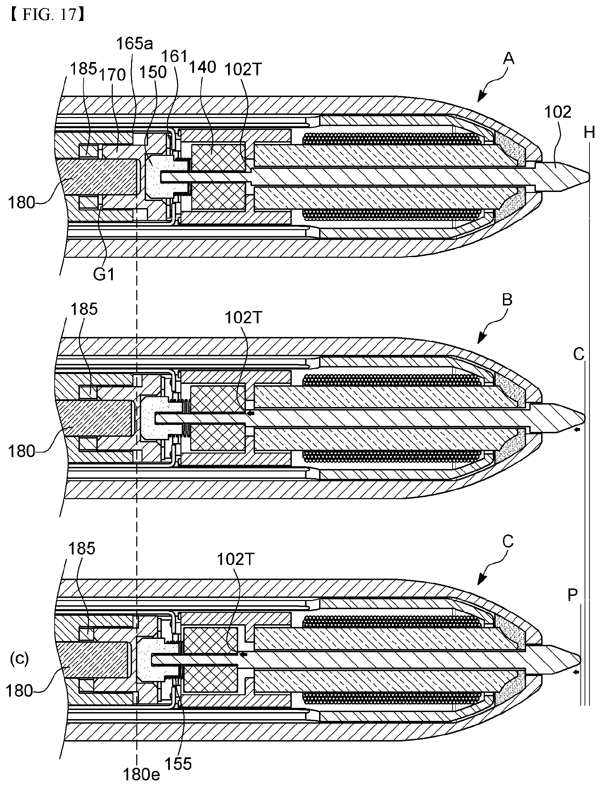

Hereinafter, a motion of the stylus pen 100 according to an embodiment in FIGS. 9 to 16 will be described with reference to FIG. 17.

FIG. 17 are views for explaining the motion of the stylus pen 100 in FIGS. 9 to 16. Specifically, A in FIG. 17 is a view illustrating a hover state H of the stylus pen 100, B in FIG. 17 is a view illustrating a contact state C of the stylus pen 100, and C in FIG. 17 is a view illustrating a pen pressure state P of the stylus pen 100.

Referring to A in FIG. 17, since external force is not applied to the core 102 in the hover state H, the inner components are not changed. In particular, the ring terminal 161 and the connection terminals 165a and 165b maintain a contact state therebetween.

Referring to B in FIG. 17, in the contact state C, a predetermined pressure is applied to one end of the core 102. The applied pressure causes the core 102 to be moved in an inward direction of the housing 101. As the core 102 is moved, the cover portion 150 pushes the moving member 170 towards the first elastic member 180, and the ring terminal 161 is separate from the connection terminals 165a and 165b. Accordingly, the jumping capacitor 215 in FIG. 9 is electrically disconnected from the base capacitor, and overall capacitance of the capacitor unit (not shown) decreases. Here, since the magnetic body 140 is not moved, the value of the inductance of the inductor unit 120 remains unchanged. Since the overall capacitance value of the capacitor unit (not shown) decreases, the resonance frequency is varied.

Referring to C in FIG. 17, in the pen pressure state P, greater pressure is applied to one end of the core 102 than that in the contact state C. The greater pressure causes the core 102 to be moved further in an inward direction of the housing 101. Accordingly, the magnetic body 140 is pushed by the stepped portion 102T of the core 102. As the magnetic body 140 is pushed, the elastic body 155 disposed between the cover part 150 and the magnetic body 140 is pressed, and as the moving member 170 is moved, the first elastic member 180 and the second elastic member 185 are pressed. Here, since the magnetic body 140 is moved away from the inductor unit 120, the value of the inductance L of the inductor unit 120 gradually decreases. Here, the capacitance of the capacitor unit (not shown) remains the same as that in the contact state C. Since the inductance value of the inductor unit 120 decreases, the resonance frequency is varied.

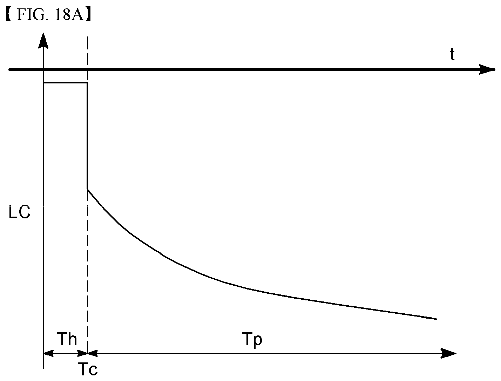

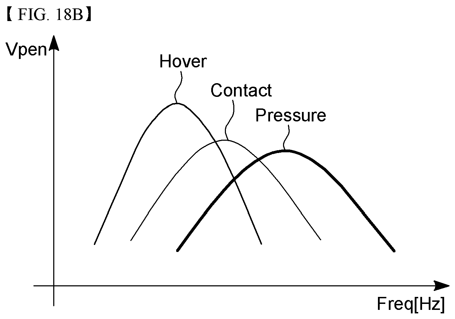

FIG. 18A is a view illustrating a variation in LC value of the resonance circuit unit according to the motions in FIG. 17. Here, a Th period represents the hover state of A in FIG. 17, a Tc point represents the contact state of B in FIG. 17, and a Tp period represents the pressure state of C in FIG. 17. FIG. 18B is a graph showing frequency characteristics in each of the operating states of A to C in FIG. 17.

Referring to FIG. 18A, a LC value of the resonance circuit unit including the capacitor unit (not shown) and the inductor unit 120 maintains a constant value in the Th period, which is before the core 102 of the stylus pen 100 contacts a touch surface, and significantly decreases in the Tc period, which is directly after the core 102 contacts the touch surface Tc. Also, in the period Tp in which pen pressure is applied to the stylus pen 100 after the stylus pen 100 contacts the touch surface, the LC value of the resonance circuit unit decreases further according to the pen pressure. That is, in this period Tp, as the pen pressure applied to the stylus pen 100 increases, the LC value of the resonance circuit unit may gradually decrease. Referring to FIG. 18A, the LC value of the resonance circuit unit shows hover state > contact state > pen pressure state. Also, immediately after the core 102 contacts the touch surface, an amount of variation in LC value is more significant in a state in which the pen pressure gradually increases.

When the value of the inductance of the inductor unit 120 and the value of the capacitance of the capacitor unit (not shown) are varied, the resonance frequency and the Q value of the resonance circuit unit may be also varied. The resonance frequency of the resonance circuit unit increases as the inductance of the resonance circuit unit decreases, and the Q value decreases as the inductance decreases. Thus, as illustrated in FIG. 18B, frequency characteristics of a resonant signal Vpen output from the resonance circuit unit may show that, as a movement distance of the core 102 increases, i.e., the pen pressure increases, the resonance frequency increases (hover state < contact state < pen pressure state), and the Q value decreases (hover state > contact state > pen pressure state).

When the resonance frequency of the resonance circuit unit is varied, a phase of the electromagnetic signal output from the stylus pen 100 is changed. The stylus pen sensing device that interacts with the stylus pen 100 may calculate the variation in the LC value of the resonance circuit unit, and based on this, whether the stylus pen 100 is in contact with the stylus pen sensing device and the pen pressure thereof may be detected.

As described above, the stylus pen 100 according to an embodiment in FIGS. 9 to 16B may change at least one or both of the inductance value and the capacitance value of the resonance circuit unit to detect the pen pressure in the stylus pen sensing device. Also, the stylus pen 100 may have an advantage of sensing precise pressure.

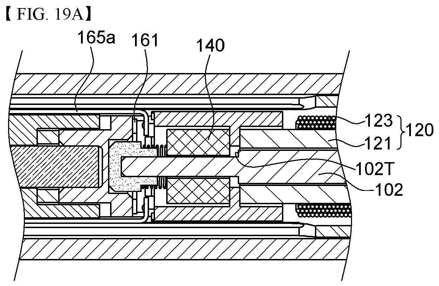

On the other hand, the stylus pen according to an embodiment in FIGS. 9 to 16B may have an assembly deviation during an assembly process. Since the assembly deviation may cause a predetermined limitation, the assembly deviation will be described in detail below with reference to FIGS. 19A to 21C.

FIGS. 19A to 19C are views for explaining a limitation caused by an assembly deviation of a core 102 occurring when the stylus pen 100 in FIGS. 9 to 17 is assembled;

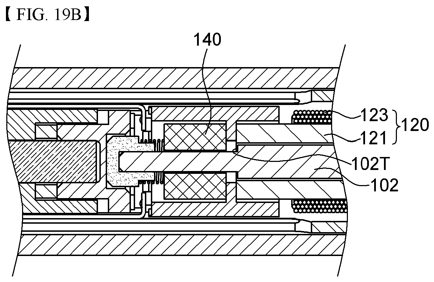

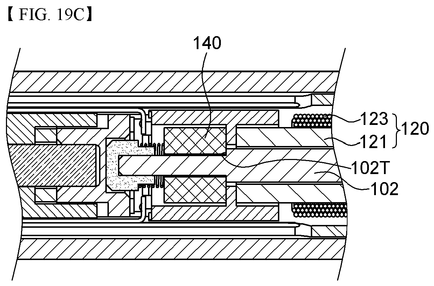

Specifically, FIG. 19A shows a case in which the core 102 is mounted as designed in advance without the assembly deviation, and FIGS. 19B and 19C show a case in which the core 102 is not mounted in a designed position by an assembly deviation occurring during the assembly process.

In FIG. 19A, the stepped portion 102T of the core 102 is disposed in the through-hole 132h formed in the partition wall 132 of the first fixing member 130. A position of the stepped portion 102T is assembled correctly without any deviation. On the other hand, in FIGS. 19B and 19C, the stepped portion 102T is disposed at a different position instead of the through-hole 132h of the partition wall 132. Specifically, the stepped portion 102T is disposed in the second cavity 133b (refer to FIG. 12B) of the first fixing member 130, in which the inductor unit 120 is disposed, in FIG. 19B, and the stepped portion 102T is disposed in the first cavity 133a (refer to FIG. 12A) of the first fixing member 130, in which the magnetic body 140 is disposed, in FIG. 19C.

When the assembly deviation occurs as in FIG. 19B, pressure is continuously applied to the core 102 immediately after the contact state in B in FIG. 17, the inductance value of the inductor unit 120 is not changed immediately because a distance between the inductor unit 120 and the magnetic body 140 is constant. On the other hand, in case of FIG. 19C, as the magnetic body 140 is moved by the core 102 between the hover state of A in FIG. 17 and the contact state of B in FIG. 17, the inductance value of the inductor unit 120 may be varied.

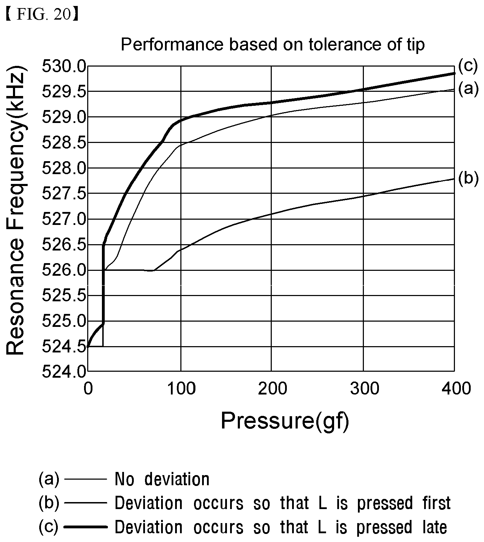

The variation in resonance frequency according to the pressure applied to the core 102 in each of FIGS. 19A to 19C will be described with reference to FIG. 20.

In a graph of FIG. 20, line ① corresponds to FIG. 19A without an assembly deviation, line ② corresponds to FIG. 19C with the assembly deviation, and line ③ corresponds to FIG. 19B with the assembly deviation.

Referring to FIG. 20, in case of line ③, the resonance frequency is not varied although the pressure applied to the core 102 increases immediately after the contact state. Thus, the stylus pen sensing device that interacts with the stylus pen 100 may not detect the pen pressure applied to the core 102. In case of line ②, since the resonance frequency is varied even in the hover state, the stylus pen sensing device may recognize the core 102 as being in the contact state instead of the hover state. As described above, due to the assembly deviation in FIG. 19B and 19C, the stylus pen sensing device may not accurately detect the stylus pen 100.

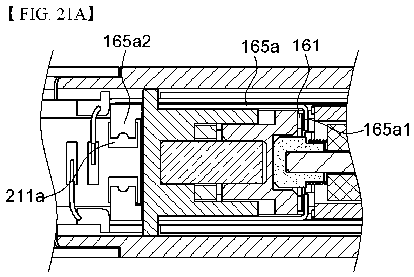

FIG. 21A to 21C are views for explaining a limitation caused by an assembly deviation of connection terminals 165a and 165b occurring when the stylus pen 100 in FIGS. 9 to 17 is assembled.

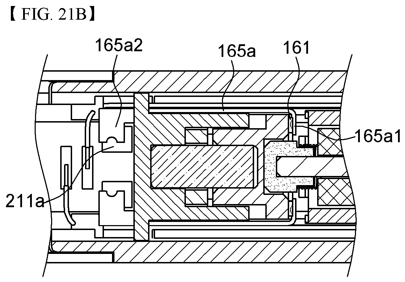

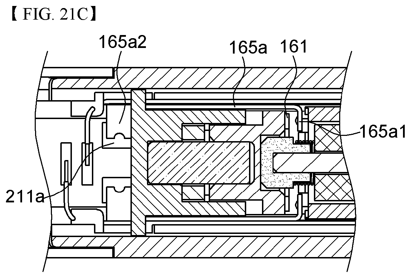

Specifically, FIG. 21A shows a case in which the connection terminals 165a and 165b are mounted as designed without any assembly deviation, and FIGS. 21B and 21C show cases in which the connection terminals 165a and 165b are not mounted at designed positions due to the assembly deviation.

In FIG. 21A, one end 165a1 of the connection terminal 165a is in contact with the ring terminal 161, and the other end 165a2 is in contact with the connection pad 211a of the substrate 210. A position of the connection terminal 165a is assembled correctly without any deviation. On the other hand, in FIGS. 21B and 21C, the connection terminal 165a is disposed at a different position instead of a designed position due to the assembly deviation. Specifically, in FIG. 21B, as the connection terminal 165a is offset by a predetermined distance towards the substrate 210, the one end 165a1 presses the ring terminal 161 with considerable force. In FIG. 21C, as the connection terminal 165a is offset by a predetermined distance towards the first fixing member 130, the one end 165a1 is spaced a predetermined distance from the ring terminal 161.

When the assembly deviation occurs as in FIG. 21B, since the connection terminal 165a and the ring terminal 161 are assembled in a state of being pressed by each other, there is a limitation in that pressure increases to recognize the contact state in B in FIG. 17. On the other hand, in case of FIG. 21C, the ring terminal 161 and the connection terminal 165a are separated from the hover state of A in FIG. 17, the stylus pen sensing device may not sense the contact state of B in FIG. 17 although pressure is applied to the core 102.

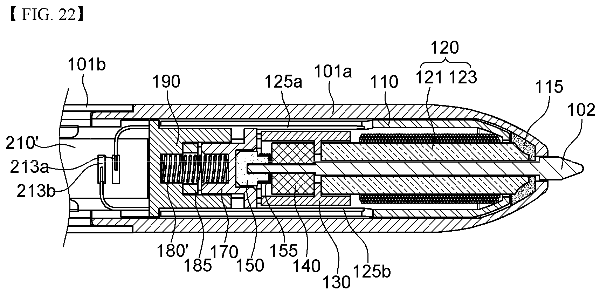

Hereinafter, a stylus pen according to another embodiment, which is not significantly affected in performance although the assembly deviation described with reference to FIGS. 19A to 21C occurs and reduced in manufacturing cost by reducing the number of inner components, will be described with reference to FIGS. 22 to 26.

When compared with the stylus pen 100 in FIGS. 9 to 17, the stylus pen in FIG. 22 is different in that: 1) a first elastic member 180' is made of a spring instead of a rubber material, and 2) the ring terminal 161, the connection terminals 165a and 165b, the jumping capacitor 215, and components for electrical connection therebetween of the stylus pen 100 in FIGS. 9 to 17 are omitted. Since the rest components except for the above-described components are the same as those of the stylus pen 100 in FIGS. 9 to 17, a detailed description thereof will be replaced with the above description, and only different components will be described in detail below.

Referring to FIG. 22, the first elastic member 180' includes a spring. The first elastic member 180' may be pressed even under low pressure (e.g., about 10 gf) and disposed to be pressed quickly even when pressure slightly increases due to a low compression strength thereof.

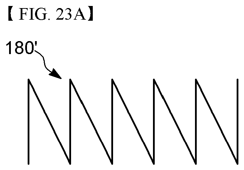

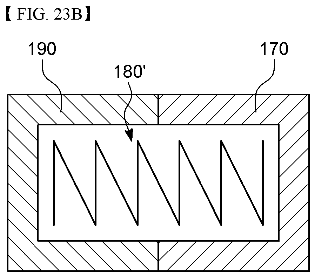

FIG. 23A and 23B are views for explaining the first elastic member 180' in FIG. 22. FIG. 23A is a view illustrating a state in which no force is applied to the first elastic member 180', and FIG. 23B is a view illustrating a state in which the first elastic member 180' is disposed between the moving member 170 and the second fixing member 190 in FIG. 22.

As illustrated in FIG. 23B, the first elastic member 180' is inserted between the moving member 170 and the second fixing member 190 in a partially pressed (or incompletely pressed) state. The first elastic member 180' is not pressed unless force (or repulsive force) greater than the pressed force applied by the moving member 170 and the second fixing member 190. Here, the force (or repulsive force) may be, e.g., about 10 gf. On the other hand, the second elastic member 190 is pressed when force greater than the applied pressed force is applied through the moving member 170.

Below is <Mathematical equation 1> that represents force F (or repulsive force) of the partially pressed first elastic member 180'.

[Mathematical equation 1]

$$F = -kx = -\frac{Gd^4}{8NaD^3}$$

In the <Mathematical equation 1>, G is a transverse elastic modulus of the spring, Na is an effective number of winding of the spring, D is a diameter of the spring, d is a diameter of a wire, and x is a pressed (-direction) length of the spring.

On the other hand, the first elastic member 180' in a non-pressed state may be disposed between the moving member 170 and the second fixing member 190. Thus, the stylus pen according to another embodiment of the present disclosure is not limited to the state in which a portion of the first elastic member 180' in a pressed state is disposed between the moving member 170 and the second fixed member 190.

The first elastic member 180' may be configured to respond to a relatively greater weight than the elastic body 155.

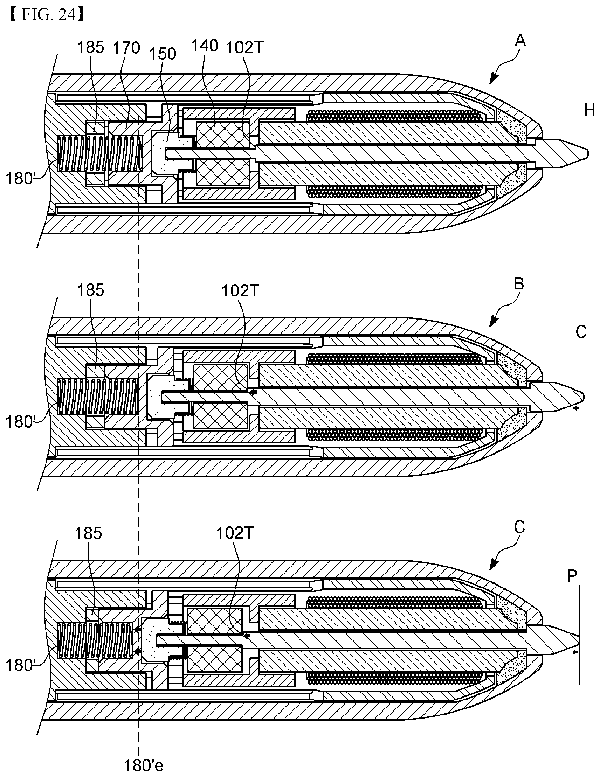

Hereinafter, a motion of the stylus pen according to another embodiment in FIG. 22 and FIGS. 23A and 23B will be described with reference to FIG. 24.

FIG. 24 is a view for explaining a motion of the stylus pen in FIGS. 22 and FIGS. 23A and 23B. Specifically, A in FIG. 24 is a view illustrating the hover state H of the stylus pen, B in FIG. 24 is a view illustrating the contact state C of the stylus pen, and C in FIG. 24 is a view illustrating the pen pressure state P of the stylus pen.

Referring to A in FIG. 24, since external force is not applied to the core 102 in the hover state H, the inner components are not changed.

Referring to B in FIG. 24, in the contact state C, a predetermined pressure is applied to one end of the core 102. The applied pressure causes the core 102 to be moved in an inward direction of the housing 101. As the core 102 is moved, the cover part 150 pushes the moving member 170 toward the first elastic member 180' up to the second elastic member 185. In this situation, the first elastic member 180' is pressed as much as the moving member 170 is pushed. Also, as the core 102 is moved, the stepped portion 102T of the core 102 pushes the magnetic body 140 towards the first elastic member 180'. As the magnetic body 140 is pushed, a distance between the inductor unit 120 and the magnetic body 140 is changed, and this changed distance changes the inductance value of the inductor unit 120 and resultantly changes the resonance frequency.

Referring to C in FIG. 24, in the pen pressure state P, greater pressure is applied to one end of the core 102 than that in the contact state C. The greater pressure causes the core 102 to be moved further in the inward direction of the housing 101, and resultantly the magnetic body 140 is moved further away from the inductor unit 120. As the magnetic body 140 is moved, the elastic body 155 disposed between the cover part 150 and the magnetic body 140 is pressed, and the movement of the moving member 170 causes the first elastic member 180' to be further pressed and the second elastic member 185 to be also pressed. Here, since the magnetic body 140 is moved further away from the inductor unit 120, the inductance L value of the inductor unit 120 gradually decreases. Since the inductance value of the inductor unit 120 decreases, the resonance frequency is varied.

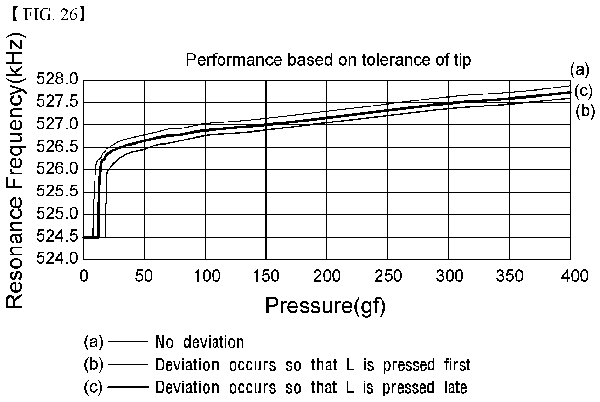

FIGS. 25A and 25B are views illustrating an example of the assembly deviation occurring in the core 102, and FIG. 26 is a graph showing a variation of the resonance frequency according to the pressure applied to the core 102 in each of FIGS. 25A and 25B.

FIG. 25A is a view illustrating a state in which the stepped portion 102T of the core 102 is offset toward the magnetic body 140 due to the assembly deviation occurring during the assembly process, and FIG. 25B is a view illustrating a state in which the stepped portion 102T of the core 102 is offset towards the inductor unit 120 due to the assembly deviation.

In a graph of FIG. 26, line ① corresponds to FIG. 22 that is a case without the assembly deviation, line ② corresponds to FIG. 25A; and line ③ corresponds to FIG. 25B.

Referring to FIG. 26, the stylus pen including the first elastic member 180' according to another embodiment of the present disclosure exhibits a minimal performance change in comparison with the case without the assembly deviation although the assembly deviation slightly occurs in the core 102. Thus, the stylus pen has an advantageous aspect in mass production in comparison with the stylus pen 100 in FIG. 9.

Also, since the stylus pen in FIGS. 22 to 24 does not use components such as the jumping capacitor 215, the ring terminal 161, and the connection terminals 165a and 165b in the stylus pen 100 illustrated in FIGS. 9 to 16B, the stylus pen may have a simplified structure and a reduced manufacturing cost. Furthermore, components for arranging the connection terminals 165a and 165b, such as the groove 194 of the second fixing member 190 in FIGS. 14A and 14B and a portion of the first groove 177 of the moving member 170 in FIGS. 13A and 13B, are not required.

Although not shown in the drawing, the stylus pen according to another embodiment of the present disclosure may be configured such that the first elastic member 180 in the stylus pen 100 in FIG. 9 is replaced with the first elastic member 180' in FIG. 22 and FIGS. 23A and 223B.

On the other hand, although not shown in the drawing, the ferrite core 121 and the buffer member 115 in FIG. 4 may be directly applied to not only the stylus pen in FIGS. 9 to 26 but also conventional stylus pens.

FIG. 27 is a perspective view according to a modified example of the ferrite core 121 in FIGS. 4 and 5, A in FIG. 28 is an enlarged front view illustrating a portion of a ferrite core 121' in FIG. 27, and B in FIG. 28 is a cross-sectional view taken along line A-A' of A in FIG. 28.

Referring to FIGS. 27 and 28, the ferrite core 121' has a cylindrical shape. A flat portion 121d may be disposed on at least a portion of an outer surface of the ferrite core 121'. Another flat portion corresponding to the flat portion 121d may be also disposed on another portion of the outer surface of the ferrite core 121'. The ferrite core 121' may be stably disposed in the housing by the flat portion 121d.

The ferrite core 121' has a cylindrical upper end 121a' and a cylindrical lower end 121b', and the lower end 121b' has at least two curved portions 121c'. The curved portion 121c' may extend from the outer surface of the lower end 121b' to a portion adjacent to the through-hole 121h of the ferrite core 121'. The curved portions 121c' may be disposed at both sides, which face each other, of the lower end 121b' based on the through-hole 121h, respectively.

While the curved surface 121c of the ferrite core 121 in FIGS. 4 to 5 may be disposed over the entire outer surface of the lower end 121b', the curved surface 121c' of the ferrite core 121' in FIGS. 27 to 28 may be disposed on a portion of the outer surface of the lower end 121b'.

The flat portions 121d may be disposed on the upper end 121a' and the lower end 121b', respectively, and connected and continuously arranged. Here, the flat portion 121d disposed on the lower end 121b' may be disposed between two curved portions 121c' that are disposed to face each other on the outer surface of the lower end 121b'.

The ferrite core 121' in FIGS. 27 to 28 may be applied as a replacement to the stylus pen in FIGS. 9 to 26. In this case, a buffer member (not shown) may have a shape covering a portion of the lower end 121b' of the ferrite core 121'.

FIG. 29 is a cross-sectional view illustrating a stylus pen to which another modified example of the ferrite core 121 in FIG. 4 is applied, FIG. 30 is a cross-sectional view illustrating only a ferrite core 121" and a coil 123 in FIG. 29, FIG. 31 is a perspective view illustrating the ferrite core 121" in FIGS. 29 to 30, A in FIG. 32 is an enlarged front view illustrating a portion of the ferrite core 121" in FIG. 31, and B in FIG. 32 is a cross-sectional view taken along the line B-B' of FIG. 31.

Referring to FIGS. 29 to 31, the ferrite core 121" in another modified example includes an upper end 121a" and a lower end 121b".

The lower end 121b" has a tapered shape, and an outer surface of the lower end 121b" includes at least one stepped portion 121c".

The stepped portion 121c" may be disposed over the entire outer surface of the lower end 121b" or disposed on a portion (portions) of the outer surface as in FIGS. 31 to 32.

The stepped portion 121c" may include a first surface 121c1, a second surface 121c2 connected to the first surface 121c1, and a third surface 121c3 connected to the second surface 121c2. The first surface 121c1 may be perpendicular to a direction in which a through-hole 121h passes, and the third surface 121c3 may be parallel to the direction in which the through-hole 121h passes. The second surface 121c2 may connect the first surface 121c1 and the third surface 121c3. Here, although not shown in the drawing, the second surface 121c2 may be a curved surface that is curved inward or outward.

The ferrite core 121" has a cylindrical shape. A flat portion 121d may be disposed on at least a portion of the outer surface of the ferrite core 121". A flat portion corresponding to the flat portion 121d may be disposed on another portion of the outer surface of the ferrite core 121". The flat portion 121d may allow the ferrite core 121" to be stably disposed in the housing.

The flat portions 121d may be disposed on the upper end 121a" and the lower end 121b", respectively, and connected and continuously arranged. Here, the flat portion 121d disposed on the lower end 121b" may be disposed between two stepped portions 121c" that are disposed to face each other on the outer surface of the lower end 121b".

Since the ferrite core 121" in FIGS. 29 to 32 includes the stepped portions 121c", the ferrite core 121" may have the same or similar effect as the ferrite core 121 in FIGS. 4 to 5.

The ferrite core 121" in FIGS. 29 to 32 may be applied as a replacement to the stylus pen in FIGS. 9 to 26. In this case, the buffer member (not shown) may have a shape capable of covering a portion of the lower part 121b" of the ferrite core 121". FIG. 33 is a perspective view illustrating a stylus pen 1000 according to another embodiment of the present disclosure, FIG. 34 is a cross-sectional view illustrating a portion of the stylus pen 1000 in FIG. 33, and FIG. 35 is a perspective view illustrating the stylus pen 1000 in FIG. 33, from which a housing 1010 is removed.

Referring to FIGS. 33 to 35, the housing 1010 forms an appearance of the stylus pen 1000. The housing 1010 includes an inner predetermined space and has an elongated shape in one direction. The housing 1010 may be formed such that two or more parts are coupled to each other or integrated into one piece.

The housing 1010 may be made of a non-conductive synthetic resin material.

A button part 1090 may be disposed on the housing 1010. The button part 1090 is designed to perform a specific motion of the stylus pen 1000. For example, the button part 1090 may be designed to perform a cancel operation or a special function.

A core 1020 includes one end that is disposed outside the housing 1010, and the rest portion except the one end is disposed in the housing 1010. Here, the one end of the core 1020 may be referred to as a pen tip.

The core 1020 may be made of a non-conductive resin material.

The core 1020 may include a base part 1021 and an outer part 1025. The base part 1021 has an elongated shape extending along a longitudinal direction of the stylus pen 1000. The outer part 1025 surrounds a side surface of the base part 1021. One end of the base part 1021 is exposed to the outside instead of being covered by the outer part 1025. The outer part 1025 is made of a relatively harder material than that of the base part 1021 to reinforce and protect the base part 1021.

One portion of the one end of the core 1020 may be moved into the housing 1010 by external force applied from the outside. As the external force increases, a volume of the one portion of the one end of the core 1020, which is moved into the housing 1010, may increase. When the applied external force decreases, the one portion of the one end of the core 1020 is moved out of the housing 101 again. When the external force is not applied, the one portion of the one end of the core 1020 is returned to an original state.

A buffer member 1150 is disposed in the housing 1010 and disposed between one end of a ferrite core 1210 and an inner surface of the housing 1010. The buffer member 1150 may be disposed in a tapered portion 1010t of the housing 1010. Here, the tapered portion 101t of the housing 1010, which is adjacent to the one end of the core 1020 among both ends of the housing 1010, has a shape having a width or diameter that gradually decreases in a direction toward an end of the one end of the housing 1010.

The buffer member 1150 has a conical or polygonal pyramid shape and includes a through-hole through which one end of the ferrite core 1210 and a body between one end and the other end of the core 1020 pass. An inner surface of the through-hole may have a shape corresponding to an outer surface of the one end of the ferrite core 1210 and an outer surface of the body of the core 1020. Here, the body of the core 1020 refers to a portion, which is disposed in the through-hole of the ferrite core 1210, in the core 1020 having an elongated shape in one direction.

The buffer member 1150 may be made of an elastic material such as rubber to serve as a buffer between the ferrite core 1210 and the housing 1010. This buffer member 1150 may block an electrical or magnetic effect from the outside.

The buffer member 1150 has a shape that surrounds one end of the ferrite core 1210.

A virtual tangent line L1 that contacts, in common, the tapered portion 1010t of the housing 1010 and the portion (or pen tip) disposed outside the housing in the core 102 forms a predetermined angle as illustrated in FIG. 4. Here, the predetermined angle may be less than 30°. When the predetermined angle is less than 30°, a drawing may be performed in a state in which the stylus pen according to another embodiment of the present disclosure is inclined at 60° based on a contact surface.

The inductor unit 1200 may constitute an LC resonant unit with a capacitor unit (not shown). A resonance frequency may be set by a value of inductance L of the inductor unit 1200 and a value of capacitance C of the capacitor unit (not shown). The resonance frequency may be varied according to variation in the value of the inductance L of the inductor unit 1200 and/or the value of the capacitance C of the capacitor unit (not shown).

The inductor unit 1200 includes a ferrite core 1210 and a coil 1230 wound around an outer surface of the ferrite core 1210.

The ferrite core 1210 may have an overall cylindrical, elliptical, or polygonal barrel shape, and a through-hole 1210h that passes through the inside of the ferrite core 1210 may be formed along a longitudinal direction of the ferrite core 121.

The ferrite core 1210 has the through-hole 1210h through which the body of the core 1020 passes. The body of the core 1020 may perform a linear reciprocating movement along the longitudinal direction through the through-hole 1210h.

One end of the ferrite core 1210 may have a tapered shape having a diameter or width that gradually decreases in a direction toward an end thereof. Here, as illustrated in FIG. 5, an outer surface of the one end having the tapered shape may include at least one curved portion 121c that is curved inward.

As illustrated in FIG. 5, the ferrite core 1210 may include an upper end 121a and a lower end 121b disposed below the upper end 121a. Here, the upper end 121a and the lower end 121b may be integrated with each other.

The coil 1230 may be wound around the ferrite core 1210 with at least one layer.

The coil 1230 is electrically connected to a substrate 2100. The coil 1230 may include a first connection part 1231 and a second connection part 1232, which are for being connected to the substrate 2100. The first connection part 1231 is disposed on a fixing bracket 1600 and has one end that is electrically connected to a first terminal 2131 of the substrate 2100. The second connection part 1232 is disposed on the fixing bracket 1600 and has one end that is electrically connected to a second terminal 2132 of the substrate 2100. Here, the fixing bracket 1600 may have a groove in which each of the first connection part 1231 and the second connection part 1232 is disposed. The groove may be formed along the longitudinal direction of the stylus pen 1000 on an outer surface of the fixing bracket 1600. The groove may guide the first connection part 1231 and the second connection part 1232 of the coil 1230 and protect the first connection part 1231 and the second connection part 1232 from external impacts.

FIG. 36 is a perspective view illustrating only the fixing bracket 1600 in FIG. 25, FIG. 37 is a perspective view illustrating the fixing bracket 1600 in FIG. 36 viewed from another direction, and FIG. 38 is a perspective view illustrating a portion of FIG. 35 viewed from another direction.

Referring to FIGS. 35 to 38, the fixing bracket 1600 is fixed in the housing 1010. The fixing bracket 1600 may be disposed between the inductor unit 1200 and a substrate bracket 1900 in the housing 1010. The fixing bracket 1600 may have one end coupled to the inductor unit 1200 and the other end coupled to the substrate bracket 1900.

The one end of the fixing bracket 1600 may include an insertion groove 1620 into which the other end of the ferrite core 1210 of the inductor unit 1200 is inserted. The insertion groove 1620 may be defined by a first partition wall 1611 and an inner wall 1622 of the fixing bracket 1600.

The first partition wall 1611 may contact the other end of the ferrite core 1210, and the first partition wall 1611 has a through-hole 1610 through which the core 1020 passes.

The inner wall 1622 may include a plurality of protrusions 1621 that protrude into the insertion groove 1620. The plurality of protrusions 1621 may contact an outer surface of the other end of the ferrite core 1210 to hold a position thereof.

The other end of the fixing bracket 1600 may include latch holes 1660 and 1665 into which latch parts 1960 and 1965 of the substrate bracket 1900 are inserted. At least one latch hole 1660 and 1665 may be provided. Alternatively, as illustrated in the drawing, one latch hole may be disposed above the fixing bracket 1600, and one latch hole may be disposed below the fixing bracket 1600. As the latch part 1960 of the substrate bracket 1900 is coupled to the latch hole 1660, the fixing bracket 1600 may be coupled to the substrate bracket 1900.

The other end of the fixing bracket 1600 may include a guide protrusion 1667. The guide protrusion 1667 may extend along a longitudinal direction of the fixing bracket 1600. The guide protrusion 1667 may be coupled with a guide part 1967 of the substrate bracket 1900. As the guide protrusion 1667 is coupled to the guide part 1967 of the substrate bracket 1900, the fixing bracket 1660 may be arranged along the longitudinal direction of the stylus pen 1000.

The other end of the fixing bracket 1600 may include a second partition wall 1680. The second partition wall 1680 fixes a position of an elastic member 1800 together with the substrate bracket 1900. That is, the elastic member 1800 may be fixedly mounted between the second partition wall 1680 and the substrate bracket 1900.

The fixing bracket 1600 is disposed to surround a moving bracket 1300, an elastic body 1700, and the elastic member 1800. The fixing bracket 1600 may have an inner accommodation space 1655 in which the moving bracket 1300, the elastic body 1700, and the elastic member 1800 are accommodated. The moving bracket 1300 may perform a linear reciprocating movement in the accommodation space 1655 of the fixing bracket 1600,

The fixing bracket 1600 may include two or more electrode patterns 1690. The electrode patterns 1690 may be disposed on both outer surfaces of the fixing bracket 1600, respectively. The electrode patterns 1690 may be plated on the outer surface of the fixing bracket 1600 made of a non-conductive material. For example, the electrode patterns 1690 may be formed on the outer surface of the non-conductive fixing bracket by using a laser direct structuring (LDS) and a laser manufacturing antenna (LMA).

The electrode patterns 1690 may be arranged around a guide groove 1630 of the fixing bracket 1600 and have an uneven shape or a '⊐'-shape. Each of the electrode patterns 1690 may have one end that is in contact with or spaced a predetermined distance from an electrode pattern 1390 of the moving bracket 1300 and the other end that is electrically connected to terminals 2191 and 2192 of the substrate 2100.

According to a movement of the moving bracket 1300 synchronized with a movement of the core 1020, the electrode pattern 1690 may be in contact with or spaced at a predetermined distance from the electrode pattern 1390 of the moving bracket 1300. This will be explained later with reference to another drawing.

FIG. 39 is a perspective view from which the inductor unit 1200 and the fixing bracket 1600 in FIG. 35 are removed, FIG. 40 is a perspective view of FIG. 39 viewed from another direction, and FIG. 41 is a cross-sectional view of FIG. 39.

Referring to FIGS. 34 to 39, the moving bracket 1300 is moved in synchronization with the core 1020. When one end of the core 1020 receives external force from the outside, the core 1020 is moved into the housing 1010, and the moving bracket 1300 is moved together with the core 1020.

The moving bracket 1300 accommodates the other end of the core 1020, the magnetic body 1400, and the protection member 1500. The moving bracket 1300 may include an accommodation part for accommodating the other end of the core 1020, the magnetic body 1400, and the protection member 1500.

In the accommodation part, the magnetic body 1400 and the protection member 1500 are disposed to surround the other end of the core 1020. To this end, the magnetic body 1400 may have a barrel shape with a through-hole through which the other end of the core 1020 passes, and the protection member 1500 may have a barrel shape with a through-hole through which the other end of the core 1020 passes.

The magnetic body 1400 includes a magnetic material and is moved together with the core 1020 in synchronization with the movement of the core 1020. The movement of the magnetic body 1400 changes a distance to the inductor unit 1200 fixed in the housing 1010. An inductance of the inductor unit 1200 is varied by the change in distance.

The protection member 1500 may include an elastic material and be inserted between the other end of the core 1020 and the moving bracket 1300. The protection member 1500 may protect the other end of the core 1020. Since the protection member 1500 is inserted between the other end of the core 1020 and the moving bracket 1300, the moving bracket 1300 may be synchronized with the movement of the core 1020.

As illustrated in FIG. 38, the protection member 1500 may include a protrusion 1510 that protrudes from an outer surface thereof to the outside. The protrusion 1510 may be inserted into an insertion groove 1310 defined in the moving bracket 1300. The protection member 1500 may be stably fixed to the moving bracket 1300 by the protrusion 1510 of the protection member 1500 and the insertion groove 1310 of the moving bracket 1300, and thus the other end of the core 1020 may be fixed to the moving bracket 1300.

The moving bracket 1300 may include a first protrusion 1330a and a second protrusion 1330b. The first protrusion 1330a and the second protrusion 1330b may protrude in an outward direction from the outer surface of the moving bracket 1300 or in a direction perpendicular to a longitudinal direction of the stylus pen 1000. The first protrusion 1330a and the second protrusion 1330b may be disposed in the guide hole 1630 of the fixing bracket 1600 in FIG. 35. When the moving bracket 1300 is moved in synchronization with the movement of the core 1020, the first protrusion 1330a and the second protrusion 1330b may be moved along the guide hole 1630 of the fixing bracket 1600.

The moving bracket 1300 may include a third protrusion 1350. The third protrusion part 1350 may protrude in an outward direction from the outer surface of the moving bracket 1300 or in a direction perpendicular to the longitudinal direction of the stylus pen 1000. The third protrusion 1350 may be disposed in the guide hole 1650 of the fixing bracket 1600 in FIG. 35. When the moving bracket 1300 is moved in synchronization with the movement of the core 1020, the third protrusion 1350 may be moved along the guide hole 1650 of the fixing bracket 1600.

The moving bracket 1300 may include an extension part 1370. The extension part 1370 may extend along the longitudinal direction of the stylus pen 1000 from the outer surface of the moving bracket 1300. Alternatively, the extension part 1370 may extend along the longitudinal direction of the core 1020 from the outer surface of the moving bracket 1300. The extension part 1370 may have a structure and a shape to be disposed in the elastic member 1700. An extension part 1870 of the elastic member 1800 may be disposed on an end of the extension part 1370.

The moving bracket 1300 may include an electrode pattern 1390. The electrode pattern 1390 may be disposed on the outer surface of the moving bracket 1300, on which the extension part 1370 is formed, among the outer surfaces of the moving bracket and on the first and second protrusions 1330a and 1330b.

The electrode pattern 1390 may be in contact with and electrically connected to the elastic body 1700 surrounding the extension part 1370 of the moving bracket 1300. The electrode pattern 1390 may be in contact with and electrically connected to the electrode pattern 1690 of the fixing bracket 1600 in FIG. 35, and detached and electrically disconnected from the electrode pattern 1690 of the fixing bracket 1600 by the movement of the core 1020.

The electrode pattern 1390 may be plated on the outer surface of the moving bracket 1300 made of non-conductive material. For example, the electrode pattern 1390 may be formed on the outer surface of the moving bracket 1300 by using a laser direct structuring (LDS) and a laser manufacturing antenna (LMA).

The electrode pattern 1390 may include a base electrode pattern 1391 and first and second extension patterns 1393a and 1393b.

The base electrode pattern 1391 may be disposed on the outer surface of the moving bracket 1300 and arranged to surround the extension part 1370 of the moving bracket 1300. The base electrode pattern 1391 contacts one end of the elastic member 1700.

The first and second extension patterns 1393a and 1393b may extend respectively from both sides of the first electrode pattern 1391, the first extension pattern 1393a may be disposed on the first protrusion 1330a, and the second extension pattern 1393b may be disposed on the second protrusion 1330b. The first and second extension patterns 1393a and 1393b may contact the electrode pattern 1690 of the fixing bracket 1600 in FIG. 35 or may be separated therefrom by a movement of the core 1020.

The elastic body 1700 may be made of a conductive material and have a spring shape. The elastic body 1700 may be disposed between the moving bracket 1300 and the elastic member 1800. Here, the elastic body 1700 may be inserted between the moving bracket 1300 and the elastic member 1800 in a partially pressed state instead of being completely pressed. When the external force applied to the moving bracket 1300 synchronized with the movement of the core 1020 is less than elastic force of pushing outward from the partially pressed elastic body 1700, the elastic member 1700 is not pressed. When the external force is greater than the elastic force, the elastic body 1700 is initiated to be pressed.

In the elastic body 1700, the extension part 1370 of the moving bracket 1300 and the extension part 1870 of the elastic member 1800 may be disposed together. Through this, there is an advantage in that an inner volume of the stylus pen 1000 may be reduced because an inner space of the elastic body 1700 is usable.

The elastic body 1700 has one end electrically connected to the electrode pattern 1390 of the moving bracket 1300 and the other end electrically connected to the terminal 2110 of the substrate 2100. The elastic body 1700 may include a connecting wire 1710 that connects the elastic body 1700 and the terminal 2110 of the substrate 2100. The connecting wire 1710 may have one end connected to the elastic body 1700 and the other end connected to the terminal 2110 of the substrate 2100. Each of the elastic member 1800 and the substrate bracket 1900 may have a guide groove in which the connecting wire 1710 is disposed in order to protect and guide the connecting wire 1710.

The elastic member 1800 is made of a non-conductive material and has a predetermined elasticity. For example, the elastic member 1800 may be made of rubber.

The elastic member 1800 may be disposed between the moving bracket 1300 and the substrate bracket 1900.

FIG. 42 is perspective views illustrating only the elastic member 1800 in FIG. 39, and FIG. 43 is a perspective view illustrating the substrate bracket 1900 and the substrate 2100 in FIG. 39.

Referring to FIGS. 36 to 43, the elastic member 1800 may include an extension part 1870. The extension part 1870 may extend in a direction from an outer surface of the elastic member 1800 to the moving bracket 1300. The extension part 1870 may be disposed in the elastic body 1700.

The elastic member 1800 may include a guide groove 1810. The guide groove 1810 may be formed along the longitudinal direction of the stylus pen 1000 on the outer surface of the elastic member 1800. An extension line 1710 of the elastic body 1700 may be disposed in the guide groove 1810.

The elastic member 1800 may include a mounting groove 1850. The mounting groove 1850 is defined in the outer surface of the elastic member 1800. The mounting groove 1850 may be disposed at a side opposed to the extension part 1870. A mounting part 1910 of the substrate bracket 1900 may be inserted into the mounting groove 1850. A latch groove 1851 having a shape corresponding to a protrusion 1915 of the mounting part 1910 of the substrate bracket 1900 may be formed in the mounting groove 1850. Through this, the elastic member 1800 may be stably fixed and mounted to the substrate bracket 1900.

The substrate bracket 1900 supports the substrate 2100 in the housing 1010 and is coupled with the elastic member 1800 to support the elastic member 1800.

The substrate bracket 1900 may include a side part 1940 that guides and supports a side portion of the substrate 2100.

The substrate bracket 1900 may include a mounting part 1910 for being coupled with the elastic member 1800. The mounting part 1910 protrudes in a direction from the substrate bracket 1900 to the moving bracket 1300. The mounting part 1910 may include a protrusion 1915 that protrudes from an outer surface thereof. The protrusion 1915 may protrude in a direction perpendicular to a direction in which the mounting part 1910 protrudes.

The substrate bracket 1900 may include a guide groove 1920. The guide groove 1920 may guide and protect the connecting wire 1710 of the elastic member 1700.

The substrate 2100 is disposed on the substrate bracket 1900.

The substrate 2100 may include a plurality of terminals 2110, 2131, 2132, 2191, and 2192. Among the plurality of terminals 2110, 2131, 2132, the terminal 2110 is electrically connected to the elastic body 1700, and first and second terminals 2131 and 2132 are electrically connected to the coil 1230 of the inductor unit 1200. Third and fourth terminals 2191 and 2192 are electrically connected to electrode patterns 1690 disposed on both outer surfaces of the fixed bracket 1600, respectively.

The substrate 2100 includes a capacitor unit (not shown). One or more capacitors that constitute the capacitor unit (not shown) may be arranged on the substrate 2100.

The substrate 2100 may include a circuit pattern that electrically connects the one or more capacitors of the capacitor unit (not shown) and the plurality of terminals 2110, 2131, and 2132.

FIG. 44 is a view for explaining a movement of a moving bracket 1300 according to a movement of a core body 1020 in FIGS. 35 to 43, and an electrical contact and disconnection between the fixing bracket 1600 and the moving bracket 1300.

(A) of FIG. 44 illustrates a case when any external force is not applied to the core 1020, and (B) of FIG. 44 illustrates a case when predetermined external force is applied to the core 1020 to move the moving bracket 1300 in one direction.

First, referring to A in FIG. 44, when any external force is not applied to the core 1020, the electrode pattern 1390 of the moving bracket 1300 contacts the electrode pattern 1690 of the fixing bracket 1600. That is, the electrode pattern 1390 of the moving bracket 1300 and the electrode pattern 1690 of the fixing bracket 1600 are electrically connected to each other.

As the second protrusion 1330b of the moving bracket 1300 is pushed toward the core 1020 by the elastic body 1700, a state in which the electrode pattern 1390 disposed on an outer surface of the second protrusion 1330b is in contact with the electrode pattern 1690 of the fixing bracket 1600 may be maintained.

Referring to B in FIG. 44, when predetermined force is applied to the core 1020 to move the core 1020 in one direction, the moving bracket 1300 is moved together with the core 1020 in the one direction. As the moving bracket 1300 is moved in the one direction, the second protrusion 1330b is also moved in the one direction. As the second protrusion 1330b is moved, a contact between the electrode pattern 1390 of the moving bracket 1300 and the electrode pattern 1690 of the fixing bracket 1600 is released. Likewise, as the first protrusion 1330a disposed at a side opposed to the second protrusion 1330b is also moved, the contact between the electrode pattern 1390 of the moving bracket 1300 and the electrode pattern 1690 of the fixing bracket 1600 is released. Also, as the moving bracket 1300 is moved, the elastic body 1700 is pressed.

As illustrated in B in FIG. 44, when predetermined force is applied to the core 1020 to move the core 1020 in one direction, a contact between the electrode pattern 1390 of the moving bracket 1300 and the electrode pattern 1690 of the fixing bracket 1600 is released. The release of the contact causes an abrupt change in capacitance of the capacitor unit (not shown) mounted to the substrate 2100. The abrupt change of the capacitance changes a frequency of a pen signal emitted from the stylus pen 1000. A receiving side that receives the pen signal may detect the changed frequency to determine whether the stylus pen 1000 is brought into contact with a screen.

FIG. 45 is a view illustrating each of A and B in FIG. 44, and FIG. 46 is a view simplifying a stylus pen according to another embodiment of the present disclosure and showing equivalent circuit diagrams of A and B in FIG. 44.

Referring to FIGS. 45A and 45B and A and B in FIG. 46, a plurality of capacitors C1, C2, C3, and Cs are arranged on the substrate 2100. The capacitors C1, C2, C3, and Cs may form a capacitor unit (not shown). At least one or more capacitors C1, C2, and C3 of the plurality of capacitors C1, C2, C3, and Cs are connected in parallel to maintain a constant capacitance value, and an auxiliary capacitor Cs is connected in parallel to the basic capacitor according to the contact or release between the electrode pattern 1690 of the fixing bracket 1600 and the electrode pattern 1390 of the moving bracket 1300 as illustrated in FIG. 44.

First, as illustrated in FIG. 45A and A in FIG. 46, since the electrode pattern 1690 of the fixing bracket 1600 and the electrode pattern 1390 of the moving bracket 1300 are in contact with each other in a state in which external force is not applied to the core 1020, an auxiliary capacitor Cs is connected in parallel with the basic capacitors C1, C2, and C3. Thus, a capacitance of the capacitor unit (not shown) is a sum of capacitance values of the basic capacitors C1, C2, and C3 and the auxiliary capacitor Cs.

Thereafter, as illustrated in FIG. 45B and B in FIG. 46, when predetermined external force is applied to the core 1020,

the electrode pattern 1390 of the moving bracket 1300 is released from the electrode pattern 1690 of the fixing bracket 1600 by the movement of the moving bracket 1300 synchronized with the movement of the core 1020. Thus, the auxiliary capacitor Cs is not electrically connected to the basic capacitors C1, C2, and C3, and the capacitance of the capacitor unit (not shown) is changed to a capacitance value of the basic capacitors C1, C2, and C3.

In particular, referring to B in FIG. 46, it may be known that the electrode pattern 1390 of the moving bracket 1300 is in contact with the electrode pattern 1690 of the fixing bracket 1600 at two points. As illustrated in FIGS. 39 and 40, it may be understood that the fixing bracket 1600 has two electrode patterns 1690, and the first and second extension patterns 1393a and 1393b are arranged on the first and second protrusions 1330a and 1330b of the moving bracket 1300.

When the external force applied to the core 1020 is insufficient to separate both the first and second extension patterns 1393a and 1393b from two electrode patterns 1690 of the fixing bracket 1600, i.e., when the first extension pattern 1393a is separated from one electrode pattern 1690 of the fixing bracket 1600 while the second extension pattern 1393b is not separated from the other electrode pattern 1690 of the fixing bracket 1600, the auxiliary capacitor Cs remains connected in parallel with the basic capacitors C1, C2, and C3.

On the other hand, only when the external force applied to the core 1020 is sufficient to completely separate both the first and second extension patterns 1393a and 1393b from the two electrode patterns 1690 of the fixing bracket 1600, the auxiliary capacitor Cs is electrically disconnected from the basic capacitors C1, C2, and C3. Thus, when the stylus pen 1000 according to another embodiment of the present disclosure is used, there is an advantage in that a clear distinguishment between the hover state and the contact state may be obtained by clearly setting a reference pressure for distinguishing the hover state and the contact state. In particular, since the stylus pen 1000 according to another embodiment of the present disclosure may still maintain the contact state between another extension pattern and another electrode pattern although one extension pattern of the first and second extension patterns 1393a and 1393b is not in contact with one of the two electrode patterns 1690 of the fixing bracket 1600 due to a limitation in manufacturing process while manufacturing the stylus pen or carelessness of a user while using the stylus pen.

FIG. 47 is a perspective view illustrating the stylus pen 1000 in FIG. 33 according to another embodiment of the present disclosure viewed from the core 1020,

FIG. 48A is a partial cross-sectional view taken along line A-A' of the stylus pen 1000 in FIG. 47, FIG. 48B is a partial cross-sectional view taken along line B-B' of the stylus pen 1000 in FIG. 47, and FIG. 49 is a view illustrating cross-sectional views and side views (A and B) of the ferrite core 1210 in FIG. 47 and FIGS. 48A and 48B.

Referring to FIGS. 35 and 47 to 49, the housing 1010 of the stylus pen 1000 has a rectangular container shape having rounded corners, and an exposed portion of the core 1020 in the housing 1010 has a width that gradually decreases in an outward direction.

Components disposed in the housing 1010 have shapes corresponding to the shape of the housing 1010 according to an outer shape of the housing 1010. Among the inner components, the ferrite core 1210 of the inductor unit 1200 also has an optimized structure corresponding to the outer shape of the housing 1010.

As illustrated in FIG. 48A and 48B, in the ferrite core 1210, a first cross-sectional shape taken along a first vertical direction (A-A' direction in FIG. 47) perpendicular to an axial direction X (or the longitudinal direction of the stylus pen 1000) of the ferrite core 1210 is different from a second cross-section shape taken along a second vertical direction (B-B' direction in FIG. 47). Specifically, a thickness w1 of the ferrite core 1210 in the first vertical direction is different from a thickness w2 in the second vertical direction. More specifically, the thickness w1 in the first vertical direction is less than the thickness w2 in the second vertical direction. Here, the thickness w1 in the first vertical direction is defined as a minimum distance from the through-hole 1210h of the ferrite core 1210 to the outer surface of the ferrite core 1210 in the first cross-sectional shape, and the thickness w2 in the second vertical direction is defined as a minimum distance from the through-hole 1210h of the ferrite core 1210 to the outer surface of the ferrite core 1210 in the second cross-sectional shape. Alternatively, unlike as illustrated in the drawing, the thickness w1 in the first vertical direction may be a total thickness of the ferrite core 1210 in the first cross-sectional shape, and the thickness w2 in the second vertical direction may be a total thickness of the ferrite core 1210 in the second cross-sectional shape.

The ferrite core 1210 has a container or cylinder shape. A flat portion 1210d may be disposed on at least a portion of the outer surface of the ferrite core 1210. A flat portion corresponding to the flat portion 1210d may be disposed on another portion of the outer surface of the ferrite core 1210. The ferrite core 1210 may be stably disposed in the housing 1010 by the flat portion 1210d. The flat portion 1210d extends from one end to the other end of the ferrite core 1210 along the axial direction X of the ferrite core 1210.

One end of the ferrite core 1210 may include at least two curved portions 1210c. At least a portion of the curved portion 1210c may be shown in the second cross-sectional shape, but may not be shown in the first cross-sectional shape. The curved portion 1210c may be curved from one side surface of one end of the ferrite core 1210 to a portion adjacent to the through-hole 1210h of the ferrite core 1210 in a direction toward the through-hole 1210h. The curved portion 1210c may be disposed on each of both sides opposed to each other at one end of the ferrite core 1210 based on the through-hole 1210h.

As illustrated in ①, ②, and ③ of FIG. 49, the curved portion 1210c is changed in shape from an aspherical shape to a spherical shape along the axial direction X of the ferrite core 1210. ③ of FIG. 49 shows the curved portion 1210c having an aspherical shape, and ① of FIG. 49 shows the curved portion 1210c having a spherical shape. Also, ② of FIG. 49 shows the curved portion 1210c having an intermediate shape between the aspherical shape and the spherical shape.

At one end of the ferrite core 1210, the flat portion 1210d has a shape having a width that gradually decreases along the axial direction X of the ferrite core 1210. Here, the width of the flat portion 1210d may decrease non-linearly.

As described in FIGS. 6 to 8, when the above-described ferrite core 1210 is used, the inductor unit 1200 including the ferrite core 1210 may be disposed closer to a tip of the stylus pen 1000 in the stylus pen 1000. Thus, since the inductor unit 1200 may be moved relatively closer to the receiver (not shown), the pen signal received by the receiver may increase.

On the other hand, the ferrite core 1210 in FIGS. 47 to 49 may be applied to the stylus pen in FIG. 3 or 22. Furthermore, the ferrite core of the stylus pen in FIG. 3 or 22 may be applied to the stylus pen in FIG. 33.

Overall configuration of stylus pen having waterproof function

A stylus pen 100 according to an embodiment of the present disclosure may include a housing 101, a core 102, an inductor unit 120, a capacitor unit (not shown), a first fixing member 130, and sealing members 200a, 200a', and 200b. A detailed description on the housing 101, the core 102, the inductor unit 120, the capacitor unit (not shown), and the first fixing member 130 is the same as that described above.

A stylus pen 1000 according to another embodiment of the present disclosure may include a housing 1010, a core 1020, an inductor unit 1200, a capacitor unit (not shown), a fixing bracket 1600, and sealing members 2000a, 2000a', and 2000b. A detailed description on the housing 1010, core 1020, the inductor unit 1200, the capacitor unit (not shown), and the fixing bracket 1600 is the same as that described above.

On the other hand, the sealing member 200a, 200a', 200b of the stylus pen 100 according to an embodiment of the present disclosure and the sealing member 2000a, 2000a', and 2000b of the stylus pen 1000 according to another embodiment may be made of synthetic rubber or thermoplastic elastomer (TPE). For example, the synthetic rubber may include nitrile butadiene rubber (NBR), fluoroelastomer (FKM), ethylene propylene diene monomer (EPDM), or silicone rubber. However, the embodiment of the present disclosure is not limited thereto.

Hereinafter, the sealing member 200a, 200a', and 200b of the stylus pen 100 according to an embodiment of the present disclosure and the sealing member 2000a, 2000a', and 2000b of the stylus pen 1000 according to another embodiment will be described in detail with reference to the accompanying drawings.

Moisture ingress path

FIGS. 50A and 50B are views illustrating a first moisture ingress path and a second moisture ingress path in which moisture enters into the stylus pen in FIG. 9 through a core opening of the housing. FIGS. 50C and 50D are views illustrating a first moisture ingress path and a second moisture ingress path in which moisture enters into the stylus pen in FIG. 34 through a core opening of the housing.

As illustrated in FIGS. 50A and 50B, moisture may enter into the stylus pen 100 in FIG. 9 through a core opening (not shown) of the housing 101.

Here, the core opening (not shown) may refer to a gap between the housing 101 and the core 102.

Specifically, as illustrated in FIG. 50A, moisture may enter into the stylus pen 100 through the first moisture ingress path P1, in which moisture enters into the stylus pen 100 through the core opening (not shown) of the housing 101 and the space between the housing 101 and the inductor unit 120. Alternatively, as illustrated in FIG. 50B, moisture may enter into the stylus pen 100 through a second moisture ingress path P2, in which moisture enters into the stylus pen 100 through a core opening (not shown) of the housing 101 and a through-hole of a ferrite core 121.

As illustrated in FIGS. 50C and 50D, moisture may also enter into the stylus pen 1000 in FIG. 34 through a core opening (not shown) of the housing 1010. Specifically, as illustrated in FIG. 50C, moisture may enter into the stylus pen 1000 through a first moisture ingress path P1', in which moisture enters into the stylus pen 1000 through a core opening (not shown) of the housing 1010 and a space between the housing 1010 and the inductor unit 1200. Alternatively, as illustrated in FIG. 50D, moisture may enter into the stylus pen 1000 through a second moisture ingress path P2', in which moisture enters into the stylus pen 1000 through a core opening (not shown) of the housing 1010 and a through-hole of a ferrite core 1210.

Stylus pen including sealing member capable of blocking a plurality of moisture ingress paths

The stylus pen 100 illustrated in FIG. 9 may include a plurality of sealing members 200a, 200a', and 200b capable of blocking a plurality of moisture ingress paths P1 and P2 passing through a core opening (not shown) of the housing 101. Specifically, the plurality of moisture ingress paths P1 and P2 may include a first moisture ingress path P1 and a second moisture ingress path P2. More specifically, the plurality of sealing members 200a, 200a', and 200b may include a first sealing member 200a and 200a' capable of blocking the first moisture ingress path P1 and a second sealing member 200b capable of blocking the second moisture ingress path P2.

The stylus pen 1000 illustrated in FIG. 34 may include a plurality of sealing members 2000a, 2000a', and 2000b capable of blocking a plurality of moisture ingress paths P1' and P2' passing through a core opening (not shown) of the housing 1010. Specifically, the plurality of moisture ingress paths P1' and P2' may include a first moisture ingress path P1' and a second moisture ingress path P2'. More specifically, the plurality of sealing members 2000a, 2000a', and 2000b may include a first sealing member 2000a and 2000a' capable of blocking the first moisture ingress path P1', and a second sealing member 2000b capable of blocking the second moisture ingress path P2'.

**Arrangement of first sealing member**

FIGS. 51A and 51B is a view illustrating an embodiment of a sealing member for blocking the first moisture ingress path in the stylus pen in FIGS. 50A and 50B. FIGS. 51C and 51D is a view illustrating an embodiment of a sealing member for blocking the first moisture ingress path in the stylus pen in FIGS. 50C and 50D. FIGS. 52A and 52B is a view illustrating another embodiment of the sealing member for blocking the first moisture ingress path in the stylus pen in FIGS. 50A and 50B. FIGS. 52C and 52D is a view illustrating another embodiment of the sealing member for blocking the first moisture ingress path in the stylus pen in FIGS. 50C and 50D.

Arrangement that surrounds outer surface of ferrite core

FIG. 51A is a view illustrating an embodiment of the first sealing member 200a that surrounds an outer surface of the ferrite core 121 of the stylus pen 100 in FIGS. 50A and 50B. FIG. 51B is a cross-sectional view obtained by cutting the stylus pen 100 along line A-A' in FIG. 51A.

As illustrated in FIGS. 51A and 51B, the first sealing member 200a may surround at least a portion of the outer surface of the ferrite core 121. Also, the first sealing member 200a may be in close contact with an inner wall of the housing 101. Accordingly, the first sealing member 200a may prevent moisture from entering through the first moisture ingress path P1.

As described above, the stylus pen 100 in FIGS. 50A and 50B may further include an inner case 110 disposed in the housing 101. When the stylus pen 100 further includes the inner case 110, the first sealing member 200a may be in close contact with an inner wall of the inner case 110.

FIG. 51C is a view illustrating an embodiment of the first sealing member 2000a that surrounds an outer surface of the ferrite core 1210 of the stylus pen 1000 in FIGS. 50C and 50D.

FIG. 51D is a cross-sectional view obtained by cutting the stylus pen 1000 along line B-B' in FIG. 51C.

As illustrated in FIGS. 51C and 51D, the first sealing member 2000a may surround at least a portion of the outer surface of the ferrite core 1210. Also, the first sealing member 2000a may be in close contact with an inner wall of the housing 1010. Accordingly, the first sealing member 2000a may prevent moisture from entering through the first moisture ingress path P1'.

Arrangement that surrounds outer surface of fixing bracket (or first fixing member)

FIG. 52A is a view illustrating an embodiment of a first sealing member 200a' that surrounds an outer surface of the first fixing member 130 of the stylus pen 100 in FIGS. 50A and 50B. FIG. 52B is a cross-sectional view taken along line C-C' of the stylus pen 100 in FIG. 52A according to an embodiment of the present disclosure.

As illustrated in FIGS. 52A and 52B, the first sealing member 200a' may surround at least a portion of the outer surface of the first fixing member 130. Also, the first sealing member 200a' may be in close contact with the inner wall of the housing 101. Accordingly, the first sealing member 200a' may prevent moisture from entering through the first moisture ingress path P1.

As described above, the stylus pen 100 in FIGS. 50A and 50B may further include an inner case 110 disposed in the housing 101. When the stylus pen 100 further includes the inner case 110, the first sealing member 200a' may be in close contact with the inner wall of the inner case 110.

FIG. 52C is a view illustrating an embodiment of the first sealing member 2000a' that surrounds an outer surface of the fixing bracket 1600 of the stylus pen 1000 in FIGS. 50C and 50D. FIG. 52D is a cross-sectional view obtained by cutting the stylus pen 1000 along line D-D' in FIG. 52C.

As illustrated in FIGS. 52C and 52D, the first sealing member 2000a' may surround at least a portion of the outer surface of the fixing bracket 1600. Also, the first sealing member 2000a' may be in close contact with the inner wall of the housing 1010. Accordingly, the first sealing member 2000a' may prevent moisture from entering through the first moisture ingress path P1'.

**Arrangement of second sealing member**

FIGS. 53A and 53B are views illustrating a sealing member for blocking the second moisture ingress path in the stylus pen in FIGS. 50A and 50B. FIGS. 53C and 53D are views illustrating a sealing member for blocking the second moisture ingress path in the stylus pen shown in FIGS. 50C and 50D.

FIG. 53A is a view illustrating an embodiment of a second sealing member 200b disposed on a partition wall 132 of the first fixing member 130 in the stylus pen 100 in FIGS. 50A and 50B. FIG. 53B is a perspective view illustrating a coupling relationship between the first fixing member 130 and the second sealing member 200b.

As illustrated in FIGS. 53A and 53B, the second sealing member 200b may be disposed on the partition wall 132 so that the core fills an outer portion of a through-hole 132h of the partition wall 132. Also, the second sealing member 200b may be in close contact with the core 102 at a portion at which the core 102 passes through the through-hole 132h of the partition wall 132. Accordingly, the second sealing member 200b may prevent moisture from entering through the second moisture ingress path P2. On the other hand, a detailed description on the first fixing member 130, the partition wall 132, and the through-hole 132h is the same as that described above.

FIG. 53C is a view illustrating an embodiment of a second sealing member 2000b disposed on a partition wall 1611 of the fixing bracket 1600 in the stylus pen 1000 in FIGS. 50C and 50D. FIG. 53D is a perspective view illustrating a coupling relationship between the fixing bracket 1600 and the second sealing member 2000b.

As illustrated in FIGS. 53C and 53D, the second sealing member 2000b may be disposed on the partition wall 1611 so that the core 1020 fills an outer portion of a through-hole 1610 of the partition wall 1611. Also, the second sealing member 2000b may be disposed in close contact with the core 1020 at a portion at which the core 1020 passes through the through-hole 1610 of the partition wall 1611. Accordingly, the second sealing member 2000b may prevent moisture from entering through the second moisture ingress path P2'. On the other hand, a detailed description on the fixing bracket 1600, the partition wall 1611, and the through-hole 1610 is the same as that described above.

**Stylus pen including first and second sealing members**

FIGS. 54A and 54B are views illustrating a state in which a first sealing member and a second sealing member is added to each of the stylus pens in FIGS. 50A to 50D.

As illustrated in FIG. 54A, the stylus pen 100 in FIGS. 50A and 50B may include a plurality of sealing members 200a, 200a', and 200b capable of blocking a plurality of moisture ingress paths P1 and P2 passing through a core opening (not shown) of the housing 101. Specifically, the plurality of moisture ingress paths P1 and P2 may include a first moisture ingress path P1 and a second moisture ingress path P2. More specifically, the plurality of sealing members 200a, 200a', and 200b may include a first sealing member 200a and 200a' capable of blocking the first moisture ingress path P1 and a second sealing member 200b capable of blocking the second moisture ingress path P2. That is, the stylus pen 100 may block both the first moisture ingress path P1 and the second moisture ingress path P2 by the first sealing member 200a and 200a' and the second sealing member 200b.

As illustrated in FIG. 54B, the stylus pen 1000 in FIGS. 50C and 50D may include a plurality of sealing members 2000a, 2000a', and 2000b capable of blocking a plurality of moisture ingress paths P1' and P2' passing through a core opening (not shown) of the housing 1010. Specifically, the plurality of moisture ingress paths P1' and P2' may include a first moisture ingress path P1' and a second moisture ingress path P2'. More specifically, the plurality of sealing members 2000a, 2000a', and 2000b may include a first sealing member 2000a and 2000a' capable of blocking the first moisture ingress path P1' and a second sealing member 2000b capable of blocking the second moisture ingress path P2'. That is, the stylus pen 1000 may block both the first moisture ingress path P1'

and the second moisture ingress path P2' by the first sealing member 2000a and 2000a' and the second sealing member 2000b.

Stylus pen including sealing member having contact part

FIGS. 55A and 55B are views illustrating a modified example of the sealing member in FIGS. 53A to 53D.

As described above, the second sealing member 200b in FIGS. 53A and 53B may be disposed on the partition wall 132 so that the core 102 fills an outer portion of a through-hole 132h of the partition wall 132, which passes through the partition wall 132 of the first fixing member 130. Also, the second sealing member 200b may be in close contact with the core 102 at a portion at which the core 102 passes through the through-hole 132h of the partition wall 132. Accordingly, the second sealing member 200b may prevent moisture from entering through the second moisture ingress path P2. On the other hand, a detailed description on the first fixing member 130, the partition wall 132, and the through-hole 132h is the same as that described above.

As described above, the second sealing member 2000b in FIGS. 53C and 53D may be disposed on the partition wall 1611 so that the core 1020 fills an outer portion of a through-hole 1610 of the partition wall 1611, which passes through the partition wall 1611 of the fixing bracket 1600. Also, the second sealing member 2000b may be in close contact with the core 1020 at a portion at which the core 1020 passes through the through-hole 1610 of the partition wall 1611. Accordingly, the second sealing member 2000b may prevent moisture from entering through the second moisture ingress path P2'. On the other hand, a detailed description on the fixing bracket 1600, the partition wall 1611, and the through-hole 1610 is the same as that described above.

On the other hand, as illustrated in FIG. 55A, the second sealing member 200b of the stylus pen 100 in FIGS. 50A and 50B may include a sealing member body 203 and a contact part 201. Specifically, the sealing member body 203 may be disposed on the partition wall 132 to fill an outer portion of the through-hole 132h of the partition wall 132. More specifically, the contact part 201 may have a cylindrical shape with a height extending in a longitudinal direction of the core 102, and the second sealing member 200b may be in close contact with the core 102 at the contact part 201. Accordingly, the contact part 201 may maintain a close contact state with at least a portion of the core 102 when the core 102 is moved in the longitudinal direction of the core 102. That is, when the core 102 is moved in the longitudinal direction, the second sealing member 200b may prevent moisture entered through the second moisture ingress path P2 from passing through the through-hole 132h defined in the partition wall 132 of the first fixing member 130 by the contact part 201.

Also, as illustrated in FIG. 55B, the second sealing member 2000b of the stylus pen 1000 in FIGS. 50C and 50D may include a sealing member body 2003 and a contact part 2001. Specifically, the sealing member body 2003 may be disposed on the partition wall 1611 to fill an outer portion of the through-hole 1610 of the partition wall 1611. More specifically, the contact part 2001 may have a cylindrical shape with a height extending in the longitudinal direction of the core 1020, and the second sealing member 2000b may be in close contact with the core 1020 at the contact part 2001. Accordingly, the contact part 2001 may maintain a close contact state with at least a portion of the core 1020 when the core 1020 is moved in the longitudinal direction of the core 1020. That is, when the core 1020 is moved in the longitudinal direction, the second sealing member 2000b may prevent moisture entered through the second moisture ingress path P2' from passing through the through-hole 1610 defined in the partition wall 1611 of the fixing bracket 1600 by the contact part 2001.

Stylus pen including buffer member

Referring to FIGS. 9, 51A, 51B, 52A and 52B, the stylus pen 100 in FIGS. 50A and 50B may include a housing 101, a core 102, an inductor unit 120, a capacitor unit (not shown), a first fixing member 130, a buffer member 115, and a first sealing member 200a and 200a'. A detailed description on the housing 101, the core 102, the inductor unit 120, the capacitor unit (not shown), the first fixing member 130, and the first sealing member 200a and 200a' is the same as that described above.

Specifically, the stylus pen 100 in FIGS. 50A and 50B may further include a buffer member 115 disposed between an inner surface of the housing 101 and the other end of the ferrite core 121. Here, the buffer member 115 may surround at least a portion of the other end of the ferrite core 121. Also, the buffer member 115 may be in close contact with the housing 101 and the other end of the ferrite core 121. Accordingly, the buffer member 115 may block a path in which moisture enters into the stylus pen 1000 through a core opening (not shown) of the housing 101.

As illustrated in FIGS. 4 to 7, the other end of the ferrite core 121 may have a taper shape having a diameter or a width that gradually decreases in a direction toward an end thereof. Also, the other end of the ferrite core 121 may include at least one curved portion 121c having an outer surface that is curved inwardly. The other end of the ferrite core 121 when the other end of the ferrite core 121 includes the curved portion 121c may have a thickness less than that of the other end of the ferrite core 121 when the other end does not include the curved portion 121c.

Referring to FIGS. 34, 51C, 51D, 52C and 52D, the stylus pen 1000 may include a housing 1010, a core 1020, an inductor unit 1200, a capacitor unit (not shown), a fixing bracket 1600, a buffer member 1150, and a first sealing member 2000a and 2000a'. A detailed description on the housing 1010, the core 1020, the inductor unit 1200, the capacitor unit (not shown), the fixing bracket 1600, and the first sealing member 2000a and 2000a' is the same as that described above.

Specifically, the stylus pen 1000 in FIGS. 50C and 50D may include a buffer member 1150 disposed between the inner surface of the housing 1010 and the other end of the ferrite core 1210. Here, the buffer member 1150 may surround at least a portion of the other end of the ferrite core 1210. Also, the buffer member 1150 may be in close contact with the housing 1010 and the other end of the ferrite core 1210. Accordingly, the buffer member 1150 may block a path in which moisture enters into the stylus pen 1000 through the core opening (not shown) of the housing 1010.

As illustrated in FIGS. 4 to 7, the other end of the ferrite core 1210 may have a taper shape having a diameter or a width that gradually decreases in a direction toward an end thereof. Also, the other end of the ferrite core 1210 may include at least one curved portion 121c having an outer surface that is curved inwardly. The other end of the ferrite core 121 when the other end of the ferrite core 121 includes the curved portion 121c may have a thickness less than that of the other end of the ferrite core 121 when the other end does not include the curved portion 121c.

Third sealing member

FIGS. 56A and 56B are views illustrating another embodiment of the sealing member for blocking the first moisture ingress path in the stylus pen in FIGS. 50C and 50D. Specifically, FIG. 56A is a partial perspective view illustrating a stylus pen including a third sealing member. Also, FIG. 56B is a partial cross-sectional view obtained by cutting FIG. 56A along line C-C' in FIG. 56A.

As illustrated in FIGS. 56A and 56B, the stylus pen 1000 may include a third sealing member 2000c capable of blocking the first moisture ingress path P1' in FIGS. 50C and 50D, which passes through a core opening (not shown) of the housing 1010.

As illustrated in FIG. 56A, the third sealing member 2000c may surround at least a portion of an outer surface of the ferrite core 1210. Specifically, the third sealing member 2000c may surround at least a portion of the outer surface of the ferrite core 1210 around the core opening (not shown). Although the third sealing member 2000c may be in contact with the coil 1230, the embodiment of the present disclosure is not limited thereto.

As illustrated in FIG. 56B, the third sealing member 2000c may be in close contact with the inner wall of the housing 1010. Thus, the third sealing member 2000c may prevent moisture from entering through the first moisture ingress path P1' in FIGS. 50C and 50D.

Buffer member and fourth sealing member

FIGS. 57A and 57B are views illustrating an embodiment of the buffer member for blocking the first moisture ingress path and the second moisture ingress path in the stylus pen in FIGS. 50C and 50D. Specifically, FIG. 57A is a partial perspective view illustrating the stylus pen including the buffer member. Also, FIG. 57B is a partial cross-sectional view obtained by cutting FIG. 57A along line D-D' of FIG. 57A.

As illustrated in FIGS. 57A and 57B, the stylus pen 1000 may include a buffer member 1150. Specifically, the buffer member 1150 may surround at least a portion of an outer surface of each of the core 1020 and the ferrite core 1210 around the core opening (not shown). More specifically, the buffer member 1150 may include a predetermined hole (not shown). The buffer member 1150 may accommodate the core 1020 and the ferrite core 1210 through the predetermined hole (not shown).

As illustrated in FIG. 57A, the buffer member 1150 may include a fourth sealing member 2000d. Although the fourth sealing member 2000d may have a ring shape, the embodiment of the present disclosure is not limited thereto. The fourth sealing member 2000d may be coupled to one end disposed at the core opening (not shown) of the buffer member 1150.

More specifically, the fourth sealing member 2000d may block the first moisture ingress path P1' in FIGS. 50C and 50D. As illustrated in FIG. 57B, an outer portion 2000d-1 of the fourth sealing member 2000d may be in close contact with the inner wall of the housing 1010. Thus, the fourth sealing member 2000d may prevent moisture from entering through the first moisture ingress path P1'.

Alternatively, the fourth sealing member 2000d may block the second moisture ingress path P2' in FIGS. 50C and 50D. As illustrated in FIG. 57B, an inner portion 2000d'-2 of the fourth sealing member 2000d may be in close contact with the core 1020 and/or the ferrite core 1210. Thus, the fourth sealing member 2000d may prevent moisture from entering through the second moisture ingress path P2'. However, the embodiment of the present disclosure is not limited thereto. For example, the fourth sealing member 2000d may include the fourth sealing member 2000d having the inner portion 2000d'-2 that is spaced a predetermined distance from the core 1020 and/or the ferrite core 1210.

According to an embodiment of the present disclosure, the fourth sealing member 2000d may be coupled to one end of the buffer member 1150 as a separate component. Alternatively, the fourth sealing member 2000d may be coupled to one end of the buffer member 1150 and integrated with the buffer member 1150. However, the embodiment of the present disclosure is not limited thereto.

According to an embodiment of the present disclosure, the fourth sealing member 2000d may be formed at one end of the buffer member 1150 through a predetermined process. For example, the fourth sealing member 2000d may be formed through at least one process selected from the group consisting of a taping process and a coating process. However, the embodiment of the present disclosure is not limited thereto.

Third sealing member, buffer member, and fourth sealing member

FIG. 58 is a view illustrating a stylus pen including the sealing member in FIGS. 56A and 56B and the buffer member in FIGS. 57A and 57B.

As illustrated in FIG. 58, the stylus pen 1000 may include the third sealing member 2000c and the buffer member 1150. The buffer member 1150 may include the fourth sealing member 2000d. Specifically, the fourth sealing member 2000d and the buffer member 1150 may be in contact with each other to surround at least a portion of the outer surface of each of the core 1020 or the ferrite core 1210 around the core opening (not shown). Thus, the third sealing member 2000c and the fourth sealing member 2000d may together prevent moisture from entering through the first moisture ingress path P1' and the second moisture ingress path P2'.

Third moisture ingress path

FIGS. 59A and 59B are views illustrating a third moisture ingress path in which moisture enters into the stylus pen in FIG. 34 through a button part. Specifically, FIG. 59A is a perspective view illustrating the stylus pen together with the third moisture ingress path. Also, FIG. 59B is a partial perspective view illustrating a state in which the housing is removed from FIG. 59A together with the third moisture ingress path.

As illustrated in FIG. 59A and 59B, the stylus pen 1000 in FIG. 34 may include a button bracket 1190. Specifically, the button bracket 1190 is coupled with a substrate bracket 1900 to cover at least a portion of the substrate 2100 in the housing 1010. Also, the button bracket 1190 may have a predetermined groove (not shown) for being coupled with the button part 1090 to accommodate the button part 1090.

As illustrated in FIG. 59A, moisture may enter into the stylus pen 1000 in FIG. 34 through the third moisture ingress path P3'. Specifically, as illustrated in FIG. 59B, the third moisture ingress path P3' may include a path P3'-1 that passes through a gap between the button part 1090 and the housing 1010 and extends until the substrate 2100 through a hole (not shown) defined in the button bracket 1190. Alternatively, the third moisture ingress path P3' may include a path P3'-2 that passes the gap between the button part 1090 and the housing 1010 and extends until the substrate 2100 along an outer surface of the button bracket 1190.

Fourth moisture ingress path

FIGS. 60A and 60B are views illustrating a fourth moisture ingress path in which moisture enters into the stylus pen in FIG. 34 through a coupled portion between a housing and a clicker housing. Specifically, FIG. 60A is a perspective view illustrating the stylus pen together with the fourth moisture ingress path. Also, FIG. 60B is a partial perspective view illustrating a state in which the housing is removed from FIG. 60A together with the fourth moisture ingress path.

As illustrated in FIG. 60A and 60B, the stylus pen 1000 shown in FIG. 34 may include a clicker housing 2300, a clicker cover 2400, a clicker button 2500, and a clicker elastic member 2510.

Specifically, the clicker button 2500 may be inserted into a hole (not shown) defined in an end of the clicker housing 2300, which is disposed opposite to a pen tip. The clicker button 2500 may be designed to perform a specific motion of the stylus pen 1000. The clicker button 2500 may be pressed in a direction toward the core opening (not shown) by an external force.

Specifically, the clicker elastic member 2510 may have one end connected to the clicker button 2500. Also, the clicker elastic member 2510 may have the other end connected to the clicker housing 2300. When the clicker button 2500 is pressed in the direction toward the core opening (not shown), the clicker elastic member 2510 may be compressed to store elastic energy. When the force of pressing the clicker button 2500 is released, the clicker button 2500 is moved in a direction opposite to the core opening (not shown) by the elastic energy stored in the clicker elastic member 2510.

Specifically, the clicker cover 2400 and the clicker housing 2500 may surround the clicker button 2500 and the clicker elastic member 2510 in the housing 1010. The clicker housing 2500 may include a hole (not shown) for accommodating the clicker button 2500. Also, the clicker housing 2500 may be coupled to the clicker cover 2400. The clicker cover 2400 may be connected to the clicker housing 2500 through a predetermined fastening part (not shown) and coupled to an end of the substrate bracket 1900. On the other hand, as described above, a predetermined groove (not shown) may be formed in the clicker cover 2400 around a portion coupled to the substrate bracket 1900.

As illustrated in FIG. 60A, moisture may enter into the stylus pen 1000 in FIG. 34 through a fourth moisture ingress path P4'. Specifically, as illustrated in FIG. 60B, the fourth moisture ingress path P4' passes through a coupled portion between the housing 1010 and the clicker housing 2300 and extends until the substrate 2100 along outer surfaces of the clicker housing 2300 and the clicker cover 2400.

Packing member

FIG. 61 is a view illustrating a packing member for blocking the third moisture ingress path in the stylus pen in FIGS. 59A and 59B.

As illustrated in FIG. 61, the stylus pen 1000 in FIG. 34 may include a packing member 1290. Specifically, the packing member 1290 may be coupled to the button bracket 1190 through a predetermined groove (not shown) defined in the button bracket 1190. Also, the packing member 1290 that is for blocking the third moisture ingress path P3' in FIGS. 59A and 59B may cover the hole (not shown) defined in the button bracket 1190. The packing member 1290 may be in close contact with the button bracket 1190.

As illustrated in FIG. 61, the packing member 1290 may include a protrusion 1291 disposed at an edge thereof. Specifically, the protrusion 1291 may be in close contact with the inner wall of the housing 1010.

Thus, the packing member 1290 may prevent moisture from entering through the third moisture ingress path P3', which passes the gap between the button part 1090 and the housing 1010 and extends until the substrate 2100 along the hole (not shown) defined in the button bracket 1190 or the outer surface of the button bracket 1190.

Fifth sealing member

FIGS. 62A and 62B are views illustrating an embodiment of the sealing member for blocking the fourth moisture ingress path in the stylus pen in FIGS. 60A and 60B. Specifically, FIG. 62A is a partial perspective view illustrating the sealing member in the stylus pen from which the housing is removed. Also, FIG. 62B is a partial cross-sectional view obtained by cutting FIG. 62A along line E-E'.

As illustrated in FIG. 62A, the stylus pen 1000 in FIG. 34 may include a fifth sealing member 2000e for blocking the fourth moisture ingress path P4' in FIGS. 60A and 60B. Specifically, the fifth sealing member 2000e may be disposed in a groove (not shown) defined in the clicker cover 2400 around a portion at which the clicker cover 2400 is coupled to the substrate bracket 1900. The fifth sealing member 2000e may surround an outer surface of the clicker cover 2400 in the groove (not shown) defined in the clicker cover 2400.

As illustrated in FIG. 62B, the fifth sealing member 2000e may be in close contact with the inner wall of the housing 1010 in FIG. 34. Accordingly, the fifth sealing member 2000e may prevent moisture from entering through the fourth moisture ingress path P4'.

Embodiment of stylus pen including a plurality of sealing members

FIG. 63 is a view illustrating a plurality of waterproof units of the stylus pen in FIG. 34.

As illustrated in FIG. 63, the stylus pen 1000 in FIG. 34 may include a plurality of waterproof units. Specifically, the waterproof unit is for blocking a moisture ingress path into the stylus pen 1000.

For example, the moisture ingress path may include at least one path selected from the group consisting of the first moisture ingress path P1', the second moisture ingress path P2', the third moisture ingress path P3', and the fourth moisture ingress path P4', which are described above. However, the embodiment of the present disclosure is not limited thereto.

For example, the waterproof unit may include at least one selected from the group consisting of the first sealing members 2000a and 2000a', the second sealing member 2000b, the third sealing member 2000c, the buffer member 1150 including the fourth sealing member 2000d, the fifth sealing member 2000e, and the packing member 1290. However, the embodiment of the present disclosure is not limited thereto.

As illustrated in FIG. 63, the stylus pen 1000 in FIG. 34 may include the first sealing member 2000a', the third sealing member 2000c, the buffer member 1150 including the fourth sealing member 2000d, the packing member 1290, and the fifth sealing member 2000e. Accordingly, the stylus pen 1000 may prevent moisture from entering through the first moisture ingress path P1', the second moisture ingress path P2', the third moisture ingress path P3', and the fourth moisture ingress path P4'.

As described above with reference to FIGS. 52C and 52D, the first sealing member 2000a' may surround at least a portion of an outer surface of the fixing bracket 1600. Also, the first sealing member 2000a' may be in close contact with the inner wall of the housing 1010. Accordingly, the first sealing member 2000a' may prevent moisture from entering through the first moisture ingress path P1'.

As described above with reference to FIGS. 56A and 56B, the third sealing member 2000c may surround at least a portion of an outer surface of the ferrite core 1210. Specifically, the third sealing member 2000c may surround at least a portion of the outer surface of the ferrite core 1210 around the core opening (not shown). Although the third sealing member 2000c may be in contact with the coil 1230, the embodiment of the present disclosure is not limited thereto.

Also, the third sealing member 2000c may be in close contact with the inner wall of the housing 1010. Thus, the third sealing member 2000c may prevent moisture from entering through the first moisture ingress path P1'.

As described above with reference to FIGS. 57A and 57B, the stylus pen 1000 may include the buffer member 1150. Specifically, the buffer member 1150 may surround at least a portion of an outer surface of each of the core 1020 and the ferrite core 1210 around the core opening (not shown).

Also, the buffer member 1150 may include the fourth sealing member 2000d. Although the fourth sealing member 2000d may have a ring shape, the embodiment of the present disclosure is not limited thereto. The fourth sealing member 2000d may be coupled to one end disposed at the core opening (not shown) of the buffer member 1150.

More specifically, the fourth sealing member 2000d may block the first moisture ingress path P1'. As illustrated in FIG. 57B, the outer portion 2000d-1 of the fourth sealing member 2000d may be in close contact with the inner wall of the housing 1010. Thus, the fourth sealing member 2000d may prevent moisture from entering through the first moisture ingress path P1'.

Also, the fourth sealing member 2000d may block the second moisture ingress path P2'. As illustrated in FIG. 57B, the inner portion 2000d'-2 of the fourth sealing member 2000d may be in close contact with the core 1020 and/or the ferrite core 1210. Thus, the fourth sealing member 2000d may prevent moisture from entering through the second moisture ingress path P2'.

According to an embodiment of the present disclosure, the fourth sealing member 2000d may be coupled to one end of the buffer member 1150 as a separate component. Alternatively, the fourth sealing member 2000d may be coupled to one end of the buffer member 1150 and integrated with the buffer member 1150. However, the embodiment of the present disclosure is not limited thereto.

According to an embodiment of the present disclosure, the fourth sealing member 2000d may be formed at one end of the buffer member 1150 through a predetermined process. For example, the fourth sealing member 2000d may be formed through at least one process selected from the group consisting of a taping process and a coating process. However, the embodiment of the present disclosure is not limited thereto.

As described above with reference to FIG. 61, the stylus pen 1000 shown in FIG. 34 may include a packing member 1290. Specifically, the packing member 1290 may be coupled to the button bracket 1190 through a predetermined groove (not shown) defined in the button bracket 1190. Also, the packing member 1290 that is for blocking the third moisture ingress path P3' may block a hole (not shown) defined in the button bracket 1190. The packing member 1290 may be in close contact with the button bracket 1190.

Also, the packing member 1290 may include a protrusion 1291 formed at an edge thereof. Specifically, the protrusion 1291 may be in close contact with the inner wall of the housing 1010.

Thus, the packing member 1290 may prevent moisture from entering through the third moisture ingress path P3', which passes the gap between the button part 1090 and the housing 1010 and extends until the substrate 2100 along the hole (not shown) defined in the button bracket 1190 or the outer surface of the button bracket 1190.

As described above with reference to FIGS. 62A and 62B, the stylus pen 1000 shown in FIG. 34 may include a fifth sealing member 2000e for blocking the fourth moisture ingress path P4'. Specifically, the fifth sealing member 2000e may be disposed in a groove (not shown) defined in the clicker cover 2400 around a portion at which the clicker cover 2400 is coupled to the substrate bracket 1900. The fifth sealing member 2000e may surround an outer surface of the clicker cover 2400 in the groove (not shown) defined in the clicker cover 2400.

Also, the fifth sealing member 2000e may be in close contact with the inner wall of the housing 1010. Accordingly, the fifth sealing member 2000e may prevent moisture from entering through the fourth moisture ingress path P4'.

The stylus pen according to the embodiment of the present disclosure may block the plurality of moisture ingress paths of the stylus pen to realize the waterproof function.

Also, the stylus pen may realize the additional effect of blocking the moisture ingress path by using the special shape of the sealing member.

Also, the stylus pen may minimize the size of the buffer member that performs both the buffer function and the waterproof function.

Features, structures, and effects described in the above embodiments are incorporated into at least one embodiment of the present disclosure, but are not limited to only one embodiment. Moreover, features, structures, and effects exemplified in one embodiment can easily be combined and modified for another embodiment by those skilled in the art. Therefore, these combinations and modifications should be construed as falling within the scope of the present disclosure.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

**Claims**

1. A stylus pen comprising:

   a housing;
   a core having one end disposed outside the housing and the rest portion disposed in the housing and moved along a longitudinal direction by external force applied to the one end;
   an inductor unit comprising a ferrite core disposed in the housing and having a through-hole through which the core passes and a coil wound around an outer surface of the ferrite core;

a capacitor unit electrically connected to the inductor unit to form a resonance circuit; and

a plurality of sealing members configured to block a plurality of moisture ingress paths that pass through a core opening of the housing.

2. The stylus pen of claim 1, wherein the plurality of moisture ingress paths comprise:

a first moisture ingress path in which moisture enters into the stylus pen through the core opening of the housing and a space between the housing and the inductor unit; and

a second moisture ingress path in which moisture enters into the stylus pen through the core opening of the housing and a through-hole of the ferrite core.

3. The stylus pen of claim 2, wherein the plurality of sealing members comprise:

a first sealing member configured to block the first moisture ingress path; and

a second sealing member configured to block the second moisture ingress path.

4. The stylus pen of claim 3, wherein the first sealing member surrounds at least a portion of the outer surface of the ferrite core and is in close contact with an inner wall of the housing.

5. The stylus pen of claim 3 or 4, further comprising a fixing bracket fixed in the housing and coupled to the one end of the ferrite core, wherein the first sealing member surrounds at least a portion of an outer surface of the fixing bracket and is in close contact with an inner wall of the housing.

6. The stylus pen of any of claims 3 to 5, further comprising a fixing bracket fixed in the housing and coupled to the one end of the ferrite core,

wherein the fixing bracket comprises a partition wall that is in contact with the ferrite core, and the second sealing member is disposed on the partition wall to fill an outer portion of a through-hole of the partition wall, which passes through the partition wall, and is in close contact with the core at a portion at which the core passes the through-hole of the partition wall.

7. A stylus pen comprising:

a housing;

a core having one end disposed outside the housing and the rest portion disposed in the housing and moved along a longitudinal direction by external force applied to the one end;

an inductor unit comprising a ferrite core disposed in the housing and having a through-hole through which the core passes and a coil wound around an outer surface of the ferrite core;

a capacitor unit electrically connected to the inductor unit to form a resonance circuit; and

a sealing member configured to block a path in which moisture enters into the stylus pen through a core opening of the housing and a through-hole of the ferrite core.

8. The stylus pen of claim 7, further comprising a fixing bracket fixed in the housing and coupled to the one end of the ferrite core,

wherein the fixing bracket comprises a partition wall that is in contact with the ferrite core, and the second sealing member is disposed on the partition wall to fill an outer portion of a through-hole of the partition wall, which passes through the partition wall, and is in close contact with the core at a portion at which the core passes the through-hole of the partition wall.

9. The stylus pen of claim 8, wherein the sealing member comprises a cylindrical contact part having a height in the longitudinal direction of the core and is in close contact with the core at the contact part.

10. The stylus pen of claim 9, wherein the contact part maintains a close contact state with at least a portion of the core when the core is moved in the longitudinal direction.

11. A stylus pen comprising:

a housing;

a core having one end disposed outside the housing and the rest portion disposed in the housing and moved along a longitudinal direction by external force applied to the one end;

an inductor unit comprising a ferrite core disposed in the housing and having a through-hole through which the core passes and a coil wound around an outer surface of the ferrite core;

a capacitor unit electrically connected to the inductor unit to form a resonance circuit;

a buffer member disposed between an inner surface of the housing and the other end of the ferrite core to surround at least a portion of the other end of the ferrite core; and

a sealing member configured to block a path in which moisture enters into the stylus pen through a core opening of the housing and a space between the housing and the inductor unit.

12. The stylus pen of claim 11, wherein the buffer member is in close contact with the housing and the other end of the ferrite core.

13. The stylus pen of claim 12, wherein the other end of the ferrite core comprises at least one curved portion having a tapered shape having a diameter or a width that gradually decreases in a direction toward an end thereof and having an outer surface that is curved inward.

14. The stylus pen of claim 13, wherein the buffer member has a smaller thickness in comparison with a case in which the other end of the ferrite core does not comprise the curved portion.

15. The stylus pen of claim 14, wherein the sealing member surrounds the outer surface of the ferrite core and is in close contact with an inner wall of the housing.

16. The stylus pen of claim 14 or 15, further comprising a fixing bracket fixed in the housing and coupled to the one end of the ferrite core, wherein the sealing member surrounds the fixing bracket and is in close contact with an inner wall of the housing.

17. A stylus pen comprising:

    a housing;
    a core having one end disposed outside the housing and the rest portion disposed in the housing and moved along a longitudinal direction by external force applied to the one end;
    an inductor unit comprising a ferrite core disposed in the housing and having a through-hole through which the core passes and a coil wound around an outer surface of the ferrite core;
    a capacitor unit electrically connected to the inductor unit to form a resonance circuit; and
    a buffer member disposed between the housing and the other end of the ferrite core to surround at least a portion of the other end of the ferrite core and comprising a fourth sealing member at one end thereof,
    wherein the sealing member has an outer portion that is in close contact with an inner wall of the housing.

18. The stylus pen of claim 17, wherein the fourth sealing member is taped or coated on one surface of the buffer member.

19. The stylus pen of claim 17 or 18, wherein the fourth sealing member has an inner portion that is in close contact with the core or the ferrite core.

20. The stylus pen of any of claims 17 to 19, wherein the fourth sealing member has an inner portion that is spaced a predetermined distance from the core or the ferrite core.

21. The stylus pen of any of claims 17 to 20, further comprising a third sealing member that surrounds at least a portion of the outer surface of the ferrite core and is in close contact with the housing.

22. The stylus pen of claim 21, wherein the third sealing member is in contact with the coil.

23. The stylus pen of any of claims 17 to 22, further comprising:

    a fixing bracket fixed in the housing and coupled to the one end of the ferrite core; and
    a first sealing member that surrounds at least a portion of an outer surface of the fixing bracket and is in close contact with the housing.

24. The stylus pen of any of claims 17 to 23, further comprising:

    a button part disposed on an outer surface of the housing;
    a button bracket fixed in the housing and coupled to the button part; and
    a packing member that is coupled to the button bracket and is in close contact with the button bracket.

25. The stylus pen of any of claims 17 to 24, further comprising:

    a substrate bracket fixed in the housing to surround the capacitor unit;
    a clicker button moved in the longitudinal direction by external force applied to one end thereof;
    a clicker housing having one end coupled to the housing to surround the clicker button in the housing;
    a clicker cover that connects the substrate bracket and the clicker housing in the housing; and
    a fifth sealing member that surrounds a predetermined groove defined in the clicker cover around a portion at which the clicker cover is coupled to the substrate bracket,
    wherein the fifth sealing member is in close contact with the housing.

【FIG. 1A】

【FIG. 1B】

【FIG. 1C】

Pen Tip

【FIG. 2】

【FIG. 3】

【FIG. 4】

【FIG. 5】

【FIG. 6】

【FIG. 7】

【FIG. 8】

| Decease in relative height of ferrite core [mm] | Amount of increase in magnitude of pen signal |
|---|---|
| 0 | - |
| 0.5 | 6% increase |
| 1mm | 17% increase |
| 1.5 | 29% increase |

【FIG. 9】

【FIG. 10A】

【FIG. 10B】

111e

111e

111b

111e

【FIG. 11】

【FIG. 12A】

【FIG. 12B】

【FIG. 13A】

【FIG. 13B】

【FIG. 14A】

【FIG. 14B】

【FIG. 15】

【FIG. 16A】

【 FIG. 16B 】

185

199

177

161

【FIG. 17】

【FIG. 18A】

【FIG. 18B】

EP 4 668 071 A1

【 FIG. 19A 】

59

【FIG. 19B】

【FIG. 19C】

【FIG. 20】

**Performance based on tolerance of tip**

(a) ——— No deviation
(b) ——— Deviation occurs so that L is pressed first
(c) ━━━ Deviation occurs so that L is pressed late

【FIG. 21A】

【FIG. 21B】

【FIG. 21C】

【FIG. 22】

【FIG. 23A】

180'

【 FIG. 23B 】

【FIG. 24】

【FIG. 25A】

102T

102

【FIG. 25B】

【FIG. 26】

(a) ——— No deviation
(b) ——— Deviation occurs so that L is pressed first
(c) ——— Deviation occurs so that L is pressed late

【FIG. 27】

【FIG. 28】

【FIG. 29】

【FIG. 30】

123

121a"
121b"  }121"
121c"

121h

【FIG. 31】

【FIG. 32】

B — — — — — — — — — B'

A

121c1
121c2 } 121c"
121c3

121d

B

121h

【FIG. 33】

【 FIG. 34 】

【FIG. 35】

【FIG. 36】

【FIG. 37】

【FIG. 38】

【FIG. 39】

【FIG. 40】

【FIG. 41】

【FIG. 42A】

1810

1870

【FIG. 42B】

1851

1850

【FIG. 43】

【FIG. 44】

【FIG. 45A】

【FIG. 45B】

【FIG. 46】

【FIG. 47】

【 FIG. 48A 】

【FIG. 48B】

【FIG. 49】

【 FIG. 50A 】

【FIG. 50B】

【FIG. 50C】

【FIG. 50D】

【FIG. 51A】

【 FIG. 51B 】

【FIG. 51C】

【FIG. 51D】

1010

2000a

1021

1210

【FIG. 52A】

【FIG. 52B】

【FIG. 52C】

【FIG. 52D】

【FIG. 53A】

【FIG. 53B】

130

133b

132

132h

200b

【FIG. 53C】

【FIG. 53D】

【 FIG. 54A 】

【FIG. 54B】

【FIG. 55A】

【FIG. 55B】

【FIG. 56A】

【FIG. 56B】

【FIG. 57A】

【FIG. 57B】

【FIG. 58】

【FIG. 59A】

【FIG. 59B】

【FIG. 60A】

【FIG. 60B】

【FIG. 61】

【FIG. 62A】

【FIG. 62B】

【 FIG. 63 】

| | Europäisches Patentamt European Patent Office Office européen des brevets | **EUROPEAN SEARCH REPORT** | Application Number EP 25 18 4212 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/024657 A1 (NINOMIYA KENICHI [JP] ET AL) 25 January 2018 (2018-01-25) | 1-5,7, 11-13, 17-24 | INV. G06F3/0354 |
| A | * paragraphs [0008] - [0011], [0031] - [0038], [0065], [0069] - [0070], [0075], [0076], [0090] - [0105], [0109]; figures 1-2,5-9 * | 6,8-10, 14-16,25 | |
| A | US 2023/244331 A1 (OGATA MAMORU [JP] ET AL) 3 August 2023 (2023-08-03) * paragraphs [0017] - [0024]; figures 1-4 * | 1-25 | |
| A | US 2010/212976 A1 (BABA YASUHIRO [JP]) 26 August 2010 (2010-08-26) * paragraph [0052]; figure 3 * | 11,17 | |
| | | | TECHNICAL FIELDS SEARCHED (IPC) G06F |

The present search report has been drawn up for all claims

| Place of search | Date of completion of the search | Examiner |
|---|---|---|
| Munich | 24 October 2025 | Charcos Lloréns, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 4212

This annex lists the patent family members relating to the patent documents cited in the above-mentioned European search report.
The members are as contained in the European Patent Office EDP file on
The European Patent Office is in no way liable for these particulars which are merely given for the purpose of information.

24-10-2025

| Patent document cited in search report | Publication date | Patent family member(s) | Publication date |
|---|---|---|---|
| US 2018024657 A1 | 25-01-2018 | CN 107656630 A | 02-02-2018 |
| | | CN 115407886 A | 29-11-2022 |
| | | EP 3276458 A1 | 31-01-2018 |
| | | JP 6694347 B2 | 13-05-2020 |
| | | JP 2018018149 A | 01-02-2018 |
| | | KR 20180011730 A | 02-02-2018 |
| | | KR 20220019742 A | 17-02-2022 |
| | | KR 20220122964 A | 05-09-2022 |
| | | KR 20230047992 A | 10-04-2023 |
| | | KR 20230110697 A | 25-07-2023 |
| | | KR 20240050315 A | 18-04-2024 |
| | | KR 20250052327 A | 18-04-2025 |
| | | TW 201807544 A | 01-03-2018 |
| | | TW 202223603 A | 16-06-2022 |
| | | TW 202338578 A | 01-10-2023 |
| | | US 2018024657 A1 | 25-01-2018 |
| | | US 2019294269 A1 | 26-09-2019 |
| | | US 2021018998 A1 | 21-01-2021 |
| | | US 2022276731 A1 | 01-09-2022 |
| | | US 2024036667 A1 | 01-02-2024 |
| | | US 2025110587 A1 | 03-04-2025 |
| US 2023244331 A1 | 03-08-2023 | CN 116134406 A | 16-05-2023 |
| | | JP 7713467 B2 | 25-07-2025 |
| | | JP 2025133966 A | 11-09-2025 |
| | | JP WO2022097402 A1 | 12-05-2022 |
| | | KR 20230095912 A | 29-06-2023 |
| | | US 2023244331 A1 | 03-08-2023 |
| | | WO 2022097402 A1 | 12-05-2022 |
| US 2010212976 A1 | 26-08-2010 | CN 101813986 A | 25-08-2010 |
| | | EP 2221709 A2 | 25-08-2010 |
| | | JP 5286609 B2 | 11-09-2013 |
| | | JP 2010198193 A | 09-09-2010 |
| | | US 2010212976 A1 | 26-08-2010 |

For more details about this annex : see Official Journal of the European Patent Office, No. 12/82

**EP 4 668 071 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240080912

- KR 1020240151961